# EUROPEAN PATENT SPECIFICATION

(11) **EP 4 210 453 B1**
(45) Date of publication and mention of the grant of the patent: **16.07.2025**
(21) Application number: 23150918.3
(22) Date of filing: 10.01.2023
(51) Int. Cl.: H10K 50/858, H10K 85/30, H10K 50/11

(54) **LIGHT-EMITTING DEVICE AND ELECTRONIC APPARATUS INCLUDING THE SAME**
LICHTEMITTIERENDE VORRICHTUNG UND ELEKTRONISCHE VORRICHTUNG DAMIT
DISPOSITIF ÉLECTROLUMINESCENT ET APPAREIL ÉLECTRONIQUE LE COMPRENANT

(30) Priority: 10.01.2022 KR 20220003637
(43) Date of publication of application: 12.07.2023
(73) Proprietor: Samsung Display Co., Ltd., Yongin-si, Gyeonggi-do 17113 (KR)
(72) Inventor: CHO, Youngmi, Yongin-si, Gyeonggi-do 17113 (KR); JUNG, Hyojoo, Yongin-si, Gyeonggi-do 17113 (KR); KOH, Eunkyung, Yongin-si, Gyeonggi-do 17113 (KR); KWAG, Jinoh, Yongin-si, Gyeonggi-do 17113 (KR); KIM, Yongjo, Yongin-si, Gyeonggi-do 17113 (KR); HAN, Younho, Yongin-si, Gyeonggi-do 17113 (KR)
(74) Representative: Gulde & Partner

(56) References cited:
- EP-A1- 3 929 193
- EP-A1- 4 089 156
- EP-B1- 1 729 327
- WO-A1-2021/140896

## Description

### BACKGROUND

### 1. Field

Aspects of one or more embodiments of the present disclosure relate to a light-emitting device and an electronic apparatus including the same.

### 2. Description of the Related Art

From among light-emitting devices, self-emissive devices (for example, organic light-emitting devices, etc.) have relatively wide viewing angles, excellent or suitable contrast ratios, fast response times, and excellent or suitable characteristics in terms of luminance, driving voltage, and response speed.

In a light-emitting device, a first electrode is on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as the holes and electrons, recombine in the emission layer to produce excitons. These excitons are transitioned from an excited state to a ground state to thereby generate light. Examples may be found in WO 2021/140896 A1, EP 1 729 327 B1 or EP 3 929 193 A1.

### SUMMARY

The invention is defined by the appended claims. The description that follows is subjected to this limitation. Any disclosure lying outside the scope of said claims is only intended for illustrative as well as comparative purposes. The present invention provides a light-emitting device as defined in claim 1 having suitable frontal luminescence efficiency and lateral luminescence efficiency at substantially the same time, and an electronic apparatus including the light-emitting device.

Additional aspects of embodiments of the present disclosure will be set forth in part in the description which follows and, in part, will be apparent from the description, or may be learned by practice of the presented embodiments of the disclosure.

Provided is a light emitting device including:
a first electrode,
a second electrode facing the first electrode,
an interlayer between the first electrode and the second electrode and including an emission layer,
a capping layer,
wherein the emission layer includes a first emitter,
the first emitter emits first light having a first emission spectrum,
the capping layer is in the path on which (e.g., in the path through or via which) the first light travels,
a maximum emission peak wavelength of the first emission spectrum is from about 520 nm to about 550 nm,
the first emitter includes iridium,
the capping layer includes an amine-containing compound, and
the value of ratio of CIEy to reflective index (RCR value) of the first light extracted to the outside through the capping layer is 38 or less, and
the RCR value is calculated by Equation 1 $CIEy / R \left(cap\right) \times 100$
wherein, in Equation 1,
CIEy is the y coordinate value of the CIE color coordinates of the first light extracted to the outside through the capping layer, and
R(cap) is the refractive index of the amine-containing compound with respect to second having a wavelength of 530 nm.
(Not falling under the scope of the claims of the invention) According to an embodiment of the present disclosure, provided is a light-emitting device, the light-emitting device including
a first electrode,
a second electrode facing the first electrode,
an interlayer between the first electrode and the second electrode and including an emission layer,
a capping layer,
wherein the emission layer includes a first emitter,
the first emitter emits first light having a first emission spectrum,
the capping layer is in the path on which (e.g., in the path through or via which) the first light travels,
the first emitter may include a first ligand, a second ligand, and a third ligand, each of which is bonded to the iridium,
the first ligand may be a bidentate ligand including Y₁-containing ring B₁ and Y₂-containing ring B₂,
the second ligand may be a bidentate ligand including Y₃-containing ring B₃ and Y₄-containing ring B₄,
the third ligand may be a bidentate ligand including Y₅-containing ring B₅ and Y₆-containing ring B₆,
each of Y₁, Y₃, and Y₅ is nitrogen (N),
each of Y₂, Y₄, and Y₆ is carbon (C),
Y₂-containing ring B₂ and Y₄-containing ring B₄ may be different from each other,
the capping layer includes an amine-containing compound, and
the amine-containing compound includes a benzoxazole group, a benzthiazole group, a naphthooxazole group, a naphthothiazole group, or one or more combinations thereof.

An embodiment of the present disclosure provides an electronic apparatus including the light-emitting device.

An embodiment of the present disclosure provides a consumer product including the light-emitting device.

### BRIEF DESCRIPTION OF THE DRAWINGS

The above and other aspects and features of certain embodiments of the disclosure will be more apparent from the following description taken in conjunction with the accompanying drawings, in which:
FIG. 1 shows a schematic view of a light-emitting device according to an embodiment;
FIG. 2 shows a cross-sectional view of an electronic apparatus according to an embodiment; and
FIG. 3 shows a cross-sectional view of an electronic apparatus according to an embodiment.

### DETAILED DESCRIPTION

Reference will now be made in more detail to embodiments, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein. Accordingly, the embodiments are merely described, by referring to the drawings, to explain aspects of the present disclosure. As utilized herein, the term "and/or" includes any and all combinations of one or more of the associated listed items. Throughout the disclosure, the expression "at least one of a, b or c", "at least one selected from a, b, and c", etc., indicates only a, only b, only c, both (e.g., simultaneously) a and b, both (e.g., simultaneously) a and c, both (e.g., simultaneously) b and c, all of a, b, and c, or variations thereof.

A light-emitting device according to an embodiment of the present disclosure includes: a first electrode; a second electrode facing the first electrode; an interlayer which is between the first electrode and the second electrode and includes an emission layer; and a capping layer.

The emission layer includes a first emitter. The first emitter emits first light having a first emission spectrum, and the capping layer is in a path on which (e.g., in the path through or via which) the first light travels.

The emission peak wavelength (maximum emission wavelength, or maximum emission peak wavelength) of the first light is in the range of 520 nm to 550 nm.

For example, the emission peak wavelength of the first light may be in the range of about 520 nm to about 545 nm, about 520 nm to about 540 nm, about 520 nm to about 535 nm, about 525 nm to about 550 nm, about 525 nm to about 545 nm, about 525 nm to about 540 nm, or about 525 nm to about 535 nm.

A full width at half maximum (FWHM) of the first light may be in the range of about 15 nm to about 60 nm.

For example, the FWHM of the first light may be in the range of about 20 nm to about 60 nm, about 25 nm to about 60 nm, about 30 nm to about 60 nm, about 35 nm to about 60 nm, about 40 nm to about 60 nm, about 45 nm to about 60 nm, about 50 nm to about 60 nm, or about 55 nm to about 60 nm.

The emission peak wavelength (or maximum emission wavelength) and FWHM of the first light described in the present disclosure may be evaluated from the emission spectrum of a film including the first emitter (for example, see Evaluation Example 2). The emission peak wavelength in the present disclosure refers to the peak wavelength having the maximum emission intensity in the emission spectrum or electroluminescence spectrum.

The first light having the emission peak wavelength and FWHM as described above may be green light.

The first emitter includes iridium.

In an embodiment, the first emitter may be an organometallic compound containing iridium. The first emitter may be neutral, may include one iridium, and may not include (e.g., may exclude) transition metals other than iridium. In particular, the first emitter may be an organometallic iridium complex.

In an embodiment, the iridium complex may include, in addition to the iridium, a first ligand, a second ligand, and a third ligand, each of which is coupled to the iridium. In this regard, the first ligand may be a bidentate ligand including Y₁-containing ring B₁ and Y₂-containing ring B₂, the second ligand may be a bidentate ligand including Y₃-containing ring B₃ and Y₄-containing ring B₄, the third ligand may be a bidentate ligand including Y₅-containing ring B₅ and Y₆-containing ring B₆, Y₁, Y₃, and Y₅ may each be nitrogen(N),and Y₂, Y₄, and Y₆ may each be carbon(C). At least two of the ligands may differ from each other, i.e. the iridium complex may be a heteroleptic complex. For example, the Y₂-containing ring B₂ and Y₄-containing ring B₄ may be different from each other.

In one or more suitable embodiments, the Y₂-containing ring B₂ may be a polycyclic group. For example, the Y₂-containing ring B₂ may be a polycyclic group in which three or more a monocyclic group are condensed with each other. In an embodiment, the Y₂-containing ring B₂ may be a polycyclic group in which one 5-membered monocyclic group (for example, a furan group, a thiophene group, a selenophene group, a pyrrole group, a cyclopentadiene group, a silole group, etc.) is condensed with at least two 6-membered monocyclic groups (for example, a benzene group, a pyridine group, a pyrimidine group, a pyrazine group, a pyridazine group, etc.).

In an embodiment, the Y₄-containing ring B₄ may be a monocyclic group. For example, the Y₄-containing ring B₄ may be a 6-membered monocyclic group (for example, a benzene group, a pyridine group, a pyrimidine group, a pyrazine group, a pyridazine group, etc.).

In an embodiment, the first emitter may be a heteroleptic complex.

In an embodiment, the third ligand may be identical to the second ligand.

In an embodiment, the third ligand may be identical to the first ligand.

In an embodiment, the third ligand may be different from each of the first ligand and the second ligand.

More details for the first emitter are as described herein.

The capping layer is in a path on which (e.g., in the path through or via which) the first light travels and is extracted to the outside of the light-emitting device, thereby increasing the external extraction rate of the first light.

The capping layer includes an amine-containing compound. The "amine" in the amine-containing compound refers to a group represented by 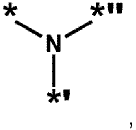 wherein *, *', and *" indicate binding sites to neighboring atoms A₁, A₂ and A₃, respectively, and each of A₁, A₂, and A₃ is not linked via a single bond or an any atom group therebetween. Each of A₁, A₂ and A₃ may be any atom, for example, carbon, hydrogen, and/or the like. In other words, the amine-containing group may be a primary amine, a secondary amine, or a tertiary amine. Most preferred are tertiary amines. For example, CBP does not belong to the amine-containing compound described in the present disclosure.

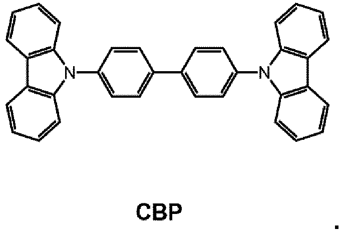

In an embodiment, the capping layer may include a monoamine-containing compound. For example, the number of "amine(s)" in the amine-containing compound included in the capping layer may be 1.

The amine-containing compound included in the capping layer includes a benzoxazole group, a benzthiazole group, a naphthooxazole group, a naphthothiazole group, or one or more combinations thereof.

The value of ratio of CIEy to refractive index (RCR value) of the first light extracted to the outside through the capping layer is 38 or less. In this regard, the RCR value is calculated by Equation 1: $CIEy / R \left(cap\right) \times 100$
wherein, in Equation 1,
CIEy is the y coordinate value of the CIE color coordinates of the first light extracted to the outside through the capping layer, and
R(cap) is the refractive index of the amine-containing compound with respect to second light having a wavelength of 530 nm.

In an embodiment, the RCR value of the first light extracted through the capping layer may be 32.0 to 38.0, 32.5 to 38.0, 33.0 to 38.0, 33.5 to 38.0, 34.0 to 38.0, 34.5 to 38.0, 35.0 to 38.0, 35.5 to 38.0, 36.0 to 38.0, 32.0 to 37.5, 32.5 to 37.5, 33.0 to 37.5, 33.5 to 37.5, 34.0 to 37.5, 34.5 to 37.5, 35.0 to 37.5, 35.5 to 37.5, or 36.0 to 37.5.

When the emission peak wavelength of the first light is 520 nm to 550 nm, and the RCR value of the first light extracted to the outside through the capping layer satisfies the ranges as described above, the light-emitting device has excellent or suitable frontal (0°) luminescence efficiency and lateral luminescence efficiency (for example, at a location moved 45° from the front (0°)) at the same time (concurrently). By utilizing such a light-emitting device, a high-quality electronic apparatus may be manufactured.

In an embodiment, the CIEy may be 0.705 to 0.740, 0.705 to 0.735, 0.705 to 0.730, 0.710 to 0.740, 0.710 to 0.735, 0.710 to 0.730, 0.715 to 0.740, 0.715 to 0.735, 0.715 to 0.730, 0.720 to 0.740, 0.720 to 0.735, or 0.720 to 0.730.

The R(cap) may be evaluated by actually measuring the refractive index of a film including (e.g., consisting of) the amine-containing compound (see, for example, Evaluation Example 3).

The R(cap) is the refractive index of the amine-containing compound with respect to second light having a wavelength of 530 nm.

In an embodiment, the R(cap) may be 1.9 to 2.5, 1.95 to 2.5, 2.0 to 2.5, 2.05 to 2.5, 1.9 to 2.45, 1.95 to 2.45, 2.0 to 2.45, 2.05 to 2.45, 1.9 to 2.4, 1.95 to 2.4, 2.0 to 2.4, 2.05 to 2.4, 1.9 to 2.35, 1.95 to 2.35, 2.0 to 2.35, 2.05 to 2.35, 1.9 to 2.3, 1.95 to 2.3, 2.0 to 2.3, 2.05 to 2.3, 1.9 to 2.25, 1.95 to 2.25, 2.0 to 2.25, 2.05 to 2.25, 1.9 to 2.1, 1.95 to 2.1, 2.0 to 2.1, 2.05 to 2.1, 1.9 to 2.05, or 1.95 to 2.05.

According to an embodiment of the present disclosure, the light-emitting device includes: a first electrode; a second electrode facing the first electrode; an interlayer which is between the first electrode and the second electrode and includes an emission layer; and a capping layer, wherein the emission layer includes a first emitter, the first emitter may emit first light having a first emission spectrum, and the capping layer may be in a path on which (e.g., in a path through or via which) the first light travels, the first emitter may include a first ligand, a second ligand, and a third ligand, each of which is bonded to the iridium, the first ligand may be a bidentate ligand including Y₁-containing ring B₁ and Y₂-containing ring B₂, the second ligand may be a bidentate ligand including Y₃-containing ring B₃ and Y₄-containing ring B₄, the third ligand may be a bidentate ligand including Y₅-containing ring B₅ and Y₆-containing ring B₆, Y₁, Y₃, and Y₅ may each be nitrogen(N),Y₂, Y₄, and Y₆ may each be carbon(C), and Y₂-containing ring B₂ and Y₄-containing ring B₄ may be different from each other, and the capping layer includes an amine-containing compound, and the amine-containing compound may include a benzoxazole group, a benzthiazole group, a naphthooxazole group, a naphthothiazole group, or one or more combinations thereof.

The first light, the first emitter, and the amine-containing compound may each independently be the same as described above.

In an embodiment, the Y₂-containing ring B₂ may be a polycyclic group.

In an embodiment, the emission peak wavelength of the first light may be in the range of about 520 nm to about 545 nm, about 520 nm to about 540 nm, about 520 nm to about 535 nm, about 525 nm to about 550 nm, about 525 nm to about 545 nm, about 525 nm to about 540 nm, about or 525 nm to about 535 nm.

In an embodiment, the FWHM of the first light may be in the range of about 20 nm to about 60 nm, about 25 nm to about 60 nm, about 30 nm to about 60 nm, about 35 nm to about 60 nm, about 40 nm to about 60 nm, about 45 nm to about 60 nm, about 50 nm to about 60 nm, or about 55 nm to about 60 nm.

The first light having the emission peak wavelength and FWHM as described above may be green light.

In an embodiment, the refractive index of the amine-containing compound with respect to second light having a wavelength of 530 nm may be in the range of 1.9 to 2.5, 1.95 to 2.5, 2.0 to 2.5, 2.05 to 2.5, 1.9 to 2.45, 1.95 to 2.45, 2.0 to 2.45, 2.05 to 2.45, 1.9 to 2.4, 1.95 to 2.4, 2.0 to 2.4, 2.05 to 2.4, 1.9 to 2.35, 1.95 to 2.35, 2.0 to 2.35, 2.05 to 2.35, 1.9 to 2.3, 1.95 to 2.3, 2.0 to 2.3, 2.05 to 2.3, 1.9 to 2.25, 1.95 to 2.25, 2.0 to 2.25, 2.05 to 2.25, 1.9 to 2.1, 1.95 to 2.1, 2.0 to 2.1, 2.05 to 2.1, 1.9 to 2.05, or 1.95 to 2.05.

As described above, a light-emitting device concurrently (e.g., simultaneously) including i) an emission layer including iridium and a first emitter including a first ligand, a second ligand, and a third ligand, each of which is bonded to the iridium and ii) a capping layer including the amine-containing compound, the amine-containing compound including a benzoxazole group, a benzthiazole group, a naphthooxazole group, a naphthothiazole group, or one or more combinations thereof, may have excellent or suitable frontal luminescence efficiency and excellent or suitable lateral luminescence efficiency at the same time (concurrently). Accordingly, by utilizing the light-emitting device, high-quality electronic apparatuses may be manufactured.

In an embodiment, the first emitter may include at least one deuterium.

In an embodiment, the first emitter may include a deuterated C₁-C₂₀ alkyl group, a deuterated C₃-C₁₀ cycloalkyl group, or one or more combinations thereof.

In an embodiment, at least one of the first ligand, the second ligand, and the third ligand may include at least one deuterium.

In an embodiment, at least one of the first ligand, the second ligand, and the third ligand may include a deuterated C₁-C₂₀ alkyl group, a deuterated C₃-C₁₀ cycloalkyl group, or one or more combinations thereof.

In an embodiment, the highest occupied molecular orbital (HOMO) energy level of the first emitter may be in the range of -5.30 eV to -4.70 eV or -5.25 eV to - 4.80 eV.

In an embodiment, the lowest unoccupied molecular orbital (LUMO) energy level of the first emitter may be in the range of -2.20 eV to -1.50 eV or -2.10 eV to - 1.80 eV.

The HOMO and LUMO energy levels may be evaluated through cyclic voltammetry analysis (for example, Evaluation Example 1) of the organometallic compound.

In an embodiment, the triplet (T₁) energy of the first emitter may be 2.10 eV to 2.60 eV or 2.20 eV to 2.50 eV.

The evaluation method for the triplet energy of the first emitter may be understood by referring to, for example, Evaluation Example 2.

The emission layer may further include, in addition to the first emitter, a host, an auxiliary dopant, a sensitizer, a delayed fluorescence material, or one or more combinations thereof. Each of the host, the auxiliary dopant, the sensitizer, the delayed fluorescence material, or one or more combinations thereof may include at least one deuterium.

For example, the emission layer may include the first emitter and the host. The host may be different from the first emitter, and the host may include an electron-transporting compound, a hole-transporting compound, a bipolar compound, or any combination thereof. The host may not include (e.g., may exclude) metal. The electron-transporting compound, the hole-transporting compound, and the bipolar compound are different from each other.

In an embodiment, the emission layer includes the first emitter and a host, and the host may include an electron-transporting compound and a hole-transporting compound. The electron-transporting compound and the hole-transporting compound may form an exciplex.

For example, the electron-transporting compound may include at least one π electron-deficient nitrogen-containing C₁-C₆₀ cyclic group. For example, the electron-transporting compound may include a pyridine group, a pyrimidine group, a pyrazine group, a pyridazine group, a triazine group, or one or more combinations thereof.

In an embodiment, the hole-transporting compound may include at least one π electron-rich C₃-C₆₀ cyclic group, a pyridine group, or one or more combinations thereof, and may not include (e.g., may exclude) an electron transport group (for example, a π electron-deficient nitrogen-containing C₁-C₆₀ cyclic group, a cyano group, a sulfoxide group, and/or a phosphine oxide group; in which a pyridine group (e.g., any pyridine group) is excluded from the foregoing listing).

In an embodiment, the following compounds may be excluded from the hole-transporting compound.

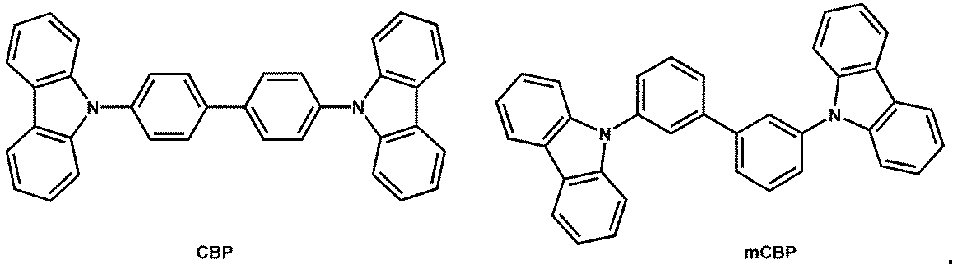

In an embodiment, the electron-transporting compound may include a compound represented by Formula 2-1 or a compound represented by Formula 2-2: 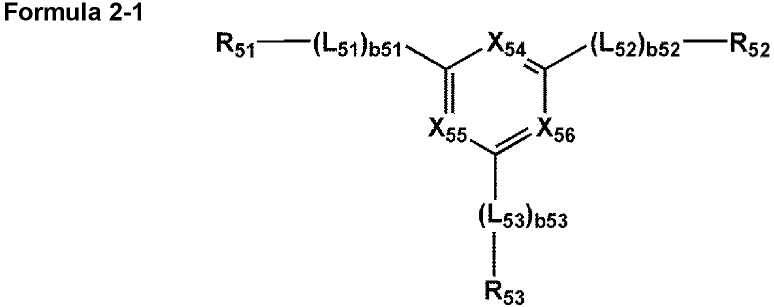 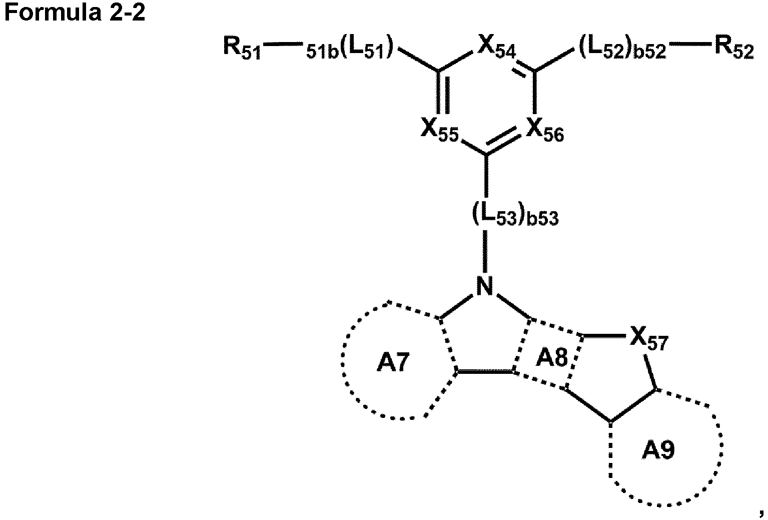
wherein, in Formulae 2-1 and 2-2,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
A₇ to A₉ may each independently be a C₃-C₆₀ carbocyclic group unsubstituted or substituted with at least one R₁₀ₐ or a C₁-C₆₀ heterocyclic group unsubstituted or substituted with at least one R₁₀ₐ (for example, a benzene group or a naphthalene group, each unsubstituted or substituted with at least one R₁₀ₐ),
X₅₄ is N or C(R₅₄), X₅₅ is N or C(R₅₅), X₅₆ is N or C(R₅₆), and at least one of X₅₄ to X₅₆ is N,
X₅₇ may be O, S, N(R₅₇), C(R₅₇ₐ)(R_{57b}), or Si(R₅₇ₐ)(R_{57b}), and
R_{51 to} R₅₇, R₅₇ₐ, R_{57b}, and R₁₀ₐ are each the same as described above.

In an embodiment, the hole-transporting compound may include a compound represented by Formula 3-1, a compound represented by Formula 3-2, a compound represented by Formula 3-3, a compound represented by Formula 3-4, a compound represented by Formula 3-5, or one or more combinations thereof: 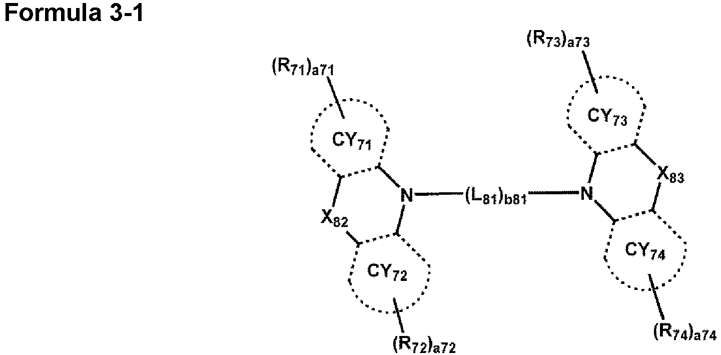 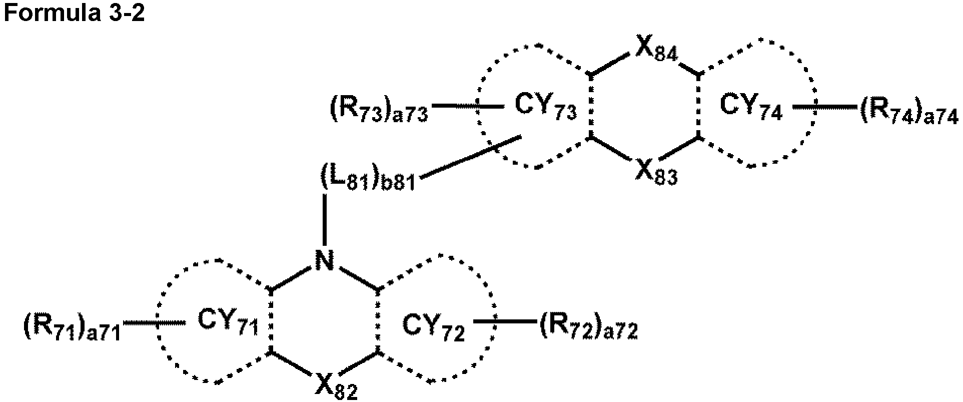 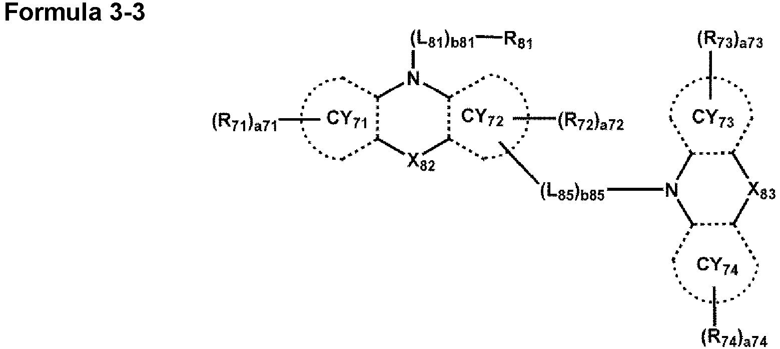 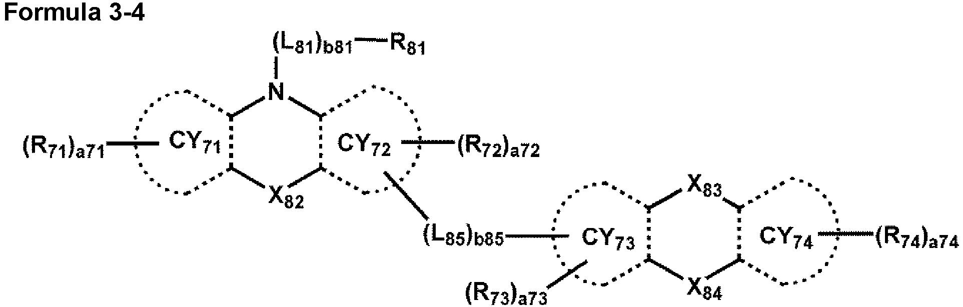 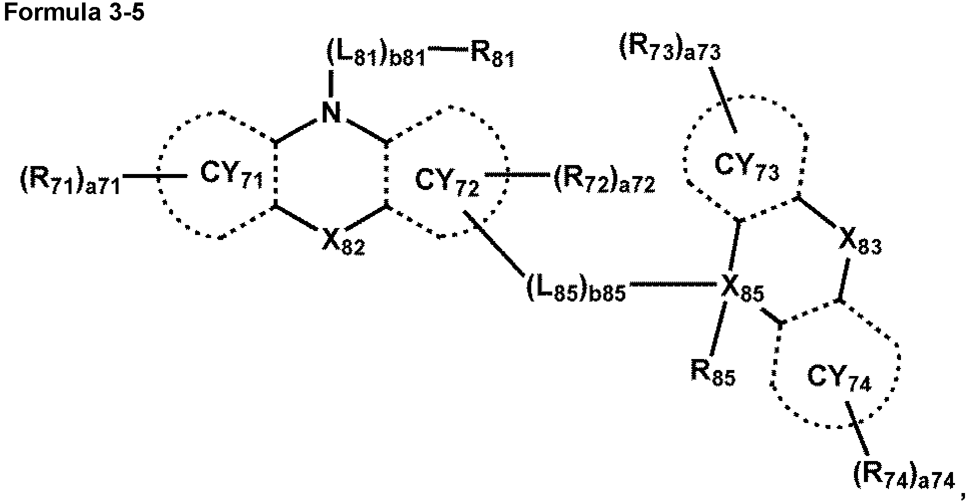
wherein, in Formulae 3-1 to 3-5,
ring CY₇₁ to ring CY₇₄ may each independently be a π electron-rich C₃-C₆₀ cyclic group (for example, a benzene group, a naphthalene group, a fluorene group, a anthracene group, a carbazole group, a dibenzofuran group, or a dibenzothiophene group), or a pyridine group,
X₈₂ may be a single bond, O, S, N-[(L₈₂)_{b82}-R₈₂], C(R₈₂ₐ)(R_{82b}), or Si(R₈₂ₐ)(R_{82b}),
X₈₃ may be a single bond, O, S, N-[(L₈₃)_{b83}-R₈₃], C(R₈₃ₐ)(R_{83b}), or Si(R₈₃ₐ)(R_{83b}),
X₈₄ may be O, S, N-[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ (for example, a benzene group, a naphthalene group, a fluorene group, a anthracene group, a carbazole group, a dibenzofuran group, or a dibenzothiophene group, each unsubstituted or substituted with at least one R₁₀ₐ), or a pyridine group unsubstituted or substituted with at least one R₁₀ₐ, wherein Q₄ and Q₅ may each independently be the same as described in connection with Q₁,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} may each be the same as described herein,
a71 to a74 may each independently be an integer from 0 to 20, and
R₁₀ₐ may be understood by referring to the description of R₁₀ₐ provided herein.

The capping layer of the light-emitting device may be outside the first electrode and/or outside the second electrode.

In an embodiment, the light-emitting device may further include at least one of a first capping layer outside of the first electrode and/or a second capping layer outside of the second electrode, wherein at least one of the first capping layer and/or the second capping layer may include the amine-containing compound described in the present disclosure.

In an embodiment, the light-emitting device may further include:
a first capping layer outside the first electrode and including the amine-containing compound described in the present disclosure;
a second capping layer outside the second electrode and including the amine-containing compound described in the present disclosure; or
the first capping layer and the second capping layer.

In an embodiment, the light-emitting device may further include a third capping layer, and the third capping layer may include a compound which is different from the amine-containing compound described in the present disclosure. The third capping layer may be in a path on which (e.g., in a path through or via which) the first light emitted from the first emitter travels.

In an embodiment, the third capping layer may include a material having a refractive index (at 589 nm) of 1.6 or more.

In an embodiment, the third capping layer may be an organic capping layer including an organic material, an inorganic capping layer including an inorganic material, and/or an organic-inorganic composite capping layer including an organic material and an inorganic material.

For example, the third capping layer may include a carbocyclic compound, a heterocyclic compound, an amine group-containing compound, a porphine derivative, a phthalocyanine derivative, a naphthalocyanine derivative, an alkali metal complex, an alkaline earth-metal complex, or one or more combinations thereof. Optionally, the carbocyclic compound, the heterocyclic compound, and the amine group-containing compound may be substituted with a substituent including O, N, S, Se, Si, F, Cl, Br, I, or one or more combinations thereof.

For example, the third capping layer may include a compound represented by Formula 201, a compound represented by Formula 202, or a combination thereof.

In an embodiment, the third capping layer may include at least one of Compounds HT28 to HT33, at least one of Compounds CP1 to CP6 (Compound CP3 is identical to Compound B02/Compounds CP1 to CP6 are distinguishable from Compound CP01 to CP06 described in the present disclosure, respectively), β-NPB, or one or more compounds thereof:

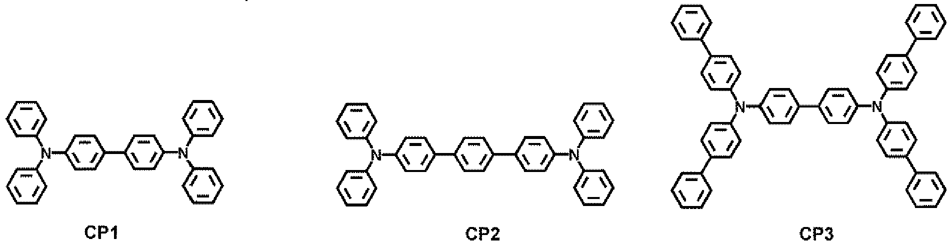

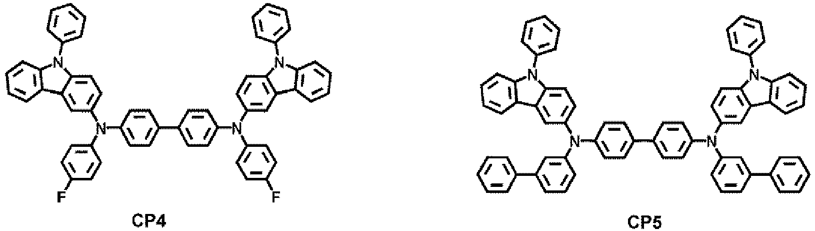

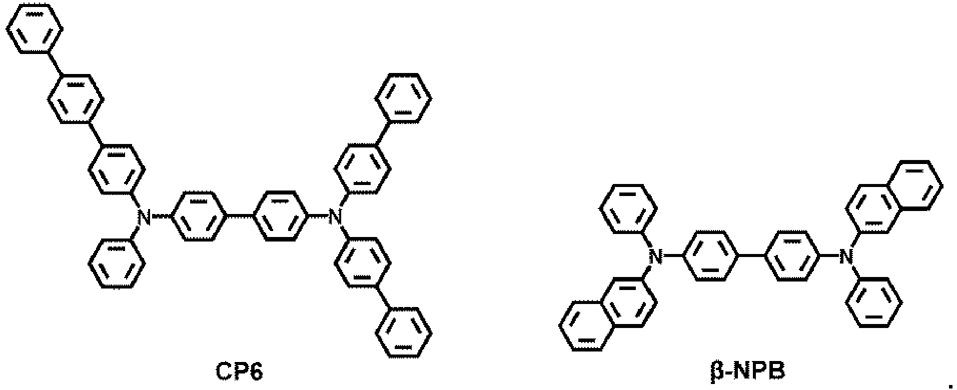

In one or more embodiments, the light-emitting device may further include:
i) a structure in which the first electrode, the interlayer, the second electrode, and the second capping layer (including the amine-containing compound described in the present disclosure) are sequentially stacked;
ii) a structure in which the first electrode, the interlayer, the second electrode, the third capping layer (containing a compound different from the amine-containing compound described in the present disclosure), and the second capping layer (including the amine-containing compound described in the present disclosure) are sequentially stacked, or
iii) a structure in which the first electrode, the interlayer, the second electrode, the second capping layer (including the amine-containing compound described in the present disclosure), and the third capping layer (containing a compound different from the amine-containing compound described in the present disclosure) are sequentially stacked.

In this regard, the first light emitted from the first emitter of the emission layer included in the interlayer may be extracted to the outside of the light-emitting device through the second electrode and then the second capping layer (or the second capping layer and the third capping layer), and the second electrode may be a semi-transmissive electrode or a transmissive electrode.

The wording "the interlayer (or, a capping layer) includes a first emitter (or an amine-containing compound)" refers to "the interlayer (or a capping layer) may include one type or kind of a compound belonging to the category of the first emitter or two or more types (kinds) of different compounds belonging to the first emitter (or one type or kind of compound belonging to an amine-containing compound or two or more different compounds belonging to an amine-containing compound).

The term "interlayer" as utilized herein refers to a single layer and/or all of a plurality of layers between the first electrode and the second electrode of the light-emitting device.

An embodiment of the present disclosure provides an electronic apparatus including the light-emitting device. The electronic apparatus may further include a thin-film transistor. For example, the electronic apparatus may further include a thin-film transistor including a source electrode and a drain electrode, wherein the first electrode of the light-emitting device may be electrically connected to the source electrode or the drain electrode. In an embodiment, the electronic apparatus may further include a color filter, a color conversion layer, a touch screen layer, a polarizing layer, or one or more combinations thereof. For more details on the electronic apparatus, related descriptions provided herein may be referred to.

An embodiment of the present disclosure provides a consumer product including the light-emitting device.

For example, the consumer product may be one of a flat panel display, a curved display, a computer monitor, a medical monitor, a TV, a billboard, indoor or outdoor illuminations and/or signal light, a head-up display, a fully or partially transparent display, a flexible display, a rollable display, a foldable display, a stretchable display, a laser printer, a phone, a cell phone, a tablet, a phablet, a personal digital assistant (PDA) , a wearable device, laptop computers, digital cameras, camcorders, viewfinders, micro displays, 3D displays, virtual or augmented reality displays, vehicles, a video wall including multiple displays tiled together, a theater or stadium screen, a phototherapy device, a signage, etc.

### Description of Formulae

The first emitter may be, for example, an organometallic compound represented by Formula 1. In some embodiments, the amine-containing compound may be, for example, a compound represented by Formula 8:

**Formula 1** **Ir(L₁)(L₂)(L₃)**

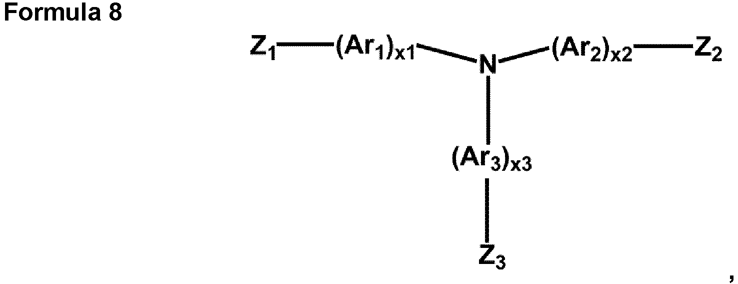

wherein, in Formula 1,
L₁ is a first ligand which is bonded to Ir of Formula 1, and is represented by Formula 1-1,
L₂ is a second ligand which is bonded to Ir of Formula 1, and is represented by Formula 1-2, and
L₃ is a third ligand which is bonded to Ir of Formula 1, and is represented by Formula 1-3: 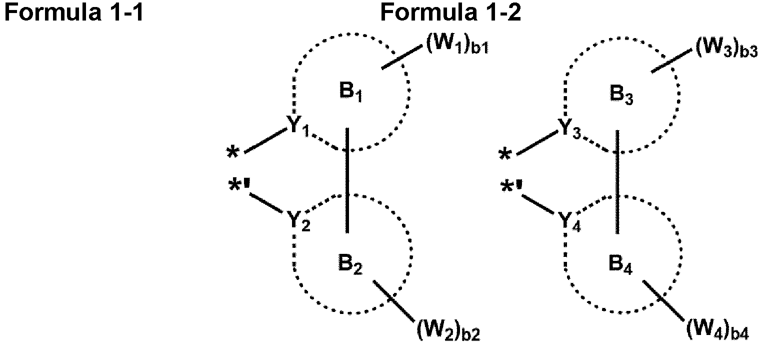 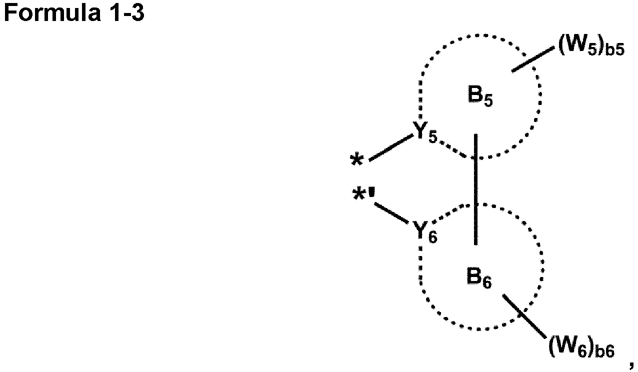
wherein, in Formulae 1-1 to 1-3, and 8,
each of Y₁, Y₃, and Y₅ is nitrogen (N),
each of Y₂, Y₄, and Y₆ is carbon (C),
ring B₁ to ring B₆ may each independently be a C₃-C₆₀ carbocyclic group or a C₁-C₆₀ heterocyclic group, and the Y₂-containing ring B₂ of Formula 1-1 is different from the Y₄-containing ring B₄ of Formula 1-2,
Ar₁ to Ar₃ and Z₁ to Z₃ may each independently be a C₃-C₆₀ carbocyclic group unsubstituted or substituted with at least one R₁₀ₐ, or a C₁-C₆₀ heterocyclic group unsubstituted or substituted with at least one R₁₀ₐ,
x1 to x3 may each independently be one of an integer from 0 to 10,
i) when x1 is 0, *-(Ar₁)ₓ₁-*' may be a single bond, ii) when x2 is 0, *-(Ar₂)ₓ₂-*' may be a single bond, and iii) when x3 is 0, *-(Ar₃)ₓ₃-*' may be a single bond,
W₁ to W₆ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
b1 to b6 may each independently be an integer from 0 to 20,
* and *' in Formulae 1-1 to 1-3 may each indicate a binding site to Ir in Formula 1,
Each of i) two groups of W₁(s) in the number of b1, ii) two groups of W₂(s) in the number of b2, iii) two groups of W₃(s) in the number of b3, iv) two groups of W₄(s) in the number of b4, v) two groups of W₅(s) in the number of b5, and vi) two groups of W₆(s) in the number of b6, may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,

R₁₀ₐ may be:
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or one or more combinations thereof,
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), or one or more combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or one or more combinations thereof.

In an embodiment, the organometallic compound represented by Formula 1 may be a heteroleptic complex.

In one or more embodiments, in Formula 1,
i) L₃ may be identical to L₂,
ii) L₃ may be identical to L₁, or
iii) L₃ may be different from each of L₁ and L₂.

In an embodiment, ring B₁, ring B₃, and ring B₅ may each independently be:
a pyridine group, a pyrimidine group, a pyrazine group, a pyridazine group, or a triazine group; or
a pyridine group, a pyrimidine group, a pyrazine group, a pyridazine group, or a triazine group, to which a cyclopentane group, a cyclohexane group, a norbornane group, a benzene group, a pyridine group, a pyrimidine group, a pyrazine group, a pyridazine group, a triazine group, a furan group, a thiophene group, a selenophene group, a pyrrole group, a cyclopentadiene group, a silole group, or one or more combinations thereof is condensed.

In an embodiment, ring B₁, ring B₃, and ring B₅ may each be a pyridine group.

In an embodiment, ring B₁, ring B₃, and ring B₅ may each independently be:
a benzene group, a pyridine group, a pyrimidine group, a pyrazine group, or a pyridazine group; or
a benzene group, a pyridine group, a pyrimidine group, a pyrazine group, or a pyridazine group, to which a cyclopentane group, a cyclohexane group, a norbornane group, a benzene group, a pyridine group, a pyrimidine group, a pyrazine group, a pyridazine group, a furan group, a thiophene group, a selenophene group, a pyrrole group, a cyclopentadiene group, a silole group, or one or more combinations thereof is condensed.

In an embodiment, ring B₂ may be a benzene group, a pyridine group, a pyrimidine group, a pyrazine group, or a pyridazine group, to which a cyclopentane group, a cyclohexane group, a norbornane group, a benzene group, a pyridine group, a pyrimidine group, a pyrazine group, a pyridazine group, a furan group, a thiophene group, a selenophene group, a pyrrole group, a cyclopentadiene group, a silole group, or one or more combinations thereof is condensed.

In an embodiment, ring B₂ may be a polycyclic group in which one of a furan group, thiophene group, a selenophene group, a pyrrole group, a cyclopentadiene group, and a silole group is condensed with at least two selected from a benzene group, a pyridine group, a pyrimidine group, a pyrazine group, and a pyridazine group.

In an embodiment, ring B₂ may be a dibenzofuran group, a dibenzothiophene group, a dibenzoselenophene group, a carbazole group, a fluorene group, a dibenzosilole group, a naphthobenzofuran group, a naphthobenzothiophene group, a naphthobenzoselenophene group, a benzocarbazole group, a benzofluorene group, a benzodibenzosilole group, a dinaphthofuran group, a dinaphthothiophene group, a dinaphthoselenophene group, a dibenzocarbazole group, a dibenzofluorene group, a dinaphthosilole group, a phenanthrenonbenzofuran group, a phenanthrenonbenzothiophene group, a phenanthrenobenzoselenophene group, a naphthocarbazole group, a naphthofluorene group, a phenanthrenobenzosilole group, an azadibenzofuran group, an azadibenzothiophene group, an azadibenzoselenophene group, an azacarbazole group, an azafluorene group, an azadibenzosilole group, an azanaphthobenzofuran group, an azanaphthobenzothiophene group, an azanaphthobenzoselenophene group, an azabenzocarbazole group, an azabenzofluorene group, an azabenzodibenzosilole group, an azadinaphthofuran group, an azadinaphthothiophene group, an azadinaphthoselenophene group, an azadibenzocarbazole group, an azadibenzofluorene group, an azadinaphthosilole group, an azaphenanthrenonbenzofuran group, an azaphenanthrenonbenzothiophene group, an azaphenanthrenobenzoselenophene group, an azanaphthocarbazole group, an azanaphthofluorene group, or an azaphenanthrenobenzosilole group.

In an embodiment, ring B₂ may be a dibenzofuran group, a dibenzothiophene group, a dibenzoselenophene group, a naphthobenzofuran group, a naphthobenzothiophene group, a naphthobenzoselenophene group, a dinaphthofuran group, a dinaphthothiophene group, a dinaphthoselenophene group, a phenanthrenonbenzofuran group, a phenanthrenonbenzothiophene group, a phenanthrenonbenzoselenophene group, an azadibenzofuran group, an azadibenzothiophene group, an azadibenzoselenophene group, an azanaphthobenzofuran group, an azanaphthobenzothiophene group, an azanaphthobenzoselenophene group, an azadinaphthofuran group, an azadinaphthothiophene group, an azadinaphthoselenophene group, an azaphenanthrenonbenzofuran group, an azaphenanthrenonbenzothiophene group, or an azaphenanthrenonbenzoselenophene group.

In an embodiment, ring B₄ may be a benzene group, a pyridine group, a pyrimidine group, a pyrazine group, or a pyridazine group.

In an embodiment, ring B₆ may be a benzene group, a pyridine group, a pyrimidine group, a pyrazine group, a pyridazine group, a dibenzofuran group, a dibenzothiophene group, a dibenzoselenophene group, a carbazole group, a fluorene group, a dibenzosilole group, a naphthobenzofuran group, a naphthobenzothiophene group, a naphthobenzoselenophene group, a benzocarbazole group, a benzofluorene group, a benzodibenzosilole group, a dinaphthofuran group, a dinaphthothiophene group, a dinaphthoselenophene group, a dibenzocarbazole group, a dibenzofluorene group, a dinaphthosilole group, a phenanthrenonbenzofuran group, a phenanthrenonbenzothiophene group, a phenanthrenonbenzoselenophene group, a naphthocarbazole group, a naphthofluorene group, a phenanthrenobenzosilole group, an azadibenzofuran group, an azadibenzothiophene group, an azadibenzoselenophene group, an azacarbazole group, an azafluorene group, an azadibenzosilole group, an azanaphthobenzofuran group, an azanaphthobenzothiophene group, an azanaphthobenzoselenophene group, an azabenzocarbazole group, an azabenzofluorene group, an azabenzodibenzosilole group, an azadinaphthofuran group, an azadinaphthothiophene group, an azadinaphthoselenophene group, an azadibenzocarbazole group, an azadibenzofluorene group, an azadinaphthosilole group, an azaphenanthrenonbenzofuran group, an azaphenanthrenonbenzothiophene group, an azaphenanthrenonbenzoselenophene group, an azanaphthocarbazole group, an azanaphthofluorene group, or an azaphenanthrenobenzosilole group.

In an embodiment, Ar₁ to Ar₃ and Z₁ to Z₃ in Formula 8 may each independently be a benzene group, a pyridine group, a pyrimidine group, a pyrazine group, a pyridazine group, a triazine group, a benzoxazole group, a benzthiazole group, a naphthooxazole group, or a naphthothiazole group, each unsubstituted or substituted with at least one R₁₀ₐ. For example, at least one of Z₁ to Z₃ in Formula 8 may each independently be a benzoxazole group, a benzthiazole group, a naphthooxazole group, or a naphthothiazole group, each unsubstituted or substituted with at least one R₁₀ₐ. In this regard, R₁₀ₐ may be: deuterium; a C₁-C₂₀ alkyl group substituted or unsubstituted with at least one deuterium; a C₃-C₂₀ carbocyclic group, or a C₁-C₂₀ heterocyclic group, each unsubstituted or substituted with deuterium, a C₁-C₂₀ alkyl group, a C₃-C₂₀ carbocyclic group, a C₁-C₂₀ heterocyclic group, or one or more combinations thereof.

x1, x2, and x3 in Formula 8 respectively indicate the number of Ar₁(s), the number of Ar₂(s), and the number of Ar₃(s), and, for example, may each independently be 0, 1, 2, or 3.

In an embodiment, W₁ to W₆ in Formula 1 may each independently be:
hydrogen, deuterium, -F, or a cyano group;
a C₁-C₂₀ alkyl group or a C₃-C₁₀ cycloalkyl group, each unsubstituted or substituted with deuterium, -F, cyano group, or one or more combinations thereof;
a phenyl group, a biphenyl group, a naphthyl group, a dibenzofuranyl group, or a dibenzothiophenyl group (or a thienyl group), each unsubstituted or substituted with deuterium, -F, cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or one or more combinations thereof; or
-Si(Q₁)(Q₂)(Q₃).

In this regard, Q₁ to Q₃ are each the same as described above.

In an embodiment, at least one of W₁ to W₆ may include at least one deuterium.

In an embodiment, at least one of W₁ to W₆ may be a deuterated C₁-C₂₀ alkyl group, or a deuterated C₃-C₁₀ cycloalkyl group.

The term "biphenyl group" as utilized herein refers to a monovalent substituent having a structure in which two benzene groups are connected to each other through a single bond.

Examples of the C₃-C₁₀ cycloalkyl group as utilized herein are a cyclopentyl group, a cyclohexyl group, a cycloheptyl group, an adamantanyl group, a norbornanyl group, and/or the like.

The term "deuterated" utilized herein includes both (e.g., simultaneously) fully deuterated and partially deuterated.

The term "fluorinated" utilized herein includes both (e.g., simultaneously) fully fluorinated and partially fluorinated.

b1 to b6 in Formula 1 respectively indicate the numbers of W₁ to W₆, and for example, may be, each independently 0, 1, 2, 3, or 4. When b1 is 2 or more, two or more of W₁(s) may be identical to or different from each other, when b2 is 2 or more, two or more of W₂(s) may be identical to or different from each other, when b3 is 2 or more, two or more of W₃(s) may be identical to or different from each other, when b4 is 2 or more, two or more of W₄(s) may be identical to or different from each other, when b5 is 2 or more, two or more of W₅(s) may be identical to or different from each other, and when b6 is 2 or more, two or more of W₆(s) may be identical to or different from each other.

In an embodiment, the first emitter may be an organometallic compound represented by Formula 1A:

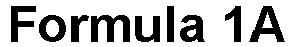

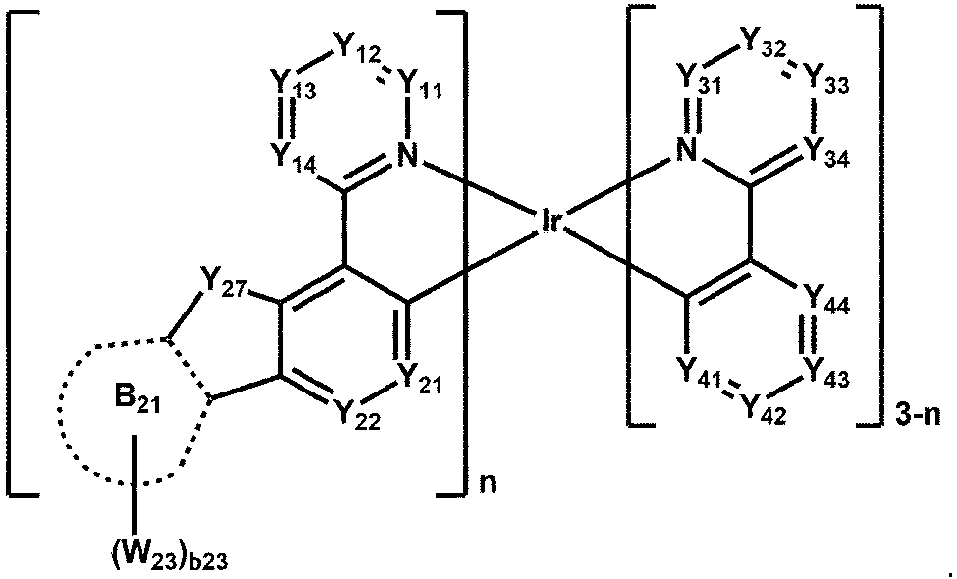

In an embodiment, the first emitter may be an organometallic compound represented by Formula 1A-1: 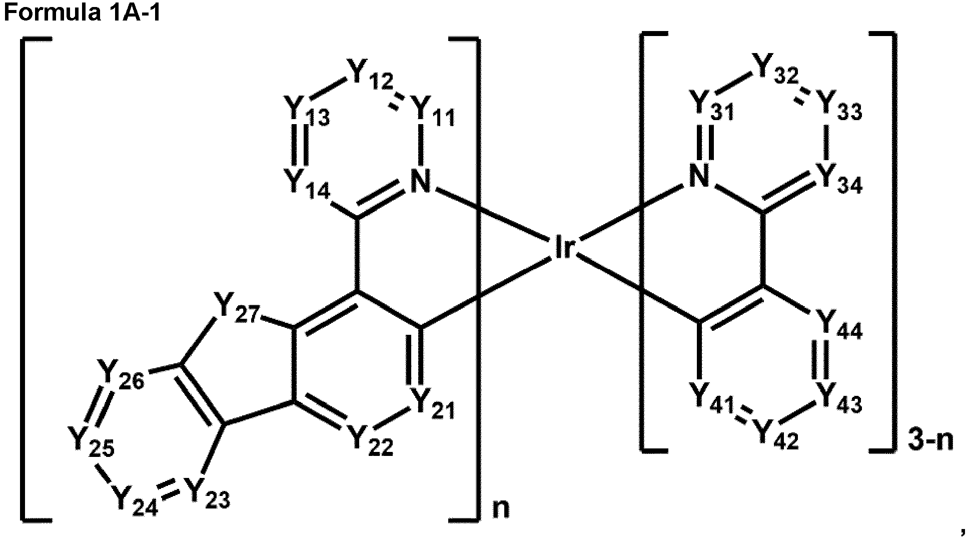
wherein, in Formulae 1A and 1A-1,
n may be 1 or 2,
ring B₂₁ may be a C₃-C₆₀ carbocyclic group or a C₁-C₆₀ heterocyclic group,
Y₁₁ may be C(W₁₁) or N, Y₁₂ may be C(W₁₂) or N, Y₁₃ may be C(W₁₃) or N, Y₁₄ may be C(W₁₄) or N, Y₂₁ may be C(W₂₁) or N, Y₂₂ may be C(W₂₂) or N, Y₂₃ may be C(W₂₃) or N, Y₂₄ may be C(W₂₄) or N, Y₂₅ may be C(W₂₅) or N, Y₂₆ may be C(W₂₆) or N, Y₃₁ may be C(W₃₁) or N, Y₃₂ may be C(W₃₂) or N, Y₃₃ may be C(W₃₃) or N, Y₃₄ may be C(W₃₄) or N, Y₄₁ may be C(W₄₁) or N, Y₄₂ may be C(W₄₂) or N, Y₄₃ may be C(W₄₃) or N, and Y₄₄ may be C(W₄₄) or N,
Y₂₇ may be O, S, Se, N(W₂₇), or C(W₂₇ₐ)(W_{27b}),
W₁₁ to W₁₄ are each the same as described in connection with W₁,
W₂₁ to W₂₇, W₂₇ₐ, and W_{27b} are each the same as described in connection with W₂,
b23 may be an integer from 0 to 20,
W₃₁ to W₃₄ are each the same as described in connection with W₃,
W₄₁ to W₄₄ are each the same as described in connection with W₄,
two or more of W₁₁ to W₁₄ may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ,
two or more of W₂₁ to W₂₇, and W₂₇ₐ and W_{27b} may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ,
two or more of W₃₁ to W₃₄ may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ, and
two or more of W₄₁ to W₄₄ may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ.

Because n is 1 or 2 in Formula 1A and 1A-1, Formulae 1A and 1A-1 may correspond to an organometallic compound in which the third ligand in Formula 1 is the same as the second ligand or the first ligand.

In an embodiment, a ring B₂₁ in Formula 1A may be a benzene group, a naphthalene group, a phenanthrene group, an anthracene group, a pyridine group, a pyrimidine group, a pyrazine group, a pyridazine group, a quinoline group, an isoquinoline group, a quinoxaline group, a quinazoline group, a benzoquinoline group, a benzoisoquinoline group, a benzoquinoxaline group, or a benzoquinazoline group.

In an embodiment, ring B₂₁ in Formula 1A may be a pyridine group, a pyrimidine group, a pyrazine group, a pyridazine group, a quinoline group, an isoquinoline group, a quinoxaline group, a quinazoline group, a benzoquinoline group, a benzoisoquinoline group, a benzoquinoxaline group, or a benzoquinazoline group.

In an embodiment, at least one of Y₂₁ to Y₂₆ in Formula 1A-1 may be N.

In an embodiment, at least one of Y₂₃ to Y₂₆ in Formula 1A-1 may be N.

In an embodiment, Y₂₆ in Formula 1A-1 may be N.

In an embodiment, each of Y₂₁ to Y₂₅ in Formula 1A-1 may not be **N,** and Y₂₆ may be N.

In an embodiment, each of Y₁₁ to Y₁₄, Y₂₁, Y₂₂, Y₃₁ to Y₃₄ and Y₄₁ to Y₄₄ in Formula 1A and 1A-1 may not be N.

In an embodiment, a group represented by 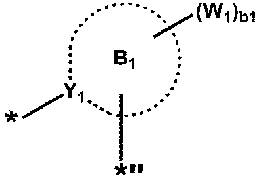 in Formula 1-1, a group represented by 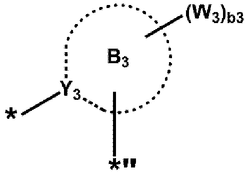 in Formula 1-2, a group represented by 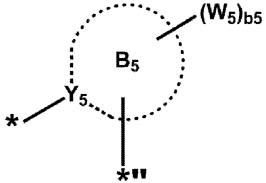 in Formula 1-3, a group represented by 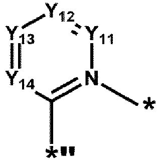 in Formulae 1A and 1A-1, and a group represented by 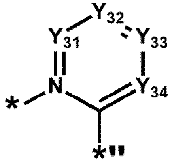 in Formulae 1A and 1A-1 may each independently be a group represented by one of Formulae BN-1 to BN-16: 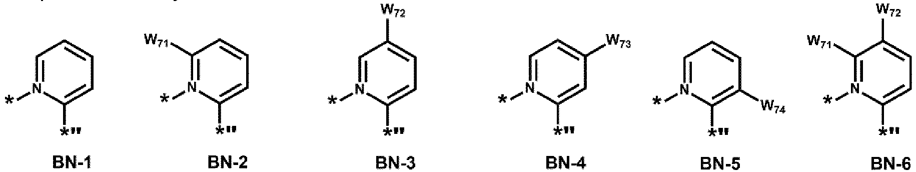 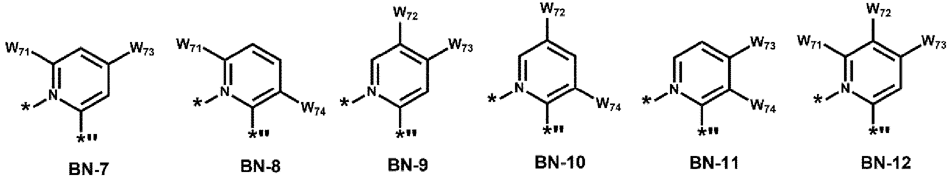 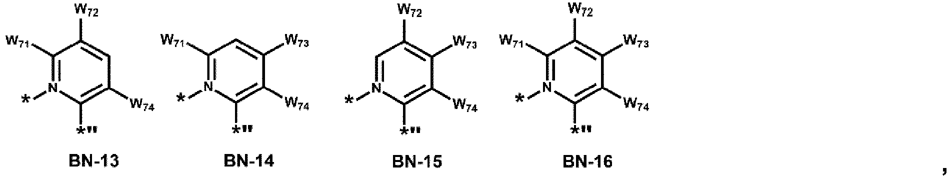
wherein, in Formulae BN-1 to BN-16,
W₇₁ to W₇₄ are each the same as described in connection with W₁, W₃, or W₅, provided that each of W₇₁ to W₇₄ may not be hydrogen,
* indicates a binding site to iridium in Formulae 1, 1A, and 1A-1, and
*" indicates a binding site to a neighboring atom in Formulae 1, 1A and 1A-1.

In an embodiment, a group represented by 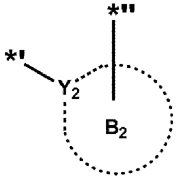 in Formula 1-1, a group represented by 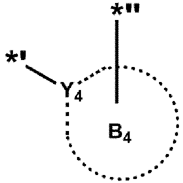 in Formula 1-2, and a group represented by 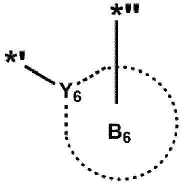 in Formula 1-3 may each independently be a group represented by one of Formulae BC-1 to BC-47: 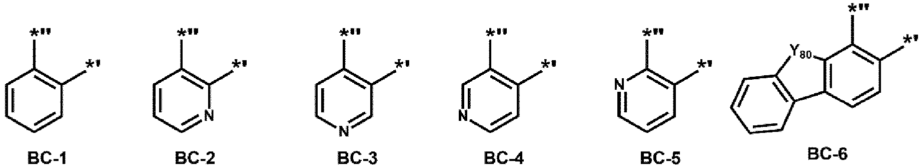 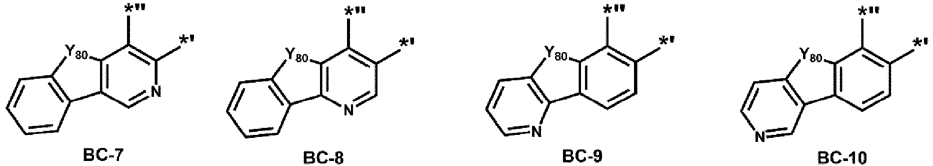 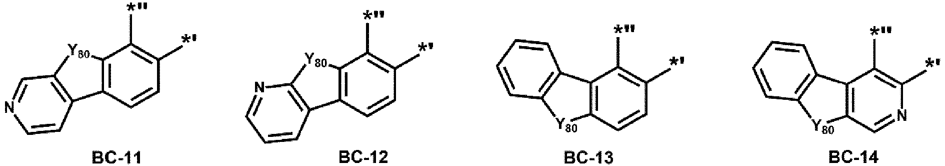 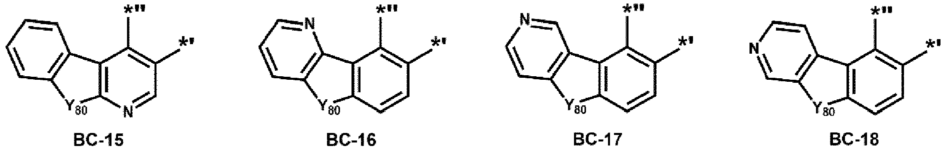 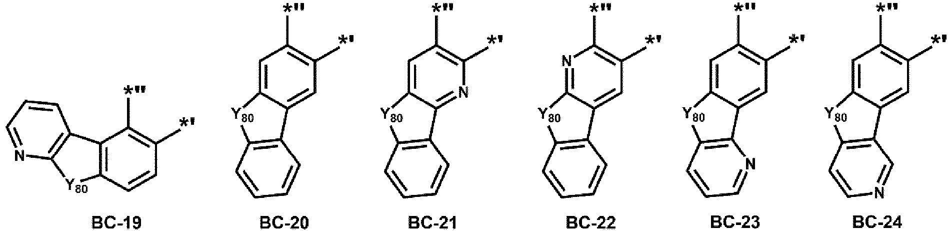 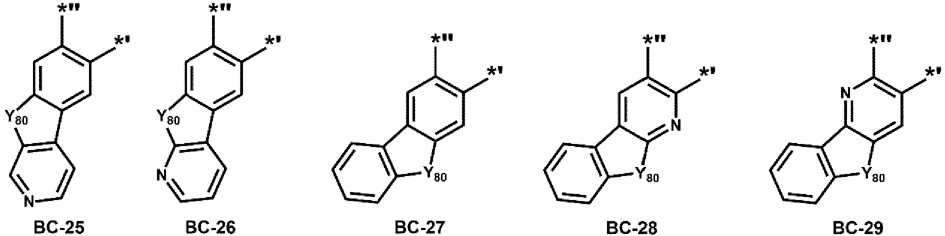 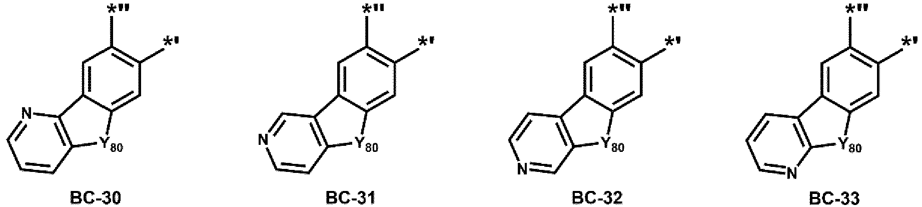 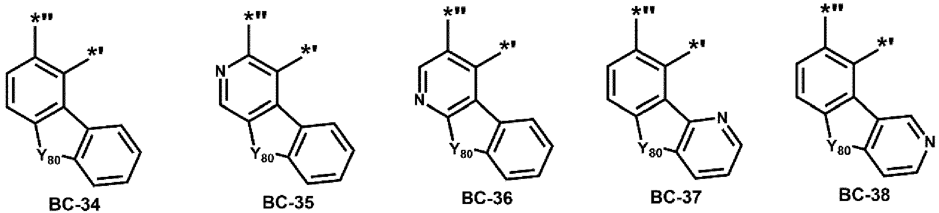 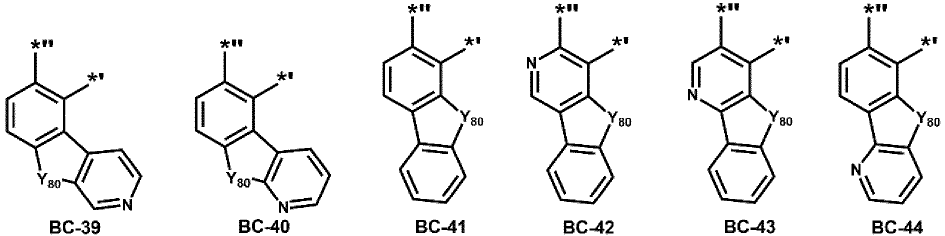 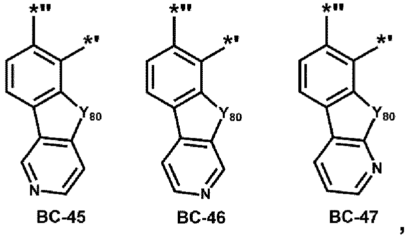
wherein, in Formulae BC-1 to BC-47,
Y₈₀ may be O, S, Se, N(W₈₀), C(W₈₀ₐ)(W_{80b}), or Si(W₈₀ₐ)(W_{80b}),
W₈₀, W₈₀ₐ, and W_{80b} are each the same as described in connection with W₂, W₄, or W₆,
*' indicates a binding site to iridium in Formula 1, and
*" indicates a binding site to a neighboring atom in Formula 1.

Formulae BC-1 to BC-47 may be substituted or unsubstituted with W₂, W₄, or W₆ as described above, and may be understood with reference to the structures of Formulae 1-1, 1-2, and 1-3.

In an embodiment, a group represented by 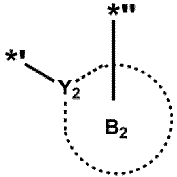 in Formula 1-1 may be one of Formulae BC-6 to BC-47.

In an embodiment, a group represented by 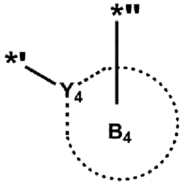 in Formula 1-2 may be represented by one of Formulae BC-1 to BC-5.

In an embodiment, the amine-containing compound may be represented by a compound such as Formula 8-1: 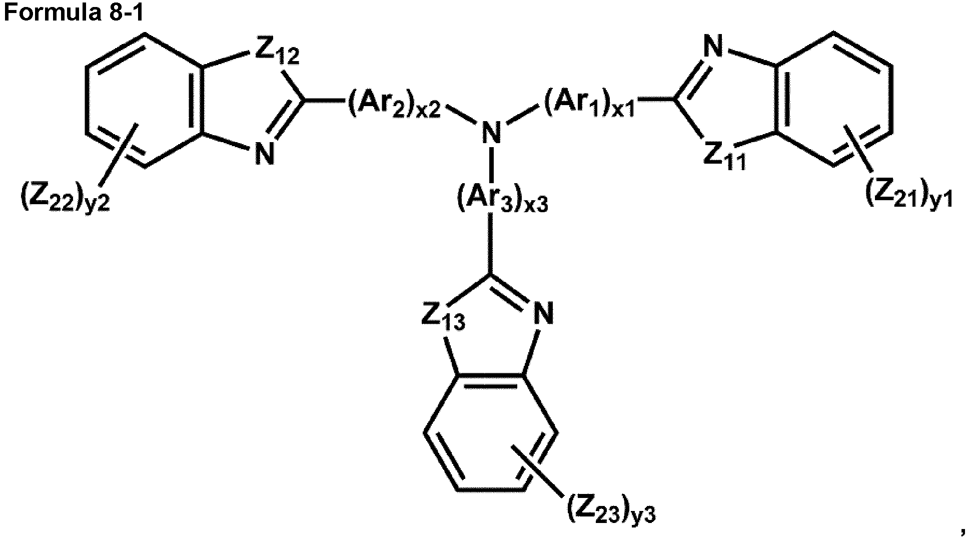
wherein, in Formula 8-1,
Ar₁ to Ar₃ and x1 to x3 are each the same as described above,
Z₁₁ to Z₁₃ may each independently be O or S,
Z₂₁ to Z₂₃ are each the same as described in connection with R₁₀ₐ,
y1 to y3 may each independently be an integer from 0 to 4.

b51 to b53 in Formulae 2-1 and 2-2 indicate numbers of L₅₁ to L₅₃, respectively, and may each be an integer from 1 to 5. When b51 is 2 or more, two or more of L₅₁(s) may be identical to or different from each other, when b52 is 2 or more, two or more of L₅₂(s) may be identical to or different from each other, and when b53 is 2 or more, two or more of L₅₃(s) may be identical to or different from each other. In an embodiment, b51 to b53 may each independently be 1 or 2.

L₅₁ to L₅₃ in Formulae 2-1 and 2-2 may each independently be
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a oxazole group, a isooxazole group, a thiazole group, an isothiazole group, an oxadiazole group, a thiadiazole group, a benzopyrazole group, a benzimidazole group, a benzoxazole group, a benzothiazole group, a benzooxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxine group, a dibenzooxathiine group, a dibenzooxazine group, a dibenzopyran group, a dibenzodithiine group, a dibenzothiazine group, a dibenzothiopyran group, a dibenzocyclohexadiene group, a dibenzodihydropyridine group, a dibenzodihydropyrazine group, an indolocarbazole group, an indolodibenzofuran group, or an indolodibenzothiophene group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), - S(=O)₂(Q₃₁), -P(=O)(Q₃₁)(Q₃₂), or one or more combinations thereof,
wherein Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In Formulae 2-1 and 2-2, X₅₄ may be N or C(R₅₄), X₅₅ may be N or C(R₅₅), X₅₆ may be N or C(R₅₆), and at least one of X₅₄ to X₅₆ may be N. R₅₄ to R₅₆ may each independently be the same as described above. In an embodiment, two or three of X₅₄ to X₅₆ may be N.

R₅₁ to R₅₇, R₅₇ₐ, R_{57b}, R₇₁ to R₇₄, R₈₁ to R₈₅, R₈₂ₐ, R_{82b}, R₈₃ₐ, R_{83b}, R₈₄ₐ, and R_{84b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ aryl alkyl group unsubstituted or substituted with at least one R₁₀ₐ, a C₂-C₆₀ heteroaryl alkyl group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂). Q₁ to Q₃ may each independently be the same as described in the present disclosure.

For example, i) R₁ to R₇, R₅ₐ, R_{5b}, R₆ₐ, R_{6b}, R₇ₐ, R_{7b}, R', and R" in Formula 1, ii) R₅₁ to R₅₇, R₅₇ₐ, R_{57b}, R₇₁ to R₇₄, R₈₁ to R₈₅, R₈₂ₐ, R_{82b}, R₈₃ₐ, R_{83b}, R₈₄ₐ, and R_{84b} in Formulae 2-1, 2-2 and 3-1 to 3-5, and iii) R₁₀ₐ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or one or more combinations thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isooxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium,-F,-CI,-Br,-I,-CD₃,-CD₂H,-CDH₂,-CF₃,-CF₂H,-CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isooxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), - N(Q₃₁)(Q₃₂), -B(Q₃₁)(Q₃₂), -P(Q₃₁)(Q₃₂), -C(=O)(Q₃₁), -S(=O)₂(Q₃₁), -P(=O)(Q₃₁)(Q₃₂), or one or more combinations thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an iso-propyl group, an n-butyl group, an isobutyl group, a sec-butyl group, a tert-butyl group, an n-pentyl group, an isopentyl group, a secpentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or one or more combinations thereof: 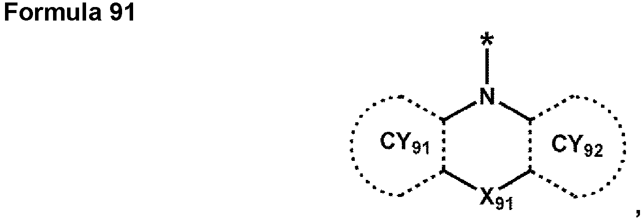
wherein, in Formula 91,
ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
X₉₁ may be a single bond, O, S, N(R₉₁), B(R₉₁), C(R₉₁ₐ)(R_{91b}), or Si(R₉₁ₐ)(R_{91b}),
R₉₁, R₉₁ₐ, and R_{91b} may respectively be understood by referring to the descriptions of R₈₂, R₈₂ₐ, and R_{82b} provided herein,
R₁₀ₐ may be understood by referring to the description of R₁₀ₐ provided herein, and
* indicates a binding site to an adjacent atom.

For example, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ,
R₉₁, R₉₁ₐ, and R_{91b} may each independently be:
   hydrogen or a C₁-C₁₀ alkyl group; or
   a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or one or more combinations thereof.

In an embodiment, i) W_{1 to} W₆, W_{11 to} W₁₄, W_{21 to} W₂₇, W₂₇ₐ, W_{27b}, W_{31 to} W₃₄, W_{41 to} W₄₄, W₇₁ to W₇₄, W₈₀, W₈₀ₐ, and W_{80b} in Formulae 1, 1A, 1A-1, BN-1 to BN-16, and BC-1 to BC-47, ii) R₅₁ to R₅₇, R₅₇ₐ, R_{57b}, R_{71 to} R₇₄, R₈₁ to R₈₅, R₈₂ₐ, R_{82b}, R₈₃ₐ, R_{83b}, R₈₄ₐ, and R_{84b} in Formulae 2-1, 2-2, 3-1 to 3-5, 502, and 503, and iii) R₁₀ₐ may each independently be hydrogen, deuterium, -F, cyano group, a nitro group, -CH₃, - CD₃, -CD₂H, -CDH₂, -CF₃, -CF₂H, -CFH₂, a group represented by one of Formulae 9-1 to 9-19, a group represented by one of Formulae 10-1 to 10-246, -C(Q₁)(Q₂)(Q₃), -Si(Q₁)(Q₂)(Q₃), or -P(=O)(Q₁)(Q₂)(where Q_{1 to} Q₃ may each independently be the same as described above) (where each of R₁₀ₐ and W₇₁ to W₇₄ is not hydrogen): 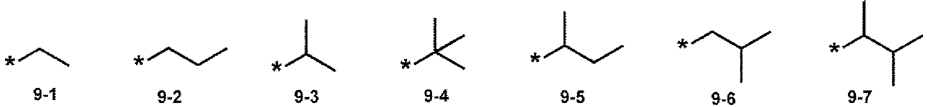 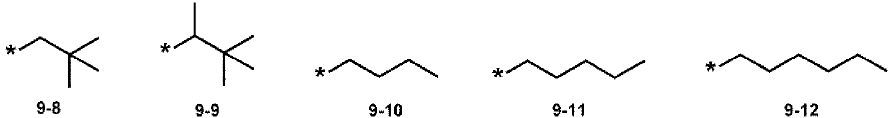 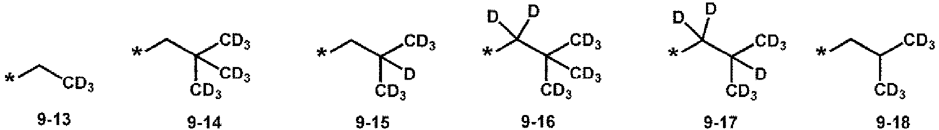 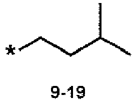 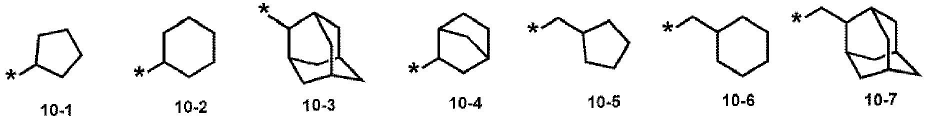 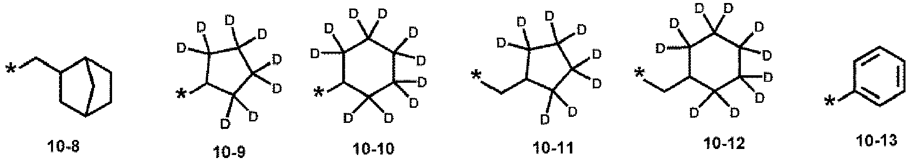 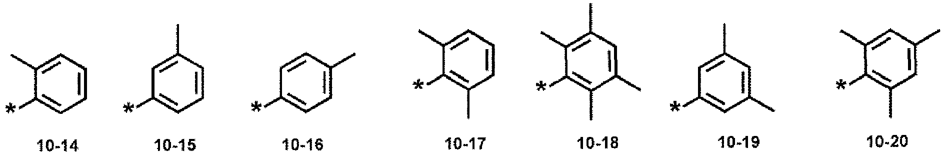 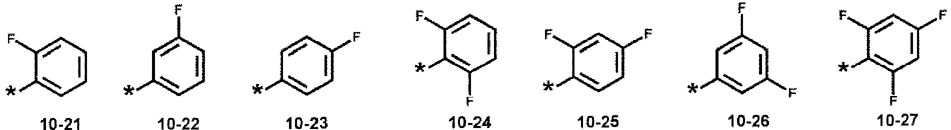 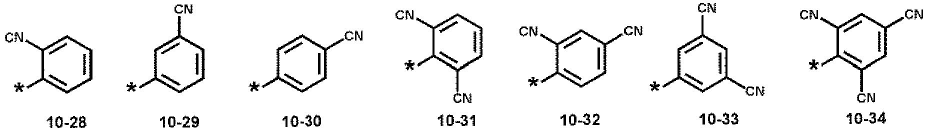 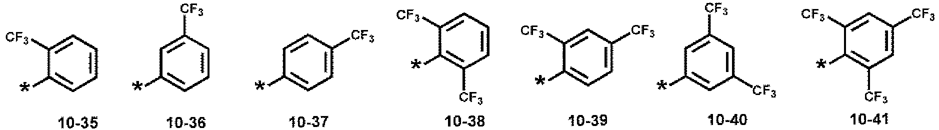 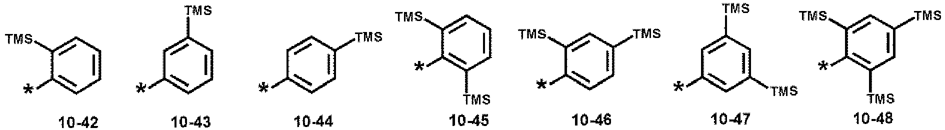 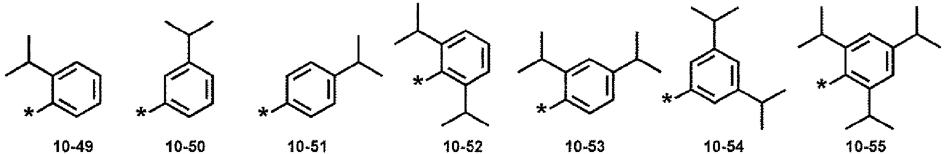 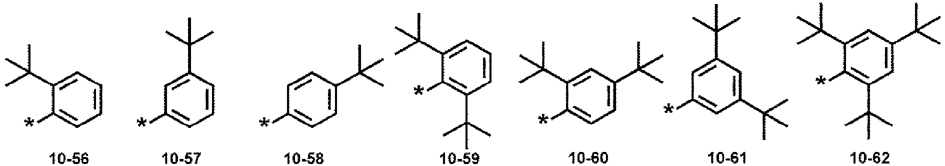 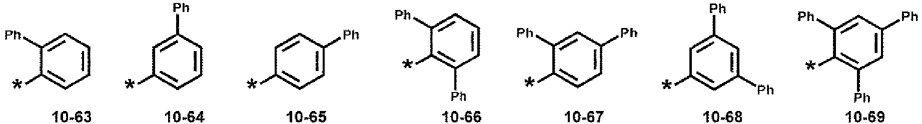 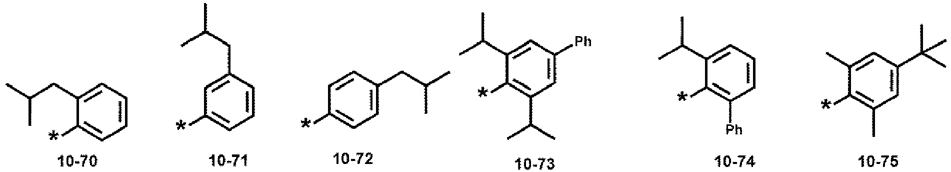 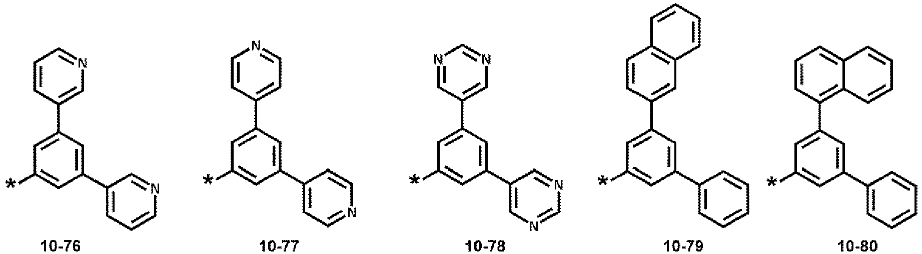 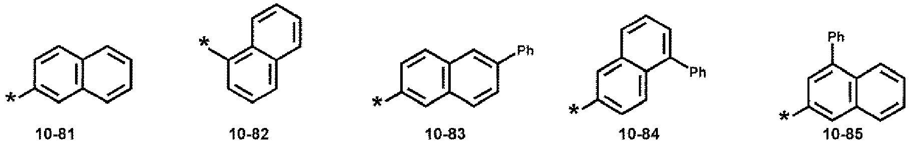 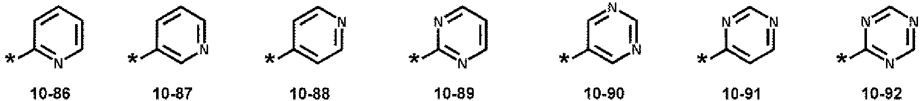 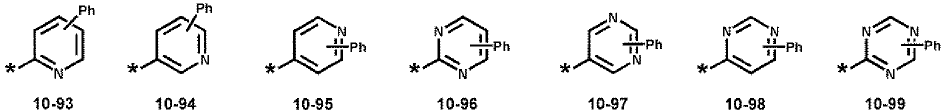 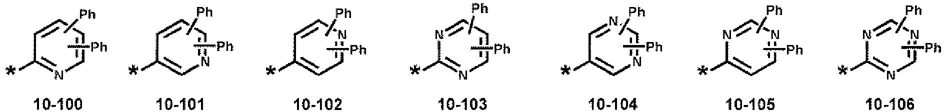 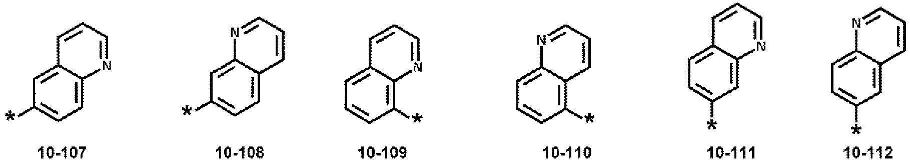 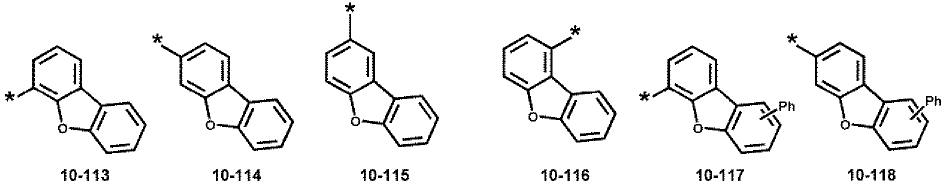 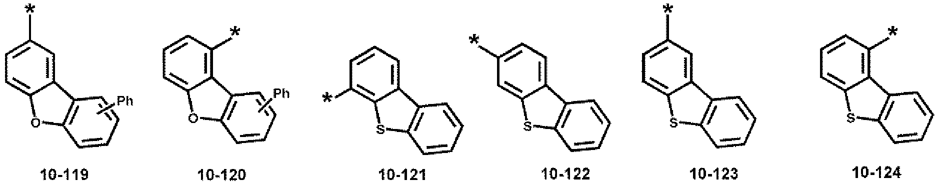 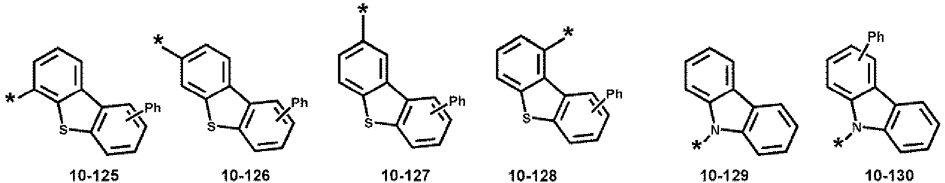 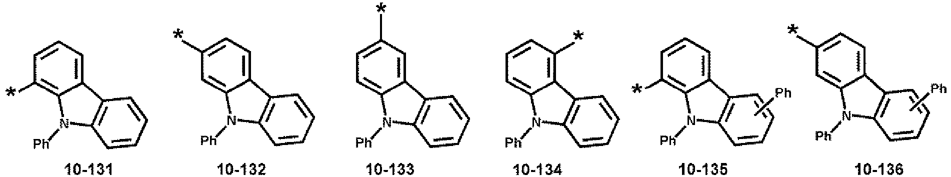 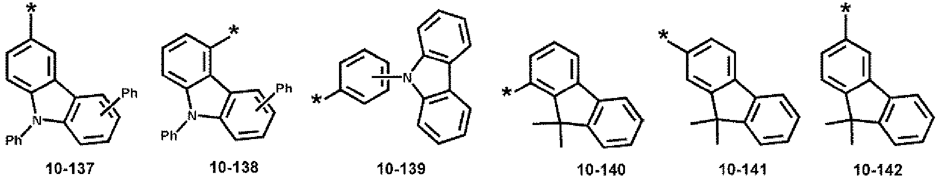 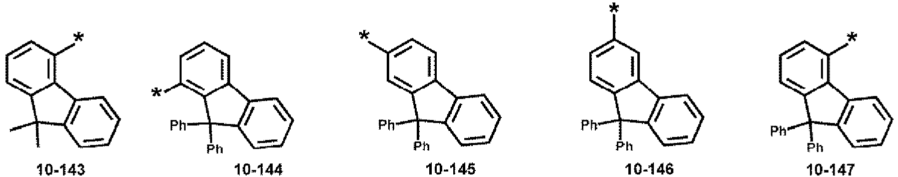 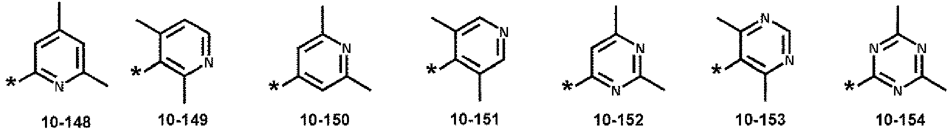 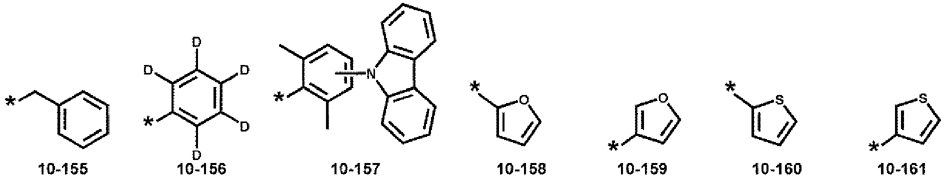 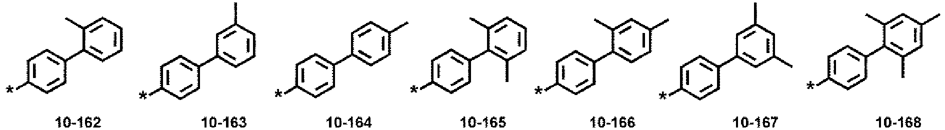 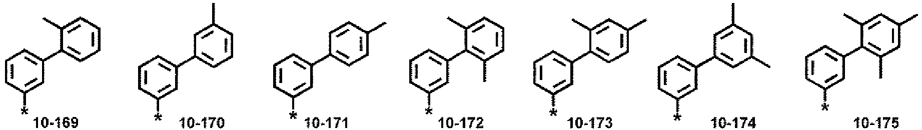 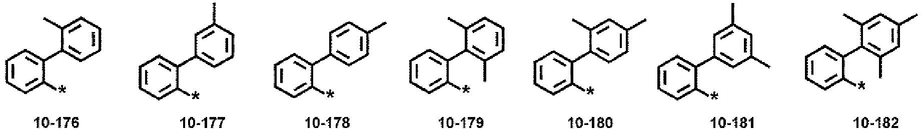 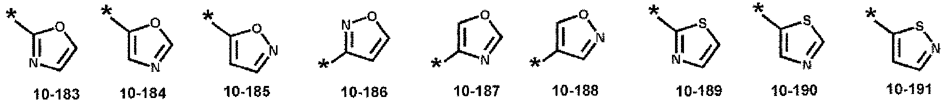 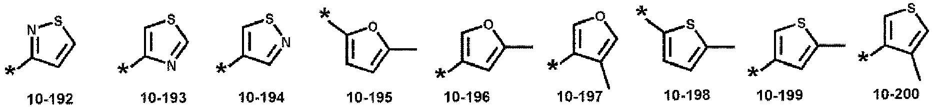 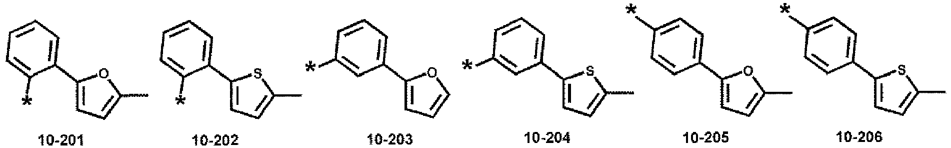 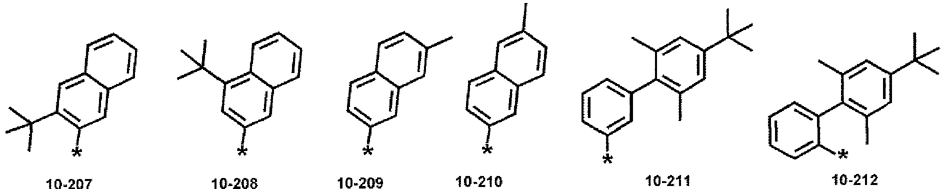 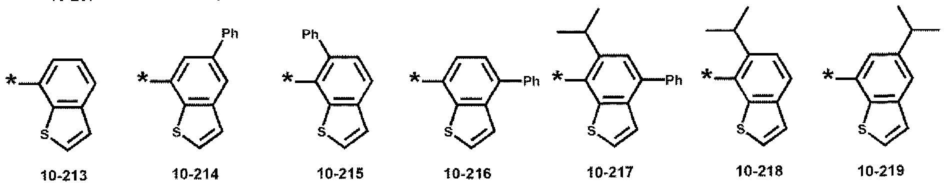 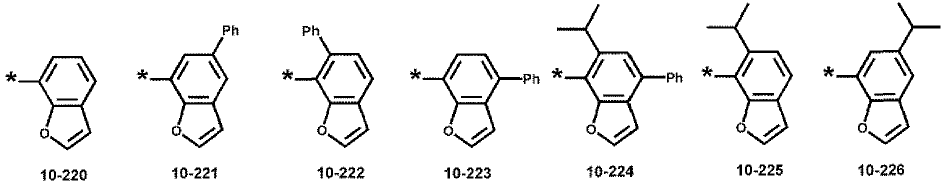 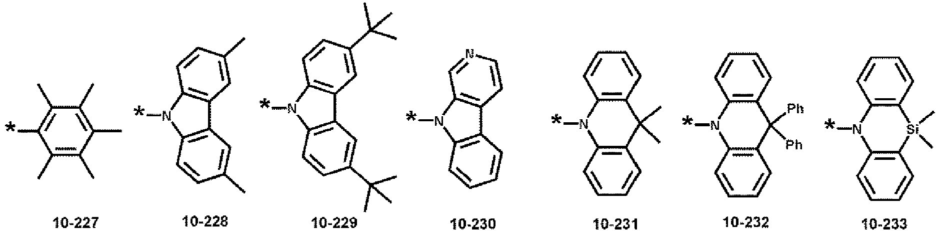 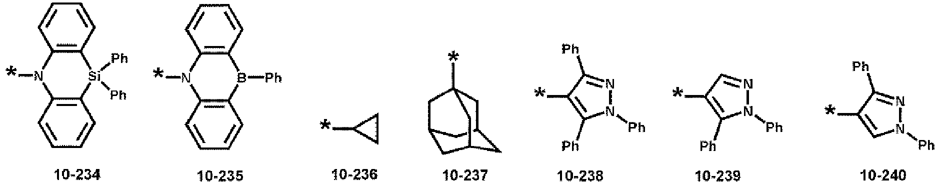 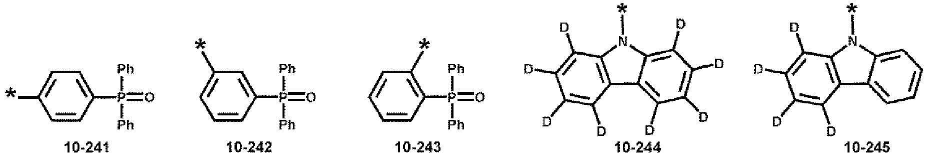 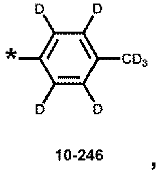 wherein, in Formulae 9-1 to 9-19 and 10-1 to 10-246, * indicates a binding site to an adjacent atom, "Ph" represents a phenyl group, and "TMS" represents a trimethylsilyl group.

a71 to a74 in Formulae 3-1 to 3-5 respectively indicate numbers of R₇₁ to R₇₄, and may each independently be an integer from 0 to 20. When a71 is 2 or more, two or more of R₇₁(s) may be identical to or different from each other, when a72 is 2 or more, two or more of R₇₂(s) may be identical to or different from each other, when a73 is 2 or more, two or more of R₇₃(s) may be identical to or different from each other, and when a74 is 2 or more, two or more of R₇₄(s) may be identical to or different from each other. a71 to a74 may each independently be an integer from 0 to 8.

In Formula 1, i) two or more of W₁(s) in the number of b1 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, ii) two or more of W₂(s) in the number of b2 may optionally be bonded to each other to form a C₃-C₆₀ carbocyclic group unsubstituted or substituted with at least one R10a or a C₁-C₆₀ heterocyclic group unsubstituted or substituted with at least one R₁₀ₐ, iii) two or more of W₃(s) in the number of b3 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, iv) two or more of W₄(s) in the number of b4 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, v) two or more of W₅(s) in the number of b5 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, and/or vi) two or more of W₆(s) in the number of b6 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

L₈₁ to L₈₅ in Formulae 3-1 to 3-5 may each independently be:
a single bond; or
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), -Si(Q₃₁)(Q₃₂)(Q₃₃), -N(Q₃₁)(Q₃₂), - B(Q₃₁)(Q₃₂), -P(Q₃₁)(Q₃₂), -C(=O)(Q₃₁), -S(=O)₂(Q₃₁), -P(=O)(Q₃₁)(Q₃₂), or one or more combinations thereof,
wherein Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In some embodiments, a group represented by 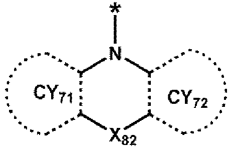 in Formulae 3-1 and 3-2 may be represented by one of Formulae CY71-1(1) to CY71-1(8) and/or,
a group represented by 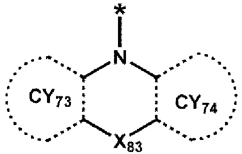 in Formulae 3-1 and 3-3 may be represented by one of Formulae CY71-2(1) to CY71-2(8) and/or,
a group represented by 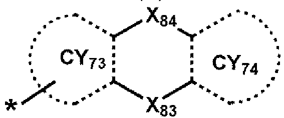 in Formulae 3-2 and 3-4 may be represented by one of Formulae CY71-3(1) to CY71-3(32) and/or,
a group represented by 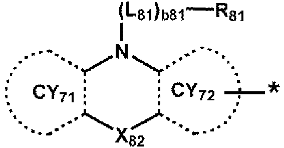 in Formulae 3-3 to 3-5 may be represented by one of Formulae CY71-4(1) to CY71-4(32), and/or
a group represented by 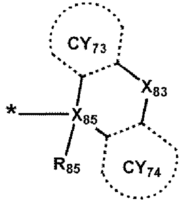 in Formula 3-5 may be represented by one of Formulae CY71-5(1) to CY71-5(8): 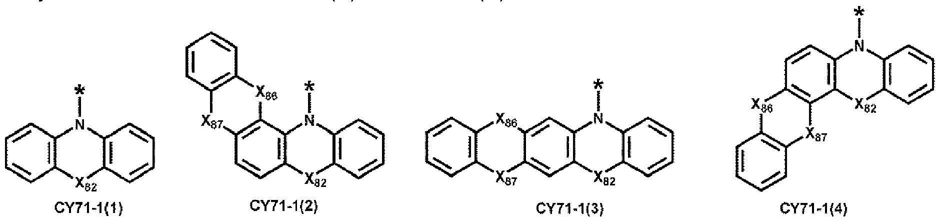 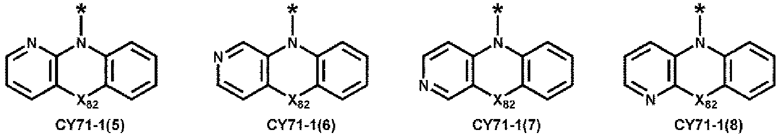 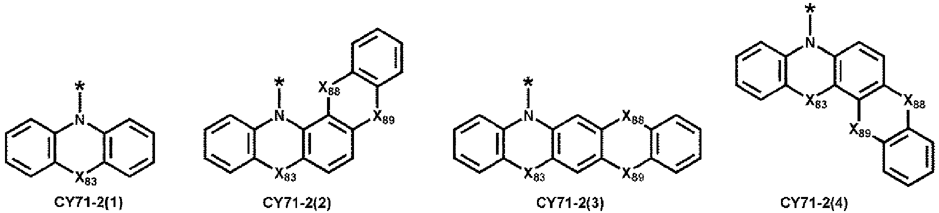 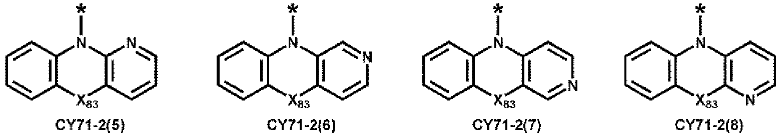 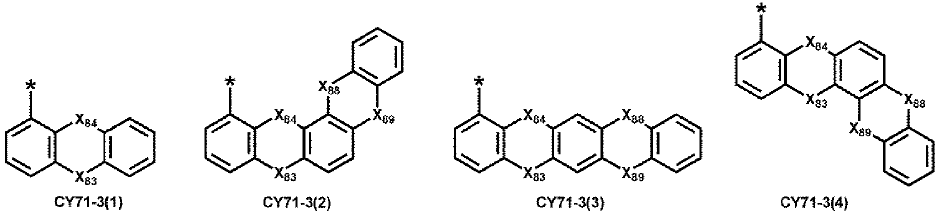 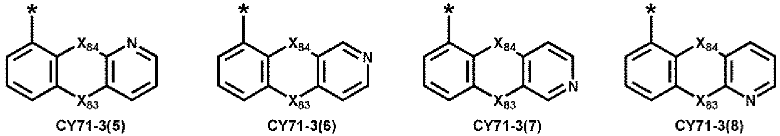 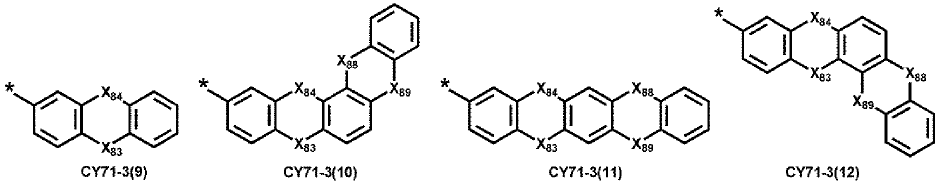 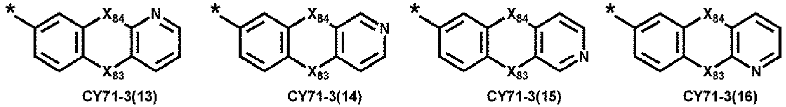 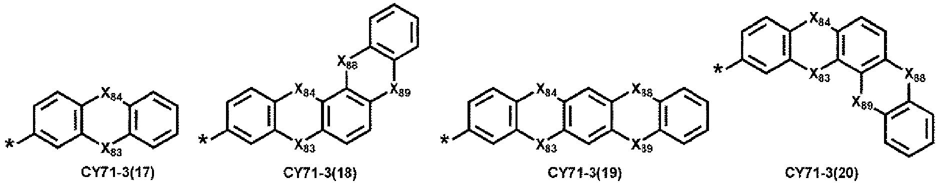 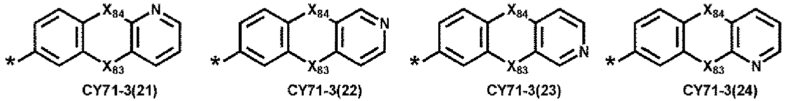 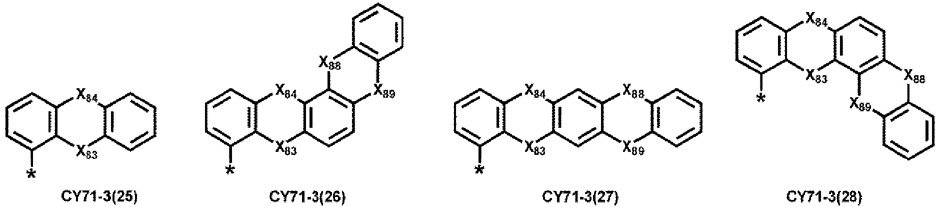 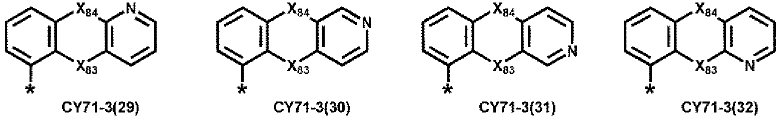 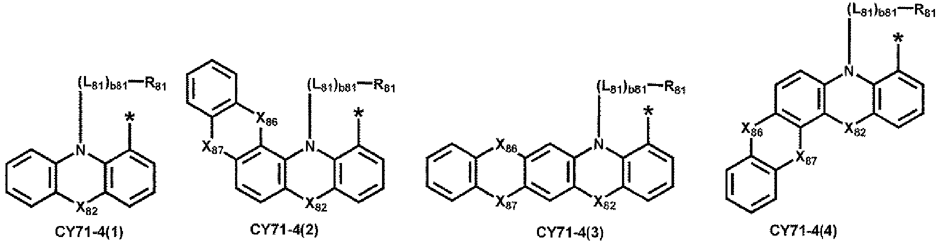 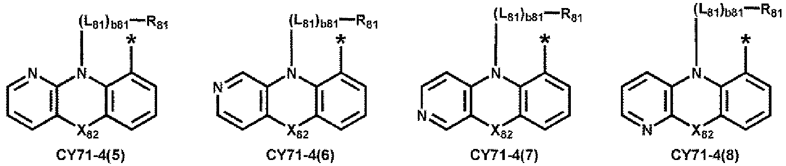 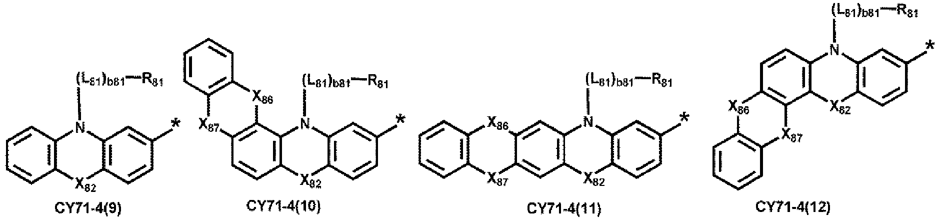 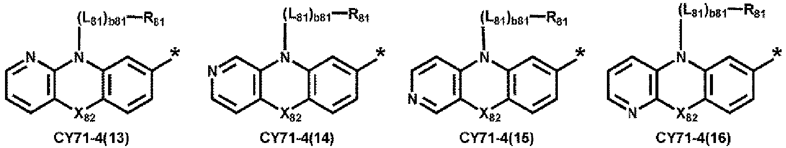 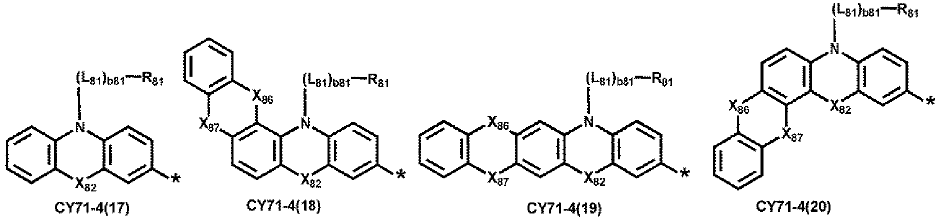 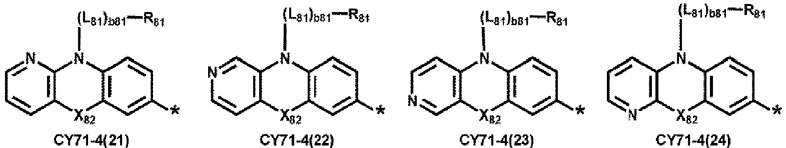 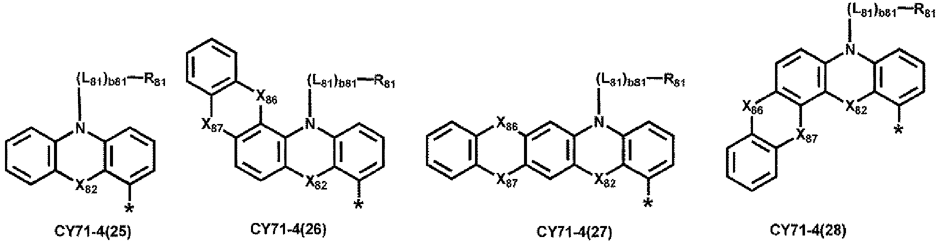 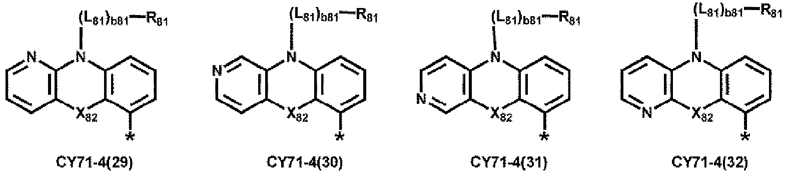 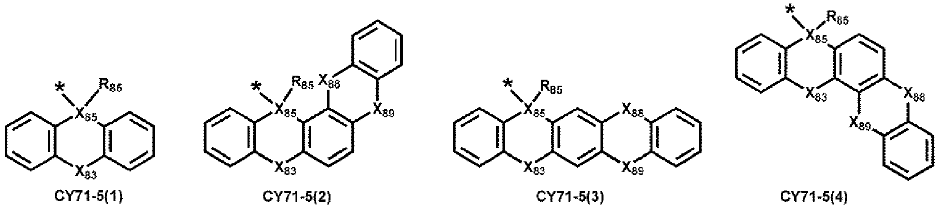 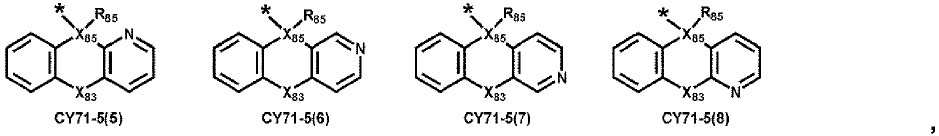
in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₅, L₈₁, b81, R₈₁, and R₈₅ may respectively be understood by referring to the descriptions of X₈₁ to X₈₅, L₈₁, b81, R₈₁, and R₈₅ provided herein,
X₈₆ may be a single bond, O, S, N(R₈₆), B(R₈₆), C(R₈₆ₐ)(R_{86b}), or Si(R₈₆ₐ)(R_{86b}),
X₈₇ may be a single bond, O, S, N(R₈₇), B(R₈₇), C(R₈₇ₐ)(R_{87b}), or Si(R87a)(R87b),
in Formulae CY71-1(1) to CY71-1(8) and CY71-4(1) to CY71-4(32), X₈₆ and X₈₇ may not be a single bond at the same time (concurrently),
X₈₈ may be a single bond, O, S, N(R₈₈), B(R₈₈), C(R₈₈ₐ)(R_{88b}), or Si(R₈₈ₐ)(R_{88b}),
X₈₉ may be a single bond, O, S, N(R₈₉), B(R₈₉), C(R₈₉ₐ)(R_{89b}), or Si(R₈₉ₐ)(R_{89b}),
X₈₈ and X₈₉ in Formulae CY71-2(1) to CY71-2(8), CY71-3(1) to CY71-3(32), and CY71-5(1) to CY71-5(8) may not be a single bond at the same time (concurrently), and
R₈₆ to R₈₉, R₈₆ₐ, R_{86b}, R₈₇ₐ, R_{87b}, R₈₈ₐ, R_{88b}, R₈₉ₐ, and R_{89b} may each be understood by referring to the description of R₈₁ provided herein.

### Compound Example

In an embodiment, the first emitter or the organometallic compound represented by Formula 1, 1A or 1A-1 may be one of Compounds GD-1 to GD-8:

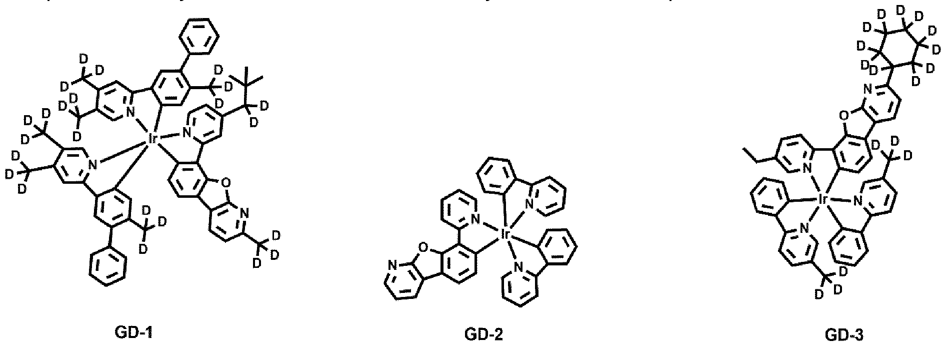

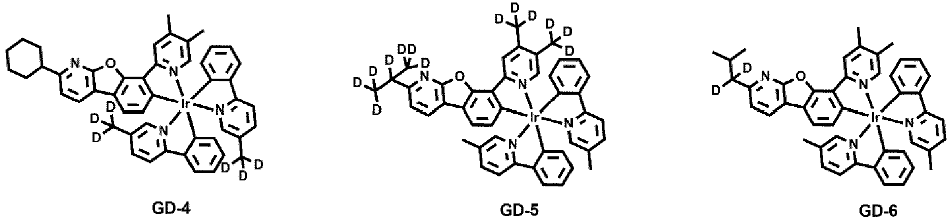

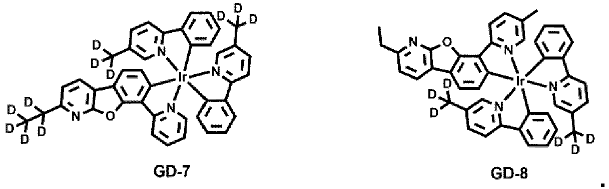

In an embodiment, the amine-containing compound may be one of Compounds CP01 to CP12:

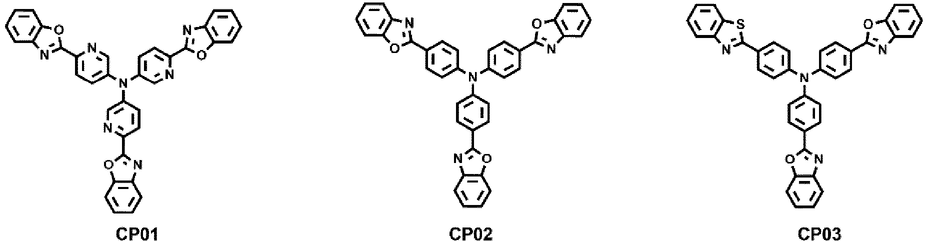

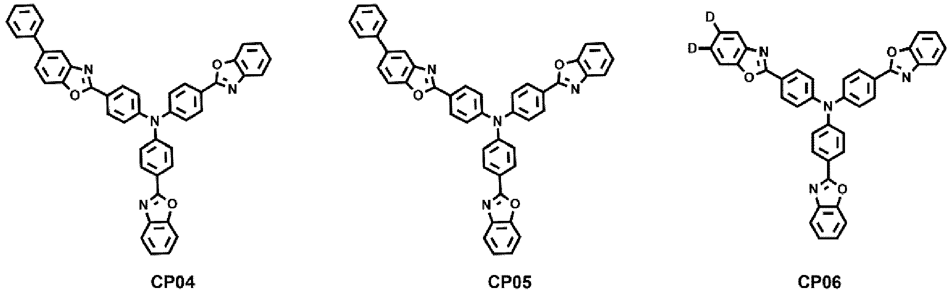

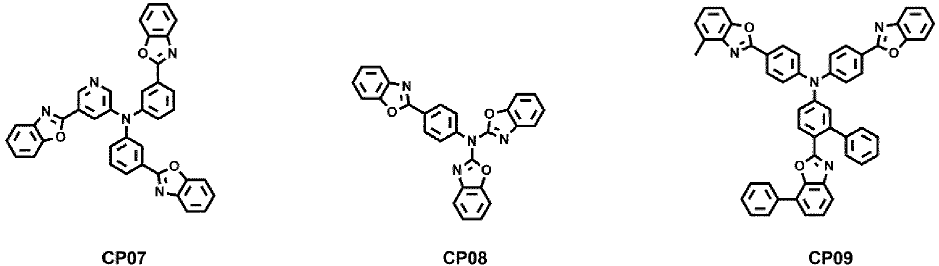

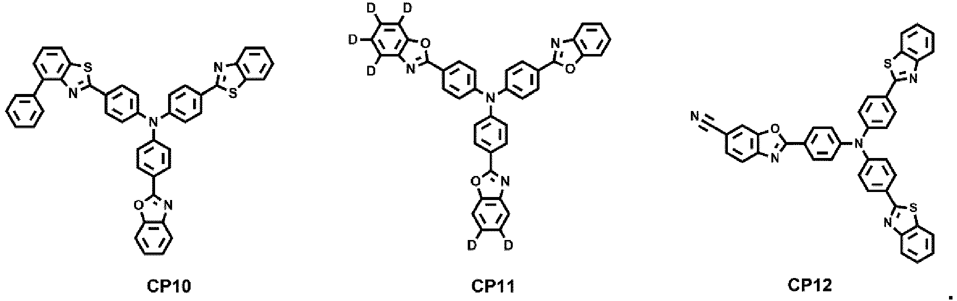

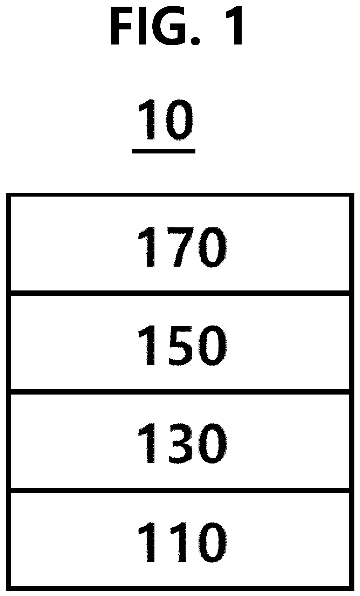

### Description of FIG. 1

FIG. 1 is a schematic cross-sectional view of a light-emitting device 10 according to an embodiment. The light-emitting device 10 includes a first electrode 110, an interlayer 130, a second electrode 150, and a second capping layer 170.

Hereinafter, the structure of the light-emitting device 10 according to an embodiment and a method of manufacturing the light-emitting device 10 will be described with reference to FIG. 1.

### First electrode 110

Referring to FIG. 1, a substrate may be additionally located under the first electrode 110 or above the second capping layer 170. As the substrate, a glass substrate and/or a plastic substrate may be utilized. In one or more embodiments, the substrate may be a flexible substrate, and may include plastics with excellent or suitable heat resistance and durability, such as polyimide, polyethylene terephthalate (PET), polycarbonate, polyethylene napthalate, polyarylate (PAR), polyetherimide, or one or more combinations thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide (SnO₂), zinc oxide (ZnO), or one or more combinations thereof. In one or more embodiments, when the first electrode 110 is a semi-transmissive electrode or a reflective electrode, a material for forming the first electrode 110 may include magnesium (Mg), silver (Ag), aluminum (Al), aluminumlithium (Al-Li), calcium (Ca), magnesium-indium (Mg-In), magnesium-silver (Mg-Ag), or one or more combinations thereof.

The first electrode 110 may have a single-layered structure including (e.g., consisting of) a single layer or a multi-layered structure including a plurality of layers. For example, the first electrode 110 may have a three-layered structure of ITO/Ag/ITO.

### Interlayer 130

The interlayer 130 may be on the first electrode 110. The interlayer 130 may include an emission layer.

The interlayer 130 may further include a hole transport region between the first electrode 110 and the emission layer, and an electron transport region between the emission layer and the second electrode 150.

The interlayer 130 may further include, in addition to one or more suitable organic materials, a metal-containing compound such as an organometallic compound, an inorganic material such as quantum dots, and/or the like.

In some embodiments, the interlayer 130 may include i) two or more emitting units sequentially stacked between the first electrode 110 and the second electrode 150 and ii) a charge generation layer between neighboring two emitting units. When the interlayer 130 includes emitting units and a charge generation layer as described above, the light-emitting device 10 may be a tandem light-emitting device.

### Hole transport region in interlayer 130

The hole transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The hole transport region may include a hole injection layer, a hole transport layer, an emission auxiliary layer, an electron-blocking layer, or one or more combinations thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, the layers of each structure being stacked sequentially from the first electrode 110.

The hole transport region may include a compound represented by Formula 201, a compound represented by Formula 202, or a combination thereof: 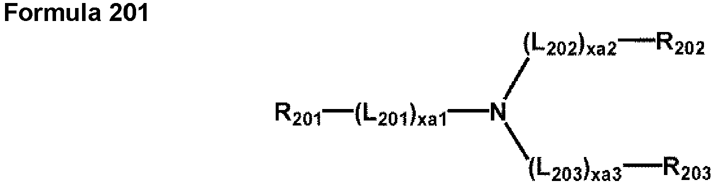 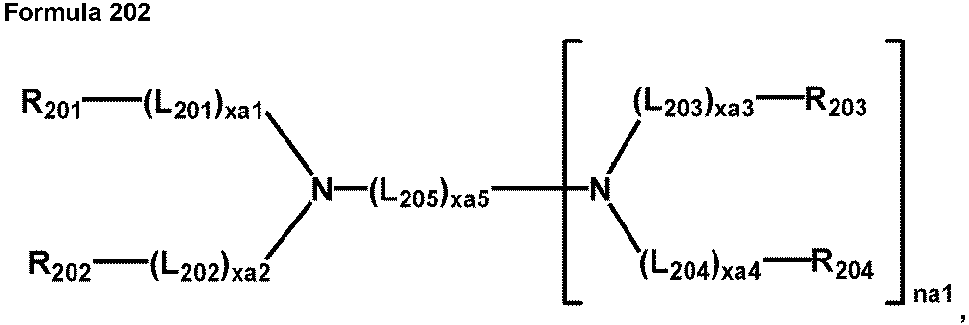
wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ, or a C₁-C₆₀ heterocyclic group unsubstituted or substituted with at least one R₁₀ₐ,
R₂₀₁ and R₂₀₂ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group (for example, a carbazole group and/or the like) unsubstituted or substituted with at least one R₁₀ₐ (for example, see Compound HT16),
R₂₀₃ and R₂₀₄ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

For example, each of Formulae 201 and 202 may include at least one of groups represented by Formulae CY201 to CY217.

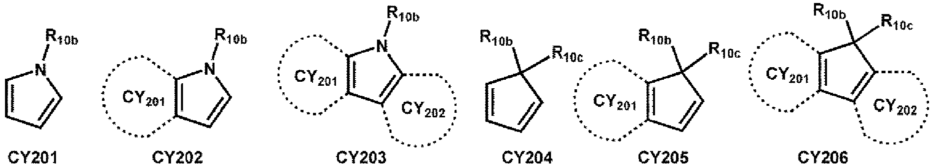

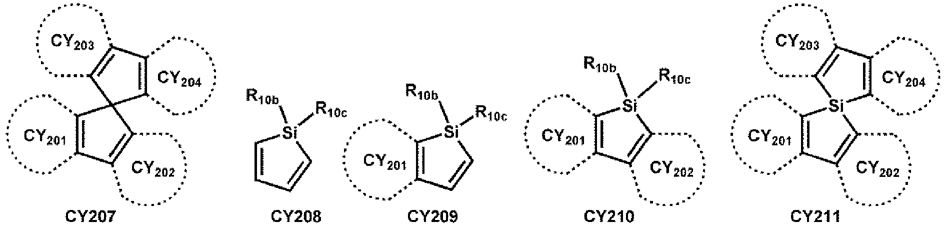

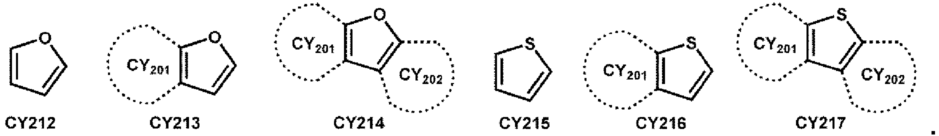

R_{10b} and R_{10c} in Formulae CY201 to CY217 may each independently be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one of the groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, R₂₀₁ may be a group represented by one of Formulae CY201 to CY203, xa2 may be 0, and R₂₀₂ may be a group represented by one of Formulae CY204 to CY207.

In one or more embodiments, each of Formulae 201 and 202 may not include (e.g., may exclude) a group represented by one of Formulae CY201 to CY203.

In one or more embodiments, each of Formulae 201 and 202 may not include (e.g., may exclude) a group represented by one of Formulae CY201 to CY203, and may include at least one of the groups represented by Formulae CY204 to CY217.

In one or more embodiments, each of Formulae 201 and 202 may not include (e.g., may exclude) a group represented by one of Formulae CY201 to CY217.

In an embodiment, the hole transport region may include at keast one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or one or more combinations thereof:

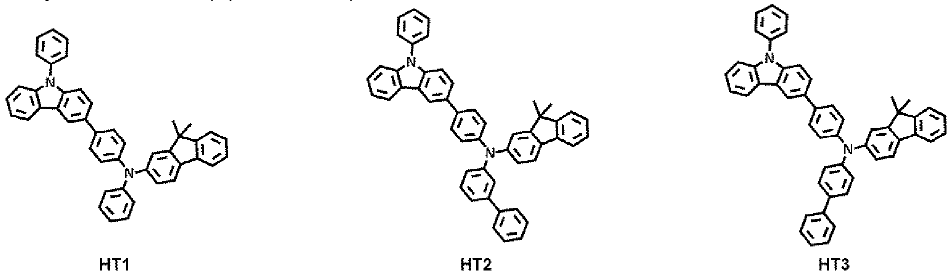

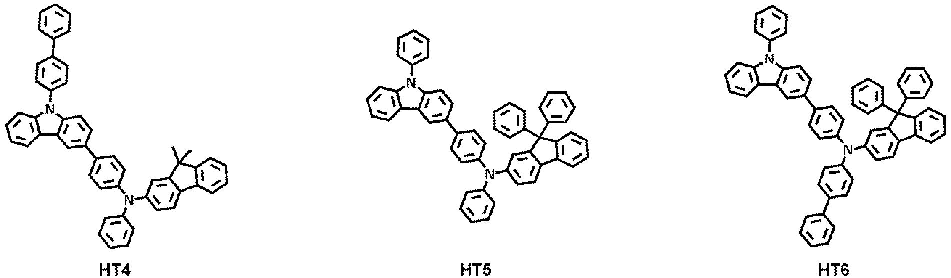

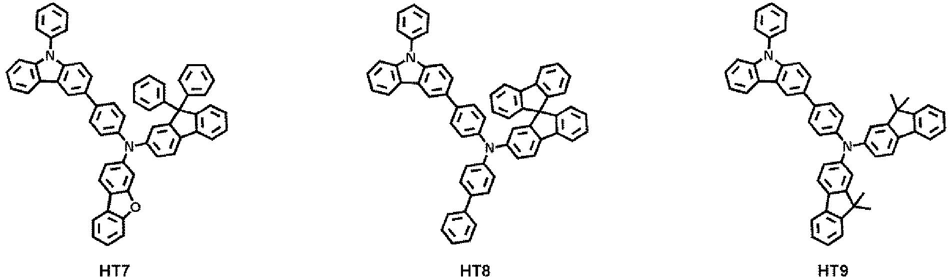

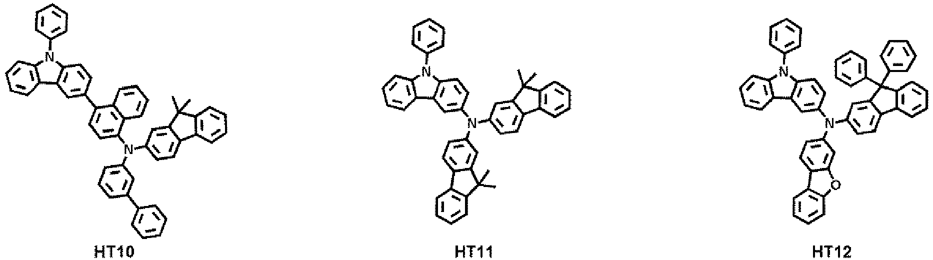

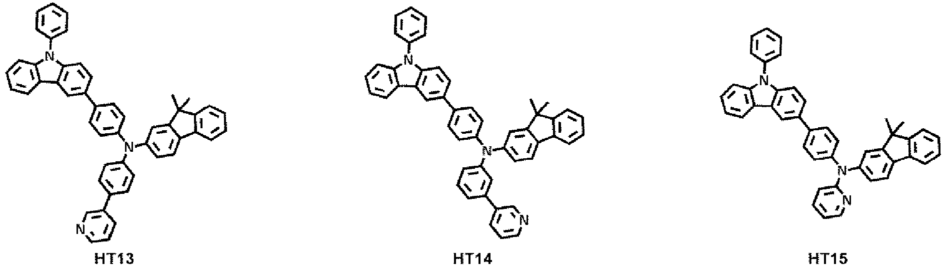

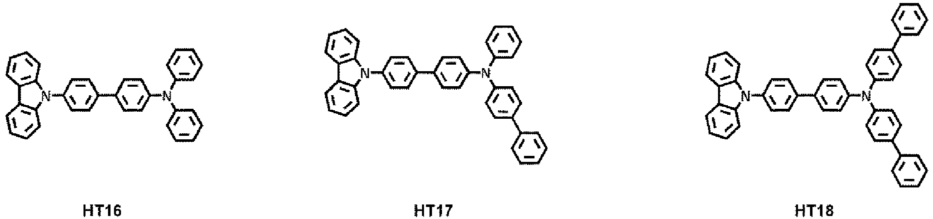

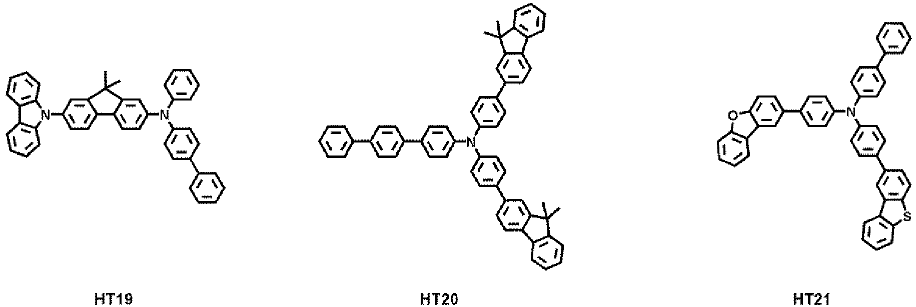

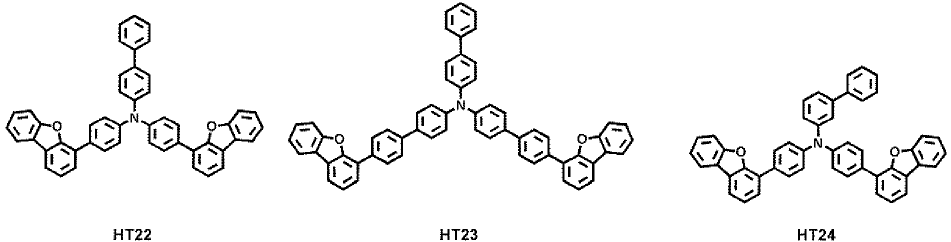

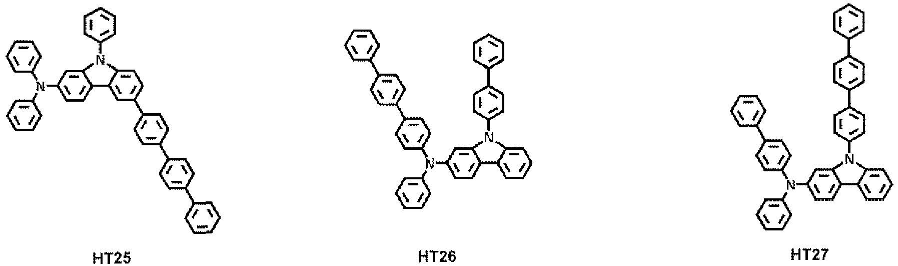

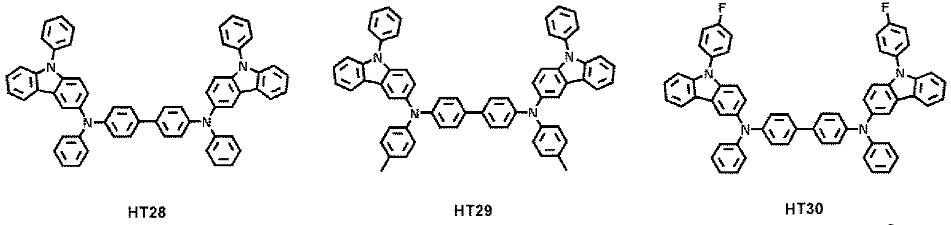

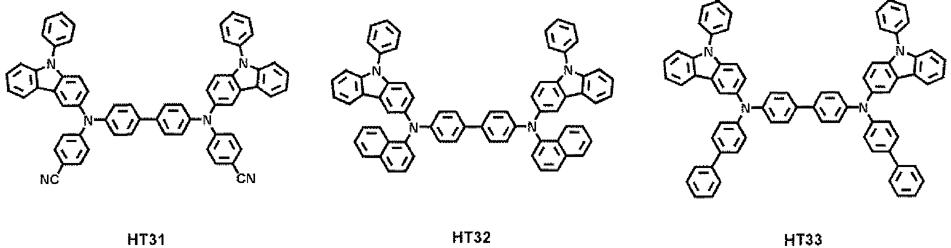

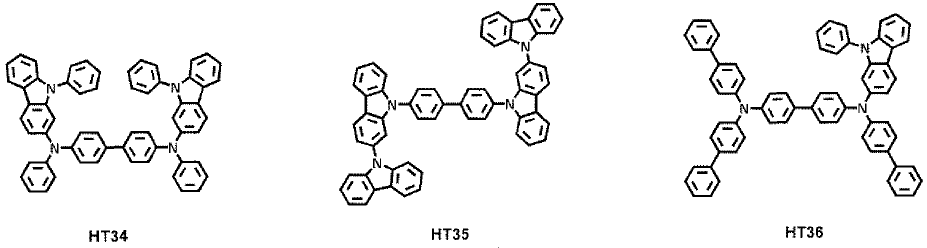

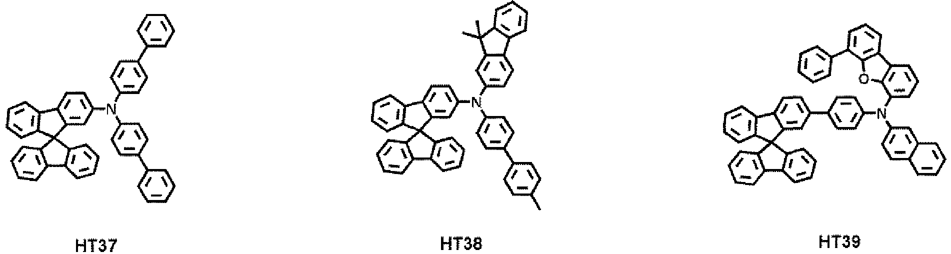

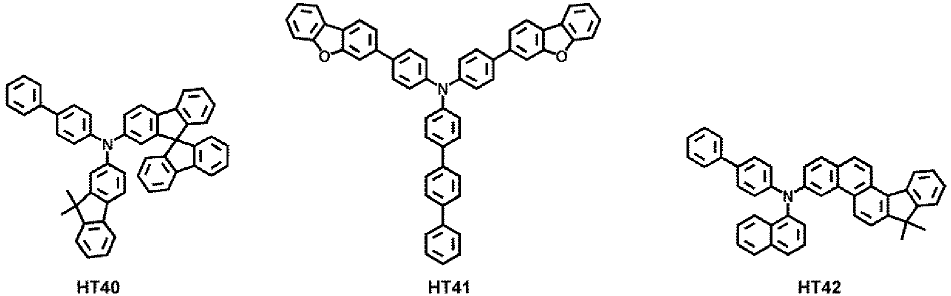

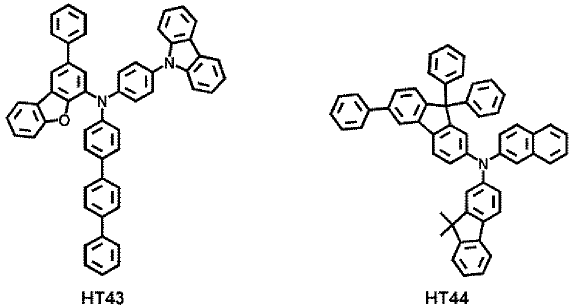

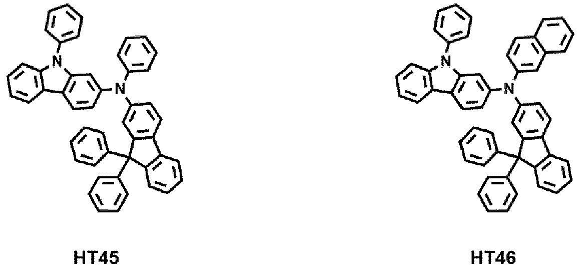

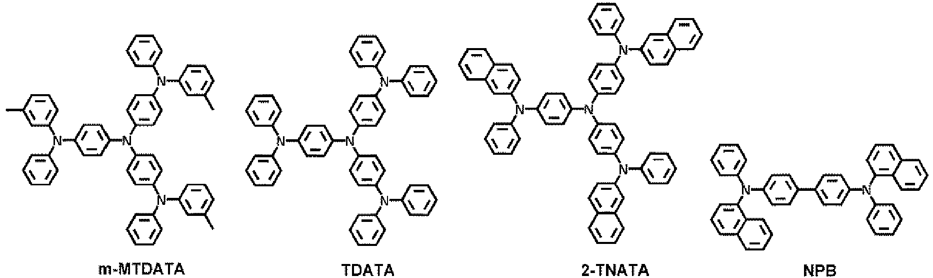

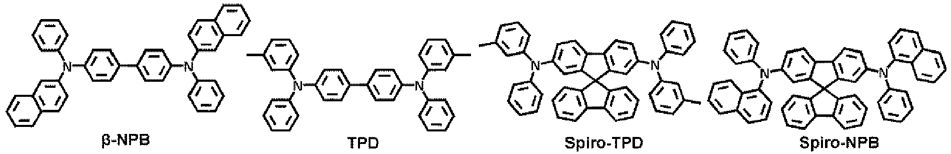

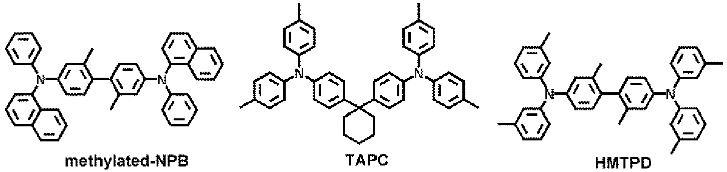

A thickness of the hole transport region may be in a range of about 50 Å to about 10,000 Å, for example, about 100 Å to about 4,000 Å. When the hole transport region includes a hole injection layer, a hole transport layer, or a combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory (suitable) hole transporting characteristics may be obtained without a substantial increase in driving voltage.

The emission auxiliary layer may increase light-emission efficiency by compensating for an optical resonance distance according to the wavelength of light emitted by an emission layer, and the electron-blocking layer may block or reduce the leakage of electrons from an emission layer to a hole transport region. Materials that may be included in the hole transport region may also be included in the emission auxiliary layer and/or the electron-blocking layer.

### p-dopant

The hole transport region may further include, in addition to these materials, a charge-generation material for the improvement of conductive properties. The charge-generation material may be substantially uniformly or non-uniformly dispersed in the hole transport region (for example, in the form of a single layer including (e.g., consisting of) a charge-generation material).

The charge-generation material may be, for example, a p-dopant.

For example, the lowest unoccupied molecular orbital (LUMO) energy level of the p-dopant may be -3.5 eV or less.

In one or more embodiments, the p-dopant may include a quinone derivative, a cyano group-containing compound, a compound including element EL1 and element EL2, or one or more combinations thereof.

Examples of the quinone derivative are TCNQ, F4-TCNQ, etc.

Examples of the cyano group-containing compound are HAT-CN, and a compound represented by Formula 221.

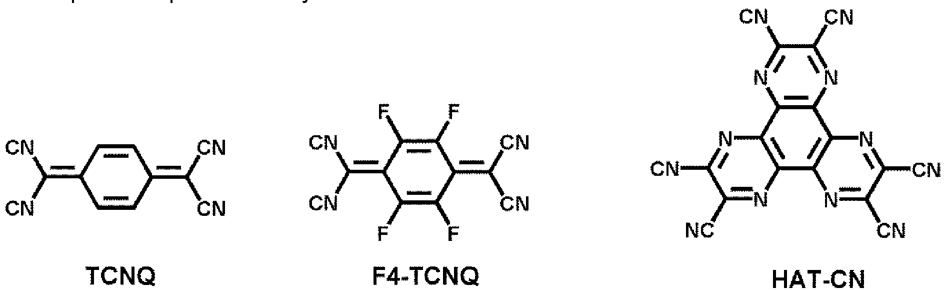

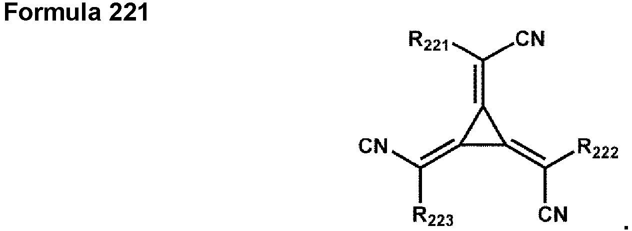

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with a cyano group; -F; -Cl; - Br; -I; a C₁-C₂₀ alkyl group substituted with a cyano group, -F, -Cl, -Br, -I, or one or more combinations thereof.

In the compound including element EL1 and element EL2, element EL1 may be metal, metalloid, or one or more combinations thereof, and element EL2 may be non-metal, metalloid, or a combination thereof.

Examples of the metal are an alkali metal (for example, lithium (Li), sodium (Na), potassium (K), rubidium (Rb), cesium (Cs), etc.); alkaline earth metal (for example, beryllium (Be), magnesium (Mg), calcium (Ca), strontium (Sr), barium (Ba), etc.); transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); post-transition metal (for example, zinc (Zn), indium (In), tin (Sn), etc.); and/or lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of the metalloid are silicon (Si), antimony (Sb), and/or tellurium (Te).

Examples of the non-metal are oxygen (O) and/or halogen (for example, F, Cl, Br, I, etc.).

Examples of the compound including element EL1 and element EL2 are metal oxide, metal halide (for example, metal fluoride, metal chloride, metal bromide, and/or metal iodide), metalloid halide (for example, metalloid fluoride, metalloid chloride, metalloid bromide, and/or metalloid iodide), metal telluride, or one or more combinations thereof.

Examples of the metal oxide are tungsten oxide (for example, WO, W₂O₃, WO₂, WO₃, W₂O₅, etc.), vanadium oxide (for example, VO, V₂O₃, VO₂, V₂O₅, etc.), molybdenum oxide (MoO, Mo₂O₃, MoO₂, MoO₃, Mo₂O₅, etc.), and/or rhenium oxide (for example, ReO₃, etc.).

Examples of the metal halide are alkali metal halide, alkaline earth metal halide, transition metal halide, post-transition metal halide, and/or lanthanide metal halide.

Examples of the alkali metal halide are LiF, NaF, KF, RbF, CsF, LiCl, NaCl, KCI, RbCl, CsCl, LiBr, NaBr, KBr, RbBr, CsBr, Lil, Nal, KI, Rbl, and/or CsI.

Examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and/or BaI₂.

Examples of the transition metal halide are titanium halide (for example, TiF₄, TiCl₄, TiBr₄, Til₄, etc.), zirconium halide (for example, ZrF₄, ZrCl₄, ZrBr₄, Zrl₄, etc.), hafnium halide (for example, HfF₄, HfCl₄, HfBr₄, Hfl₄, etc.), vanadium halide (for example, VF₃, VCl₃, VBr₃, VI₃, etc.), niobium halide (for example, NbF₃, NbCl₃, NbBr₃, NbI₃, etc.), tantalum halide (for example, TaF₃, TaCl₃, TaBr₃, TaI₃, etc.), chromium halide (for example, CrF₃, CrCl₃, CrBr₃, CrI₃, etc.), molybdenum halide (for example, MoF₃, MoCl₃, MoBr₃, MoI₃, etc.), tungsten halide (for example, WF₃, WCl₃, WBr₃, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, CoI₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCl, CuBr, Cul, etc.), silver halide (for example, AgF, AgCl, AgBr, AgI, etc.), and/or gold halide (for example, AuF, AuCl, AuBr, Aul, etc.).

Examples of the post-transition metal halide are zinc halide (for example, ZnF₂, ZnCl₂, ZnBr₂, ZnI₂, etc.), indium halide (for example, InI₃, etc.), and/or tin halide (for example, SnI₂, etc.).

Examples of the lanthanide metal halide are YbF, YbF₂, YbF₃, SmF₃, YbCl, YbCl₂, YbCl₃ SmCl₃, YbBr, YbBr₂, YbBr₃, SmBr₃, Ybl, YbI₂, YbI₃, SmI₃, and/or the like.

An example of the metalloid halide is antimony halide (for example, SbCls, etc.).

Examples of the metal telluride are alkali metal telluride (for example, Li₂Te, Na₂Te, K₂Te, Rb₂Te, Cs₂Te, etc.), alkaline earth metal telluride (for example, BeTe, MgTe, CaTe, SrTe, BaTe, etc.), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (for example, ZnTe, etc.), and/or lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers selected from a red emission layer, a green emission layer, and a blue emission layer, in which the two or more layers contact each other or are separated from each other to emit white light. In one or more embodiments, the emission layer may include two or more materials selected from a red light-emitting material, a green light-emitting material, and a blue light-emitting material, in which the two or more materials are mixed with each other in a single layer to emit white light.

In an embodiment, the emission layer may further include a host, an auxiliary dopant, a sensitizer, delayed fluorescence material, or one or more combinations thereof, in addition to the first emitter as described in the present disclosure.

When the emission layer further includes a host in addition to the first emitter, the amount of the first emitter is from about 0.01 to about 15 parts by weight based on 100 parts by weight of the host.

A thickness of the emission layer may be in a range of about 100 Å to about 1,000 Å, for example, about 200 Å to about 600 Å. When the thickness of the emission layer is within these ranges, excellent or suitable light-emission characteristics may be obtained without a substantial increase in driving voltage. **Host**

The host in the emission layer may include an electron-transporting compound described herein (for example, refer to the compounds represented by Formula 2-1 or 2-2), a hole-transporting compound described herein (for example, refer to a compound represented by one of Formulae 3-1 to 3-5), or a combination thereof.

In one or more embodiments, the host may include an alkali earth metal complex, a post-transition metal complex, or a combination thereof. For example, the host may include a Be complex (for example, Compound H55), an Mg complex, a Zn complex, or one or more combinations thereof.

In one or more embodiments, the host may include at least one of Compounds H1 to H130, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or one or more combinations thereof:

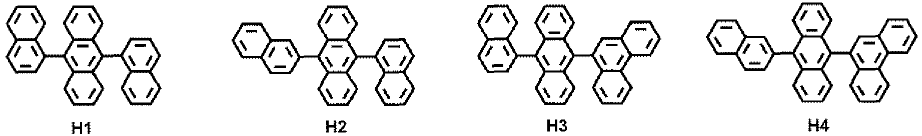

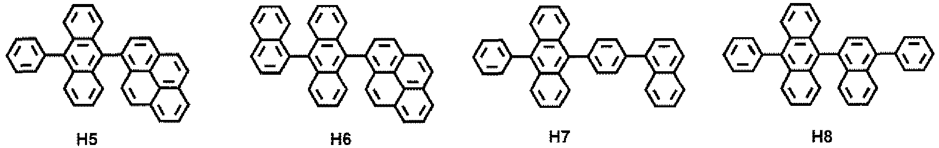

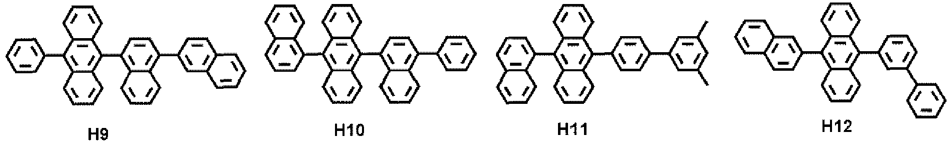

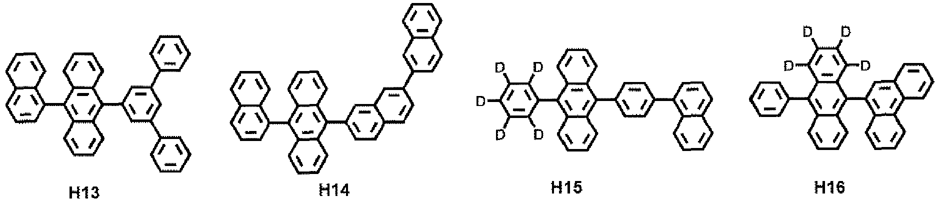

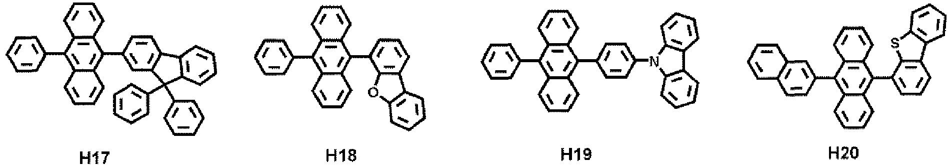

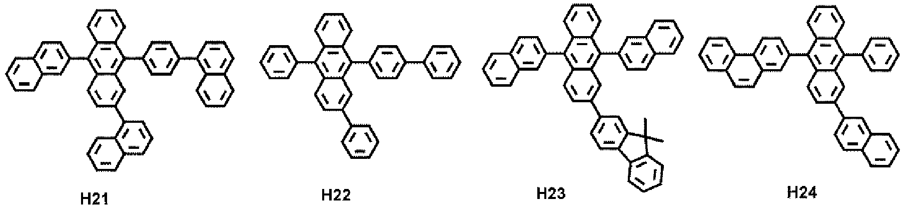

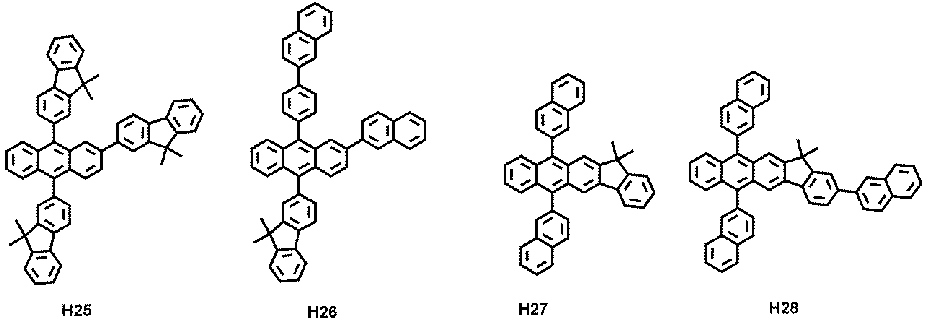

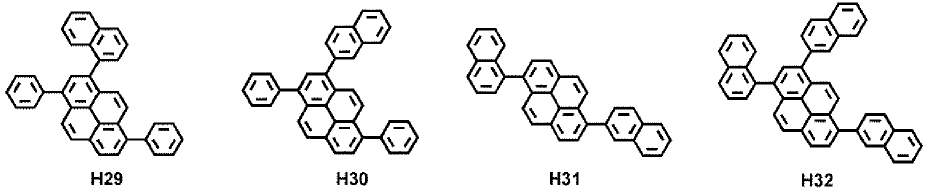

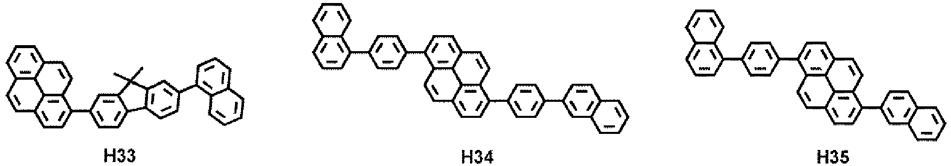

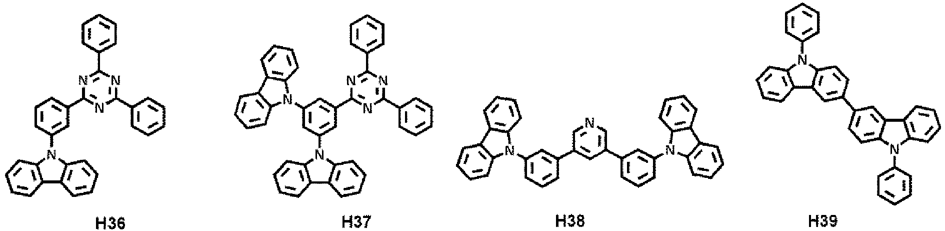

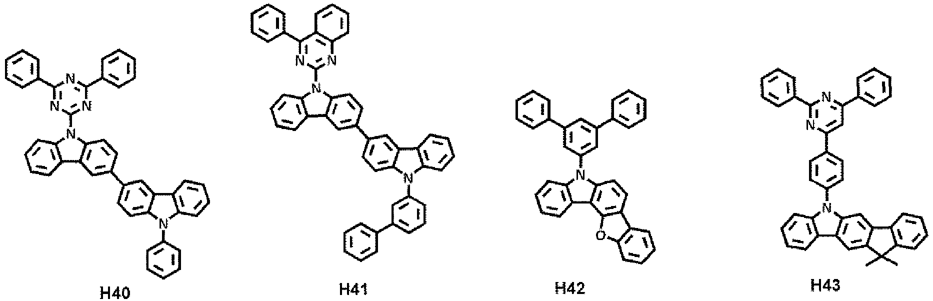

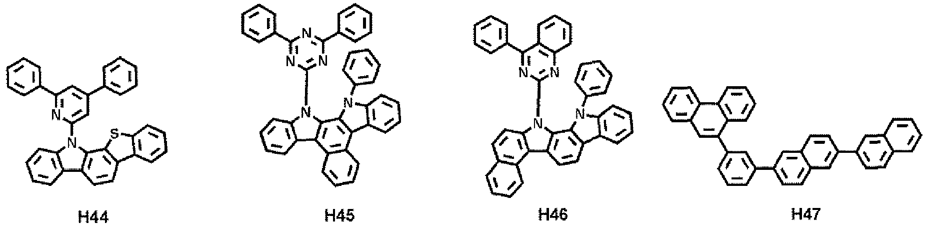

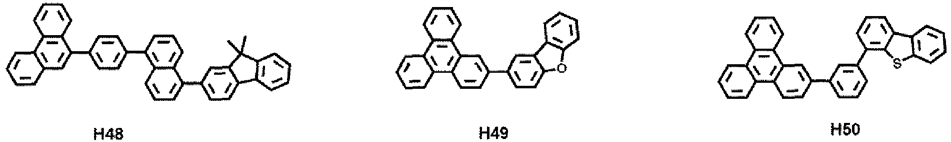

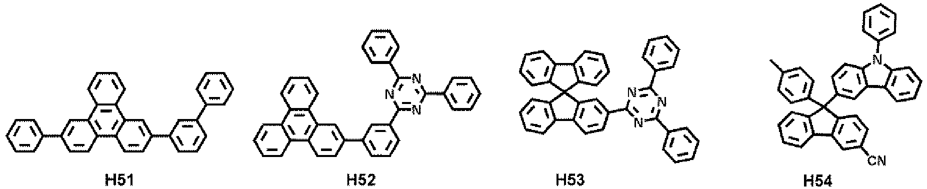

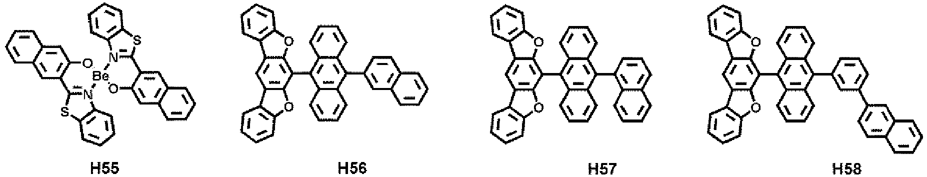

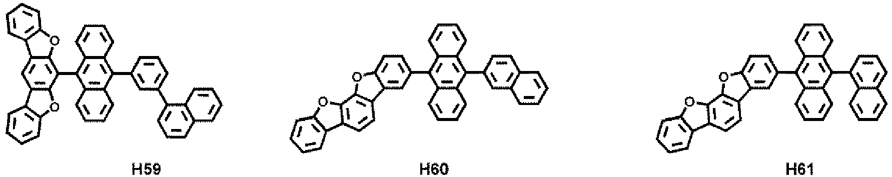

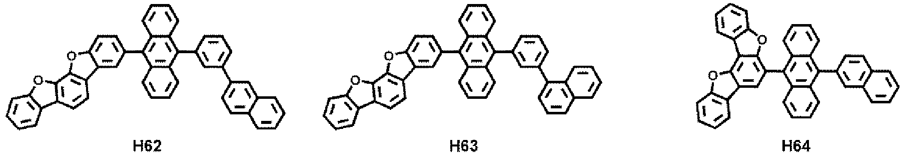

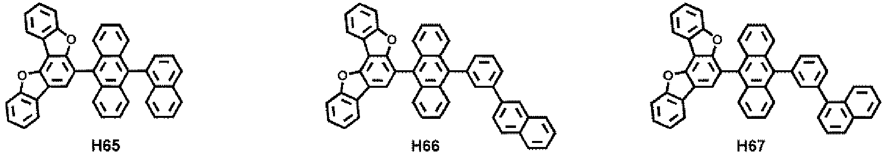

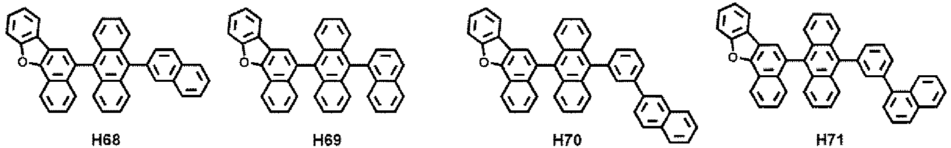

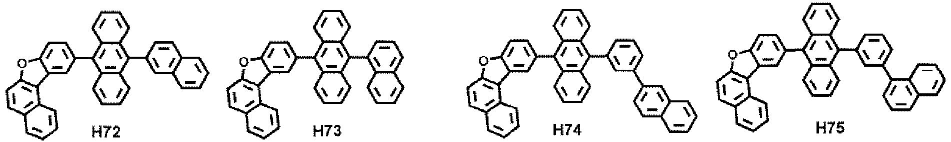

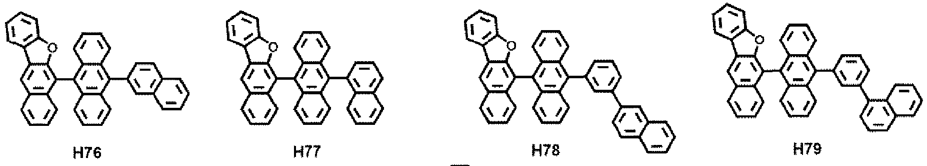

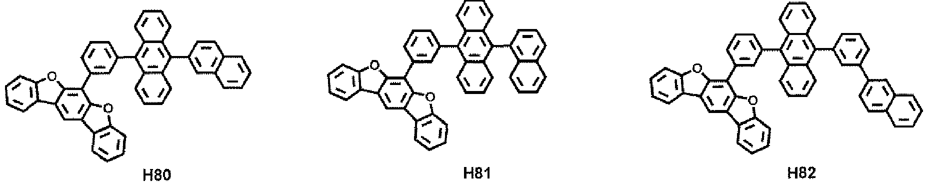

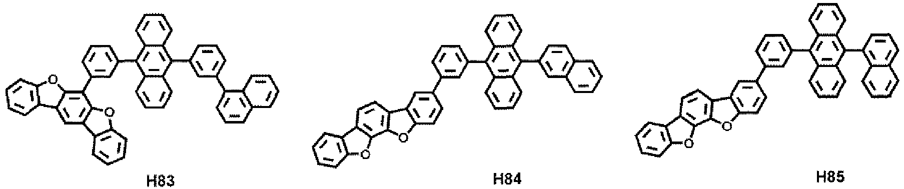

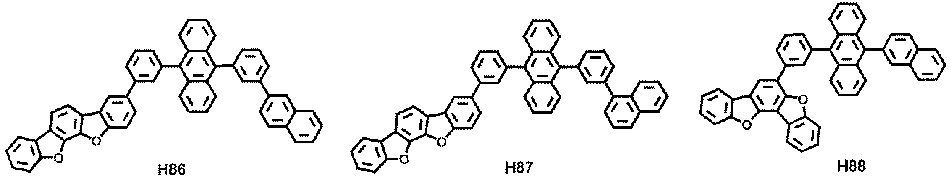

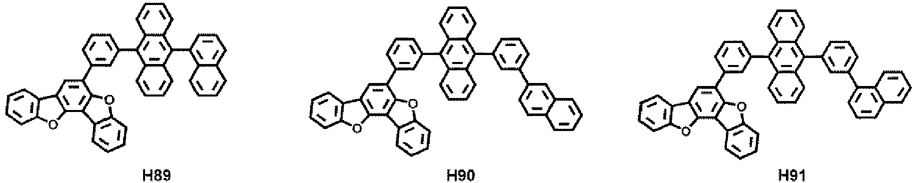

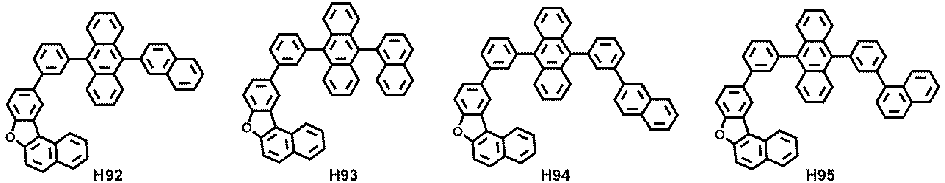

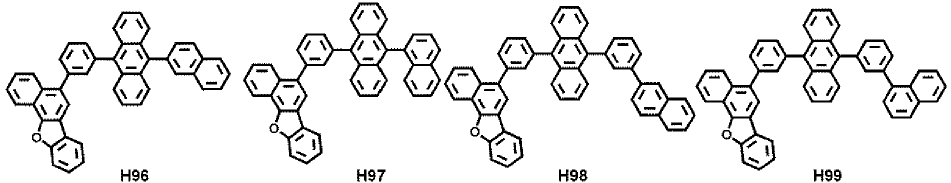

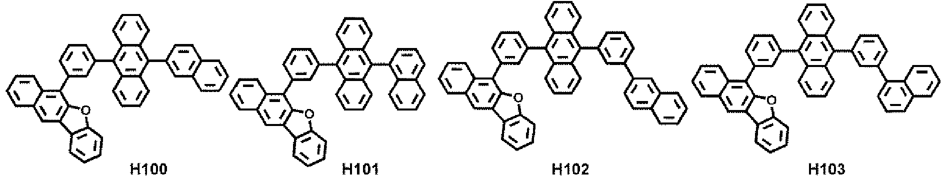

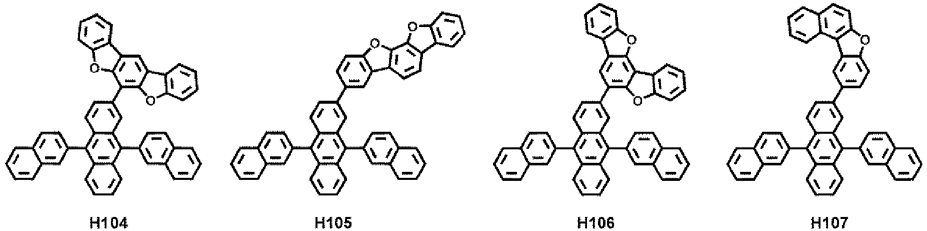

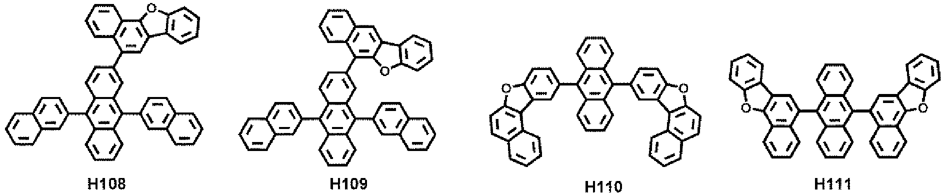

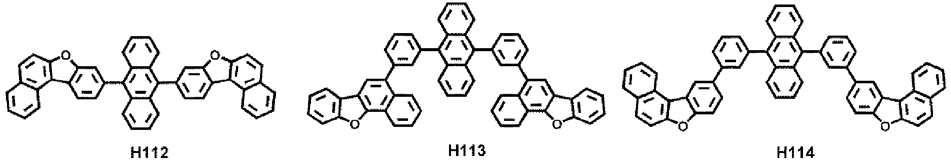

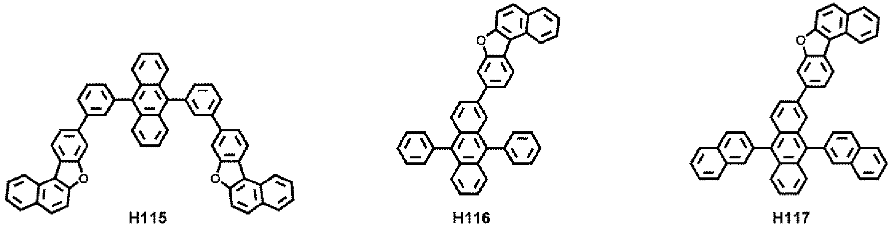

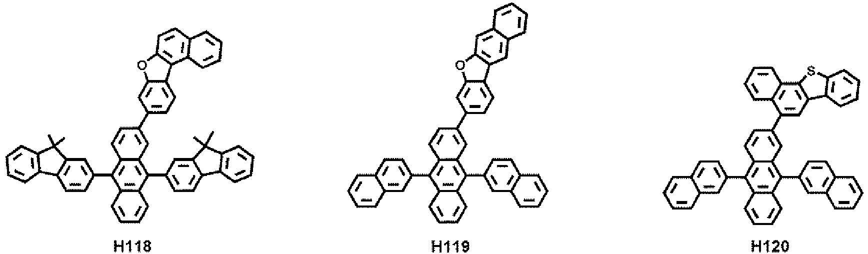

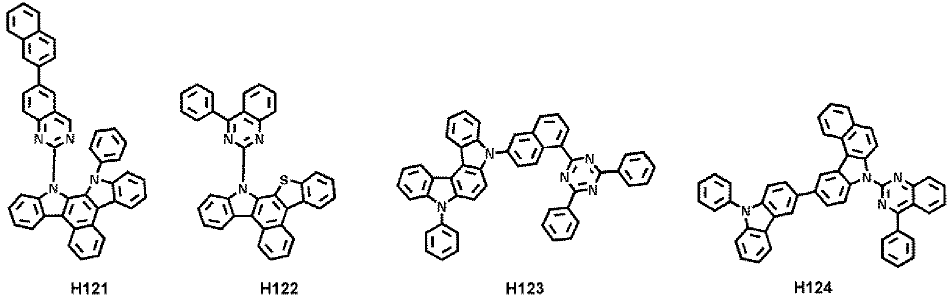

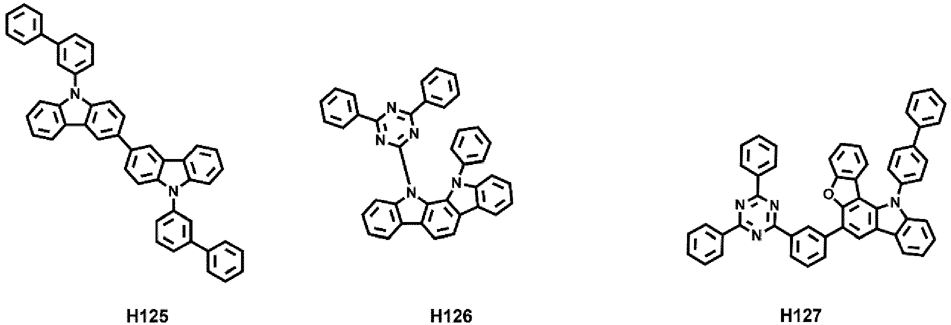

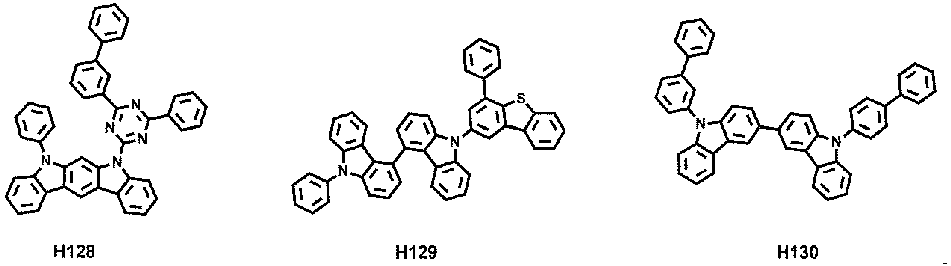

In an embodiment, the host may include a silicon-containing compound, a phosphine oxide-containing compound, or a combination thereof.

The host may have one or more suitable modifications. For example, the host may include only one kind of compound, or may include two or more kinds of different compounds.

### Phosphorescent dopant

The emission layer includes, as a phosphorescent dopant, the first emitter as described herein.

In an embodiment, the emission layer may further include, in addition to the first emitter as described in the present disclosure, an organometallic compound represented by Formula 401:

**Formula 401** **M(L₄₀₁)_{xc1}(L₄₀₂)_{xc2}**

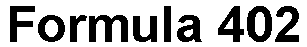

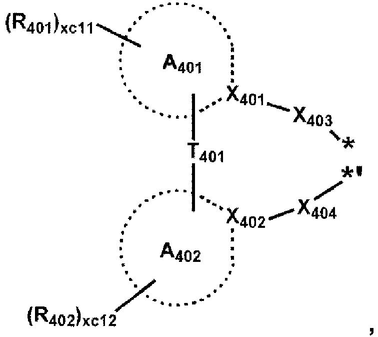

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein when xc1 is two or more, two or more of L₄₀₁(s) may be identical to or different from each other,
L₄₀₂ may be an organic ligand, and xc2 may be 0, 1, 2, 3, or 4, and when xc2 is 2 or more, two or more of L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C(Q₄₁₁)=*',
X₄₀₃ and X₄₀₄ may each independently be a chemical bond (for example, a covalent bond or a coordination bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each be the same as described herein with respect to Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), - B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ may each be the same as described herein with respect to Q₁,
xc11 and xc12 may each independently be an integer from 0 to 10, and
* and *' in Formula 402 each indicate a binding site to M in Formula 401.

For example, in Formula 402, i) X₄₀₁ may be nitrogen, and X₄₀₂ may be carbon, or ii) each of X₄₀₁ and X₄₀₂ may be nitrogen.

In one or more embodiments, when xc1 in Formula 402 is 2 or more, two ring A₄₀₁(s) in two or more of L₄₀₁(s) may be optionally linked to each other via T₄₀₂, which is a linking group, or two ring A₄₀₂(s) may be optionally linked to each other via T₄₀₃, which is a linking group (see Compounds PD1 to PD4 and PD7). T₄₀₂ and T₄₀₃ may each be the same as described herein with respect to T₄₀₁.

L₄₀₂ in Formula 401 may be an organic ligand. For example, L₄₀₂ may include a halogen group, a diketone group (for example, an acetylacetonate group), a carboxylic acid group (for example, a picolinate group), -C(=O), an isonitrile group, - CN group, a phosphorus group (for example, a phosphine group, a phosphite group, etc.), or one or more combinations thereof.

### Fluorescent dopant

The emission layer may further include a fluorescent dopant in addition to the first emitter as described in the present disclosure.

The fluorescent dopant may include an arylamine compound, a styrylamine compound, a boron-containing compound, or one or more combinations thereof.

For example, the fluorescent dopant may include a compound represented by Formula 501: 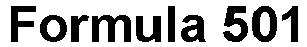 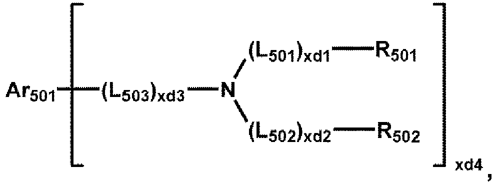
wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, Ar₅₀₁ in Formula 501 may be a condensed cyclic group (for example, an anthracene group, a chrysene group, or a pyrene group) in which three or more monocyclic groups are condensed together.

In one or more embodiments, xd4 in Formula 501 may be 2.

For example, the fluorescent dopant may include: at least one of Compounds FD1 to FD36; DPVBi; DPAVBi; or one or more combinations thereof:

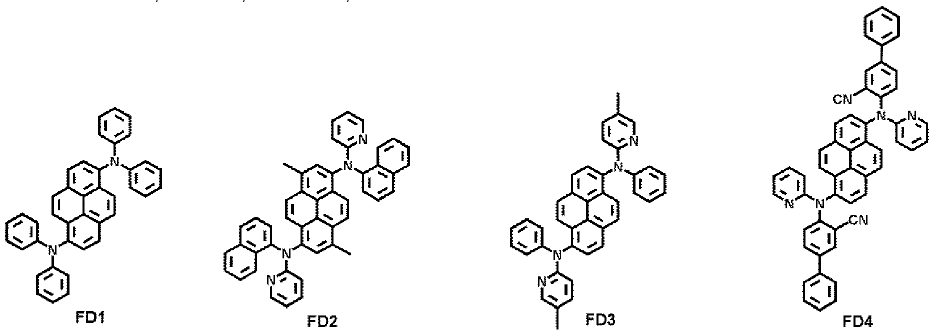

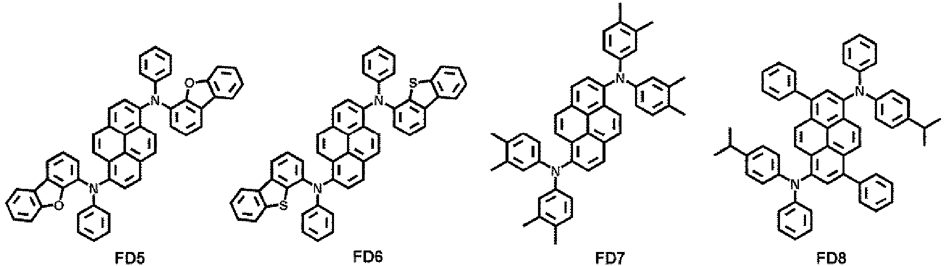

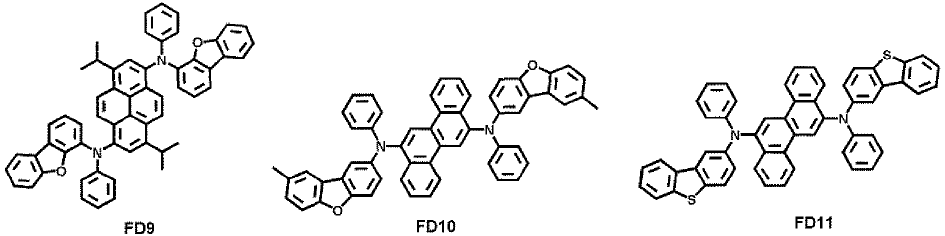

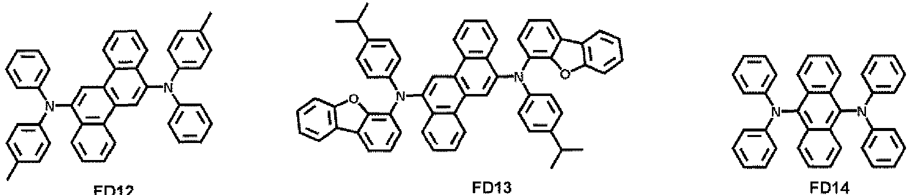

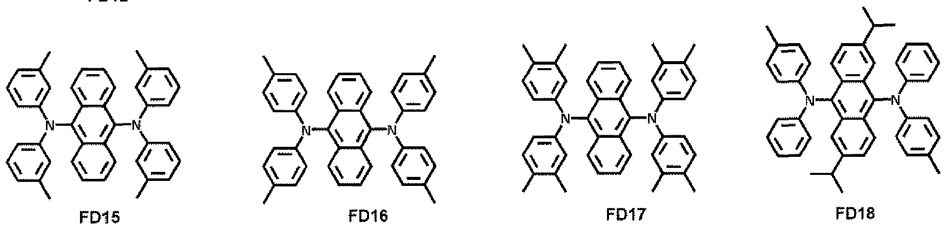

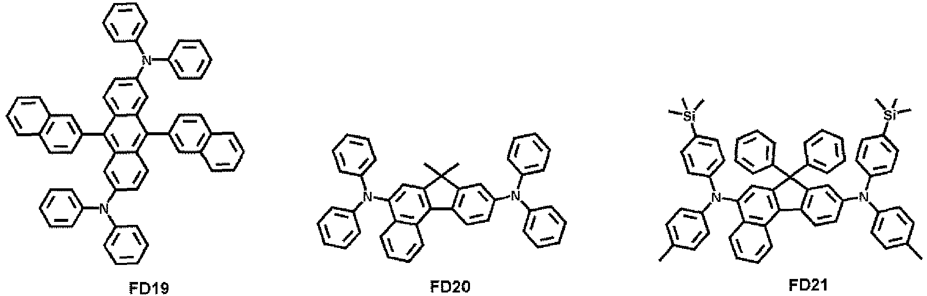

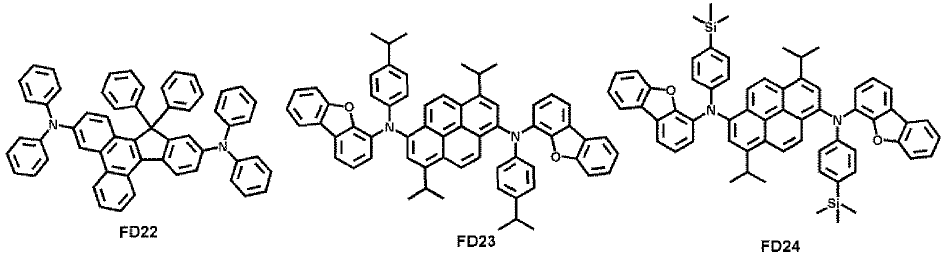

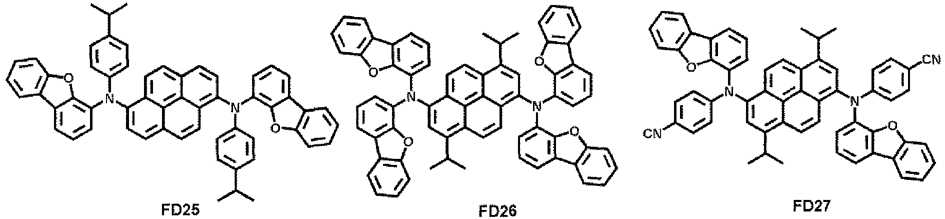

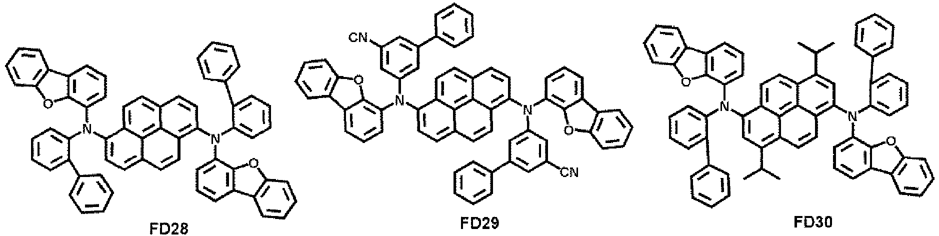

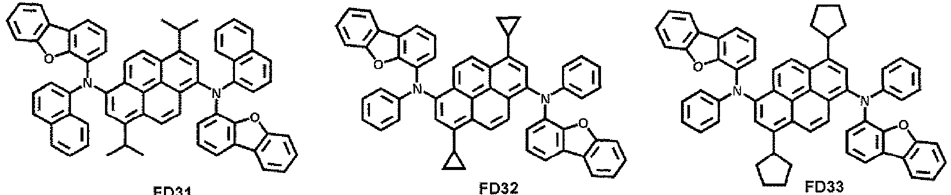

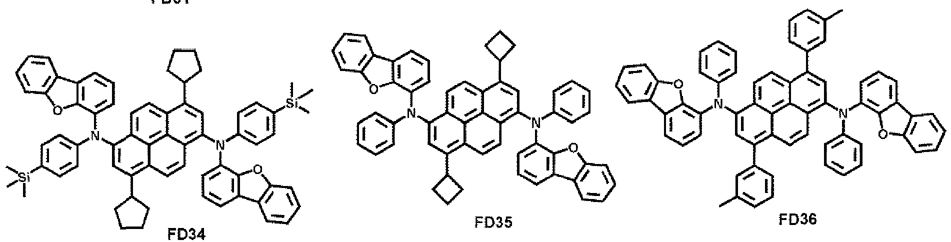

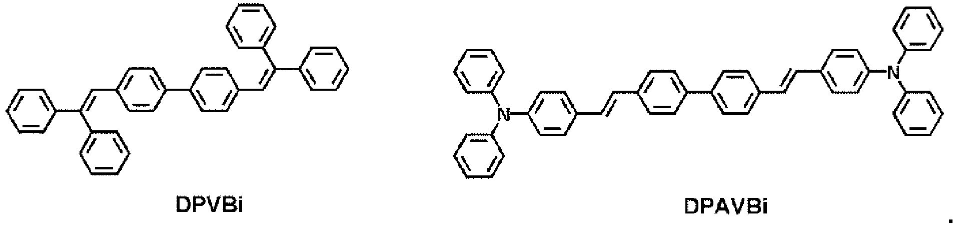

### Delayed fluorescence material

The emission layer may further include a delayed fluorescence material.

In the present disclosure, the delayed fluorescence material may be selected from compounds capable of emitting delayed fluorescent light based on a delayed fluorescence emission mechanism.

The delayed fluorescence material included in the emission layer may act as a host or a dopant depending on the type or kind of other materials included in the emission layer.

In one or more embodiments, the difference between the triplet energy level (eV) of the delayed fluorescence material and the singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material satisfies the above-described range, up-conversion from the triplet state to the singlet state of the delayed fluorescence materials may effectively occur, and thus, the luminescence efficiency of the light-emitting device 10 may be improved (increased).

For example, the delayed fluorescence material may include i) a material including at least one electron donor (for example, a π electron-rich C₃-C₆₀ cyclic group, such as a carbazole group) and at least one electron acceptor (for example, a sulfoxide group, a cyano group, or a π electron-deficient nitrogen-containing C₁-C₆₀ cyclic group), and ii) a material including a C₈-C₆₀ polycyclic group in which two or more cyclic groups are condensed while sharing boron (B).

Examples of the delayed fluorescence material may include at least one of the following compounds DF1 to DF9:

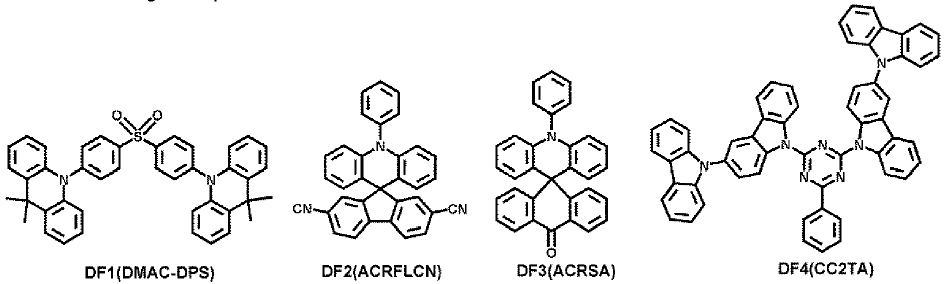

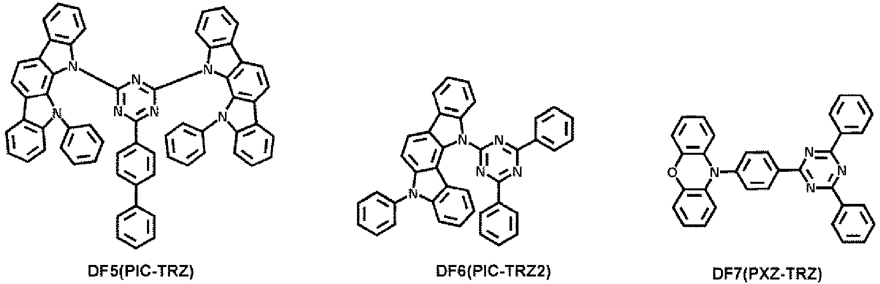

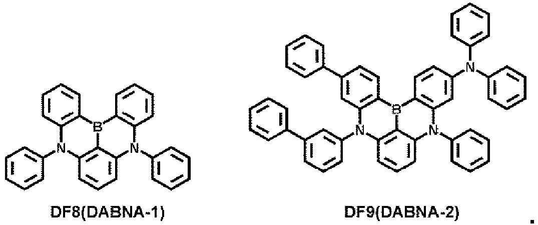

### Electron transport region in interlayer 130

The electron transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron transport region may include a buffer layer, a hole-blocking layer, an electron control layer, an electron transport layer, an electron injection layer, or one or more combinations thereof.

For example, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, the constituting layers of each structure being sequentially stacked from an emission layer.

In an embodiment, the electron transport region (for example, the buffer layer, the hole-blocking layer, the electron control layer, or the electron transport layer in the electron transport region) may include a metal-free compound including at least one π electron-deficient nitrogen-containing C₁-C₆₀ cyclic group.

For example, the electron transport region may include a compound represented by Formula 601:

**Formula 601** **[Ar₆₀₁]ₓₑ₁₁-[(L₆₀₁)ₓₑ₁-R₆₀₁]ₓₑ₂₁**

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described herein with respect to Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group unsubstituted or substituted with at least one R₁₀ₐ.

For example, when xe11 in Formula 601 is 2 or more, two or more of Ar₆₀₁(s) may be linked to each other via a single bond.

In other embodiments, Ar₆₀₁ in Formula 601 may be a substituted or unsubstituted anthracene group.

In other embodiments, the electron transport region may include a compound represented by Formula 601-1: 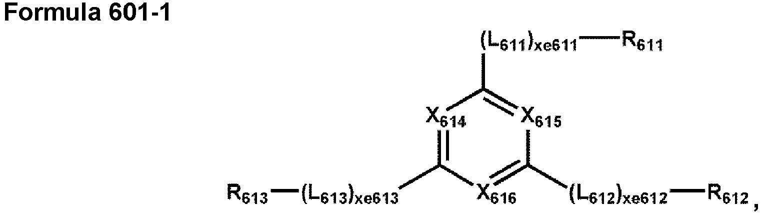
wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each be the same as described herein with respect to L₆₀₁,
xe611 to xe613 may each be the same as described herein with respect to xe1,
R₆₁₁ to R₆₁₃ may each be the same as described herein with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

The electron transport region may include at least one of Compounds ET1 to ET46, 2,9-dimethyl-4,7-diphenyl-1,10-phenanthroline (BCP), 4,7-diphenyl-1,10-phenanthroline (Bphen), Alq3, BAlq, TAZ, NTAZ, or one or more combinations thereof:

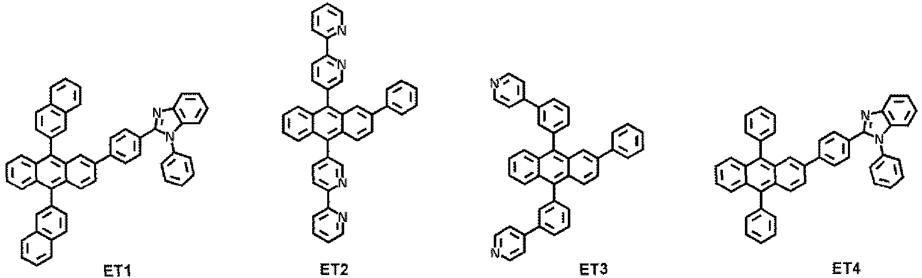

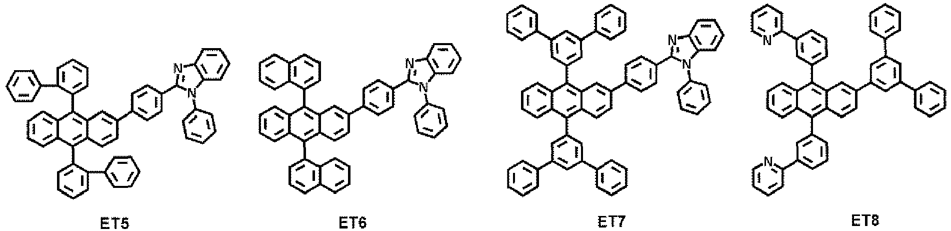

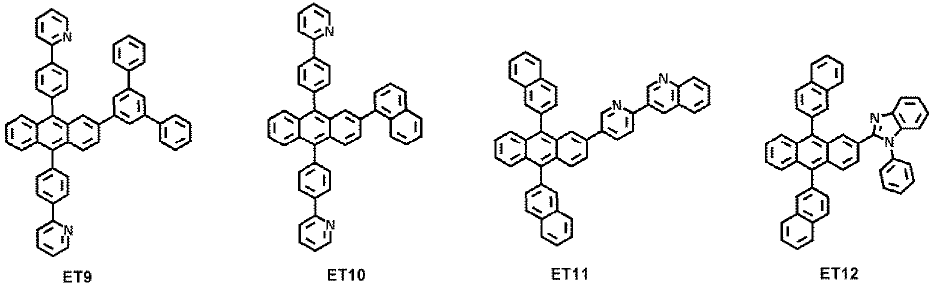

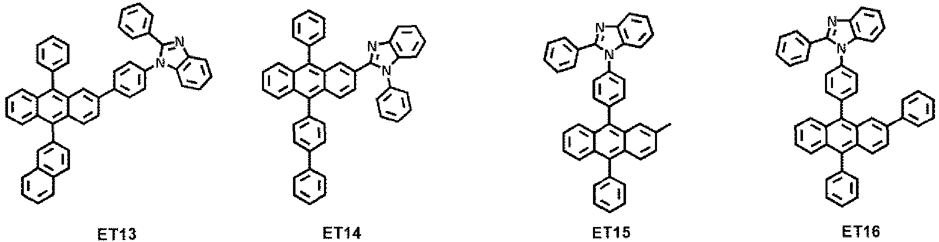

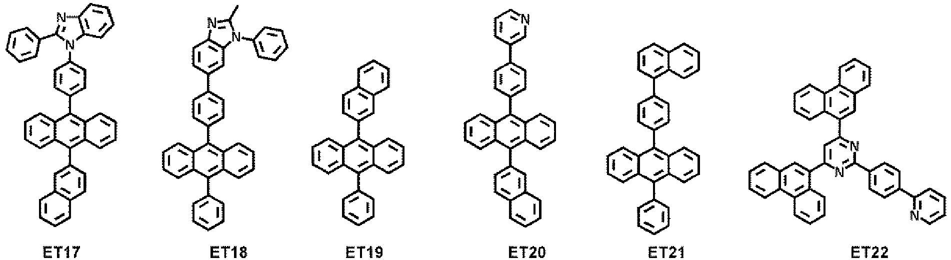

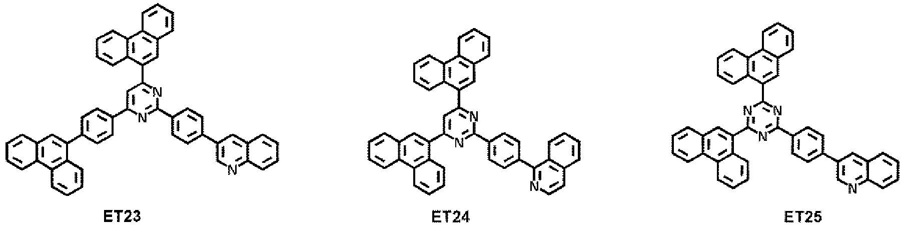

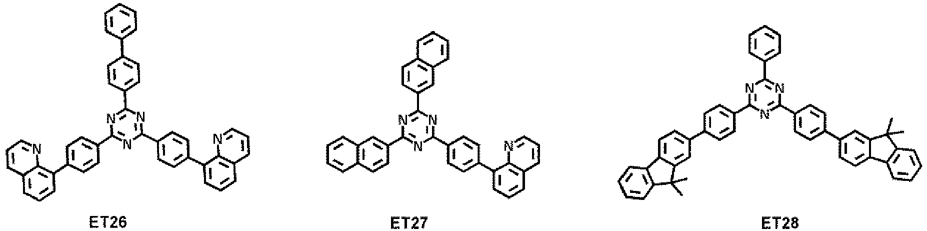

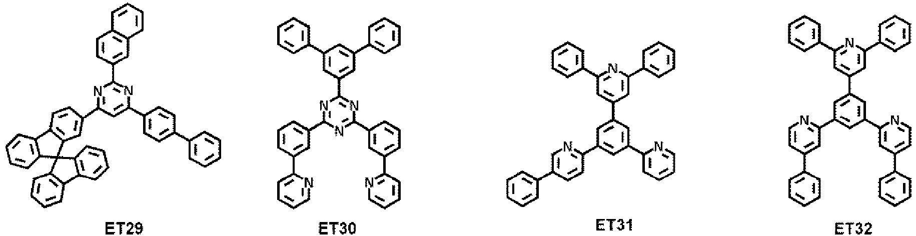

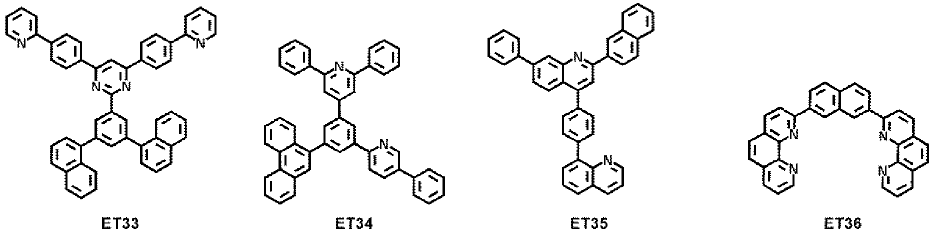

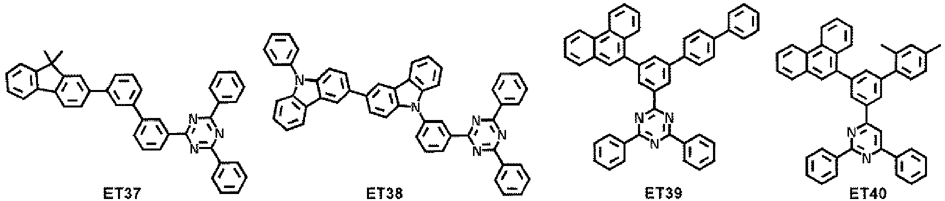

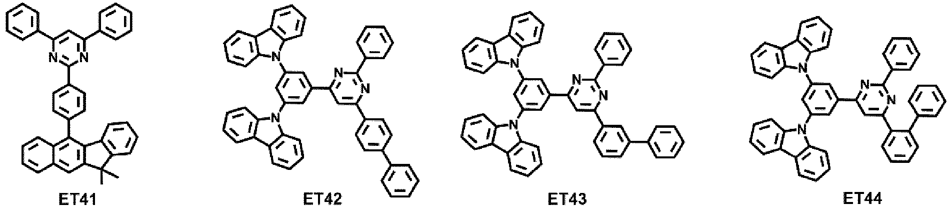

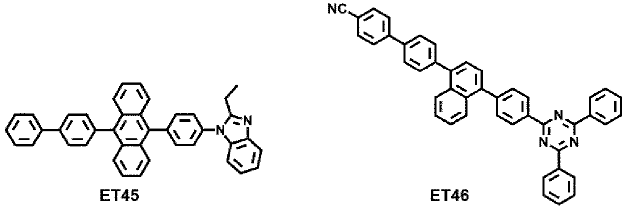

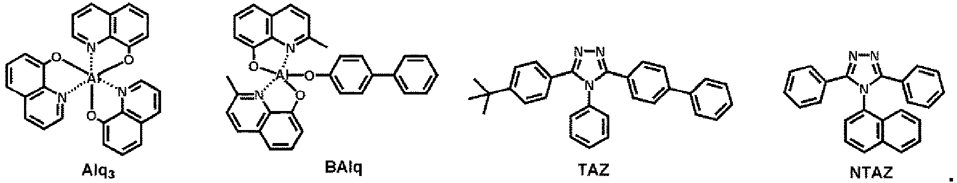

A thickness of the electron transport region may be from about 100 Å to about 5,000 Å, for example, about 160 Å to about 4,000 Å. When the electron transport region includes a buffer layer, a hole-blocking layer, an electron control layer, an electron transport layer, or one or more combinations thereof, the thickness of the buffer layer, the hole-blocking layer, or the electron control layer may each independently be from about 20 Å to about 1000 Å, for example, about 30 Å to about 300 Å, and the thickness of the electron transport layer may be from about 100 Å to about 1000 Å, for example, about 150 Å to about 500 Å. When the thickness of the buffer layer, the hole-blocking layer, the electron control layer, the electron transport layer, and/or the electron transport layer are within these ranges, satisfactory (suitable) electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or a combination thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or one or more combinations thereof.

For example, the metal-containing material may include a Li complex. The Li complex may include, for example, Compound ET-D1 (LiQ) or ET-D2:

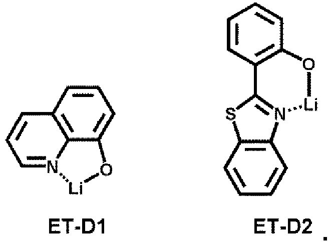

The electron transport region may include an electron injection layer that facilitates the injection of electrons from the second electrode 150. The electron injection layer may directly contact the second electrode 150.

The electron injection layer may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron injection layer may include an alkali metal, alkaline earth metal, a rare earth metal, an alkali metal-containing compound, alkaline earth metal-containing compound, a rare earth metal-containing compound, an alkali metal complex, an alkaline earth metal complex, a rare earth metal complex, or one or more combinations thereof.

The alkali metal may include Li, Na, K, Rb, Cs, or one or more combinations thereof. The alkaline earth metal may include Mg, Ca, Sr, Ba, or one or more combinations thereof. The rare earth metal may include Sc, Y, Ce, Tb, Yb, Gd, or one or more combinations thereof.

The alkali metal-containing compound, the alkaline earth metal-containing compound, and/or the rare earth metal-containing compound may be oxide(s), halide(s) (for example, fluoride(s), chloride(s), bromide(s_, and/or iodide(s)), and/or telluride(s) of the alkali metal, the alkaline earth metal, and/or the rare earth metal, or one or more combinations thereof.

The alkali metal-containing compound may include one or more: alkali metal oxides, such as Li₂O, Cs₂O, or K₂O; and/or alkali metal halides, such as LiF, NaF, CsF, KF, Lil, Nal, CsI, KI, Rbl; or one or more combinations thereof. The alkaline earth metal-containing compound may include an alkaline earth metal compound, such as BaO, SrO, CaO, BaₓSr₁₋ₓO (wherein x is a real number satisfying the condition of 0<x<1), BaₓCa₁₋ₓO (wherein x is a real number satisfying the condition of 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or one or more combinations thereof. In one or more embodiments, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and/or Lu₂Te₃.

The alkali metal complex, the alkaline earth-metal complex, and the rare earth metal complex may include i) one of metal ions of the alkali metal, the alkaline earth metal, and the rare earth metal and ii) as a ligand linked to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or one or more combinations thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or one or more combinations thereof, as described above. In one or more embodiments, the electron injection layer may further include an organic material (for example, a compound represented by Formula 601).

In one or more embodiments, the electron injection layer may include (e.g., consist of): i) an alkali metal-containing compound (for example, an alkali metal halide); or ii) a) an alkali metal-containing compound (for example, an alkali metal halide), and b) an alkali metal, an alkaline earth metal, a rare earth metal, or one or more combinations thereof. For example, the electron injection layer may be a KI:Yb co-deposited layer, an RbI:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or one or more combinations thereof may be substantially uniformly or non-uniformly dispersed in a matrix including the organic material.

A thickness of the electron injection layer may be in a range of about 1 Å to about 100 Å, and, for example, about 3 Å to about 90 Å. When the thickness of the electron injection layer is within the ranges described above, satisfactory (suitable) electron injection characteristics may be obtained without a substantial increase in driving voltage.

### Second electrode 150

The second electrode 150 may be on the interlayer 130 having a structure as described above. The second electrode 150 may be a cathode, which is an electron injection electrode, and as the material for the second electrode 150, a metal, an alloy, an electrically conductive compound, or one or more combinations thereof, each having a low-work function, may be utilized.

The second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or one or more combinations thereof. The second electrode 150 may be a transmissive electrode, a semi-transmissive electrode, or a reflective electrode.

The second electrode 150 may have a single-layered structure or a multi-layered structure including a plurality of layers.

### Second capping layer 170

The second capping layer 170 contains an amine-containing compound as described in the present disclosure. The amine-containing compound is the same as described in the present disclosure.

### Electronic apparatus

The light-emitting device may be included in one or more suitable electronic apparatuses. For example, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be in at least one traveling direction of light emitted from the light-emitting device. For example, the light emitted from the light-emitting device may be blue light, green light, or white light. For details on the light-emitting device, related description provided above may be referred to. In one or more embodiments, the color conversion layer may include a quantum dot.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be among the subpixel areas to define each of the subpixel areas.

The color filter may further include a plurality of color filter areas and light-shielding patterns located among the color filter areas, and the color conversion layer may further include a plurality of color conversion areas and light-shielding patterns located among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. For example, the first area may include a red quantum dot, the second area may include a green quantum dot, and the third area may not include (e.g., may exclude) a quantum dot. For more details on the quantum dot, related descriptions provided herein may be referred to. The first area, the second area, and/or the third area may each include a scatterer.

For example, the light-emitting device may emit first light, the first area may absorb the first light to emit first-first color light, the second area may absorb the first light to emit second-first color light, and the third area may absorb the first light to emit third-first color light. In this regard, the first-first color light, the second-first color light, and the third-first color light may have different maximum emission wavelengths. For example, the first light may be blue light, the first-first color light may be red light, the second-first color light may be green light, and the third-first color light may be blue light.

The electronic apparatus may further include a thin-film transistor, in addition to the light-emitting device as described above. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion may be between the color filter and/or the color conversion layer and the light-emitting device. The sealing portion allows light from the light-emitting device to be extracted to the outside, and concurrently (e.g., simultaneously) prevents (reduces) ambient air and moisture from penetrating into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin film encapsulation layer, the electronic apparatus may be flexible.

Various suitable functional layers may be additionally located on the sealing portion, in addition to the color filter and/or the color conversion layer, according to the use of the electronic apparatus. Examples of the functional layers may include a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (for example, fingertips, pupils, etc.).

The authentication apparatus may further include, in addition to the light-emitting device as described above, a biometric information collector.

The electronic apparatus may be applied to one or more suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and/or a vessel), projectors, and/or the like.

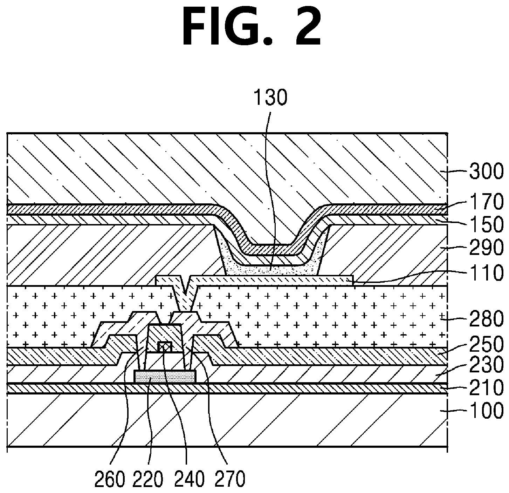

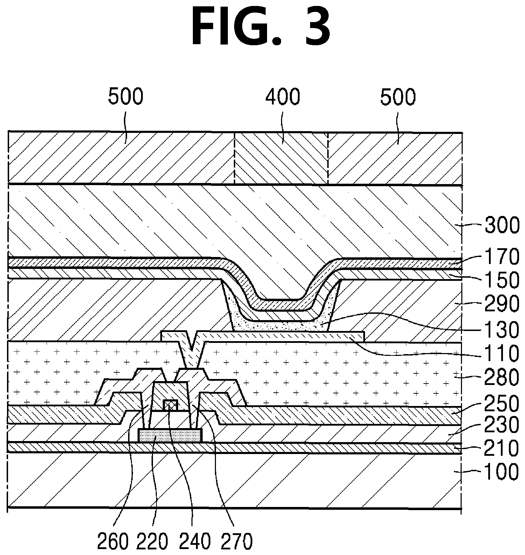

### Description of FIGs. 2 and 3

FIG. 2 is a cross-sectional view showing a light-emitting apparatus according to an embodiment of the present disclosure.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be located on the substrate 100. The buffer layer 210 may prevent or reduce penetration of impurities through the substrate 100 and may provide a substantially flat surface on the substrate 100.

A TFT may be located on the buffer layer 210. The TFT may include an activation layer 220, a gate electrode 240, a source electrode 260, and a drain electrode 270.

The activation layer 220 may include an inorganic semiconductor such as silicon and/or polysilicon, an organic semiconductor, or an oxide semiconductor, and may include a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be located on the gate electrode 240. The interlayer insulating film 250 may be located between the gate electrode 240 and the source electrode 260 and between the gate electrode 240 and the drain electrode 270, to insulate (separate) the gate electrode from the source electrode and/or the gate electrode from the drain electrode.

The source electrode 260 and the drain electrode 270 may be on the interlayer insulating film 250. The interlayer insulating film 250 and the gate insulating film 230 may be formed so as to expose the source region and the drain region of the activation layer 220, and the source electrode 260 and the drain electrode 270 may be in contact with the exposed portions of the source region and the drain region of the activation layer 220.

The TFT is electrically connected to a light-emitting device to drive the light-emitting device, and is covered and protected by a passivation layer 280. The passivation layer 280 may include an inorganic insulating film, an organic insulating film, or a combination thereof. A light-emitting device is provided on the passivation layer 280. The light-emitting device may include a first electrode 110, an interlayer 130, and a second electrode 150.

The first electrode 110 may be on the passivation layer 280. The passivation layer 280 may be located (formed) so as to expose a portion of the drain electrode 270, not fully covering the drain electrode 270, and the first electrode 110 may be connected to the exposed portion of the drain electrode 270.

A pixel defining layer 290 including an insulating material may be on the first electrode 110. The pixel defining layer 290 may expose a certain region of the first electrode 110, and an interlayer 130 may be formed in the exposed region of the first electrode 110. The pixel defining layer 290 may be a polyimide and/or polyacrylic organic film. At least some layers of the interlayer 130 may extend beyond the upper portion of the pixel defining layer 290 to be located in the form of a common layer (i.e., may be provided as a common layer).

A second electrode 150 may be on the interlayer 130, and a second capping layer 170 may be additionally formed on the second electrode 150. The second capping layer 170 may be formed so as to cover the second electrode 150.

The encapsulation portion 300 may be on the second capping layer 170. The encapsulation portion 300 may be on a light-emitting device to protect the light-emitting device from moisture or oxygen. The encapsulation portion 300 may include: an inorganic film including silicon nitride (SiNx), silicon oxide (SiOx), indium tin oxide, indium zinc oxide, or one or more combinations thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or one or more combinations thereof; or one or more combinations of the inorganic films and the organic films.

FIG. 3 shows a cross-sectional view showing a light-emitting apparatus according to an embodiment of the present disclosure.

The light-emitting apparatus of FIG. 3 is substantially the same as the light-emitting apparatus of FIG. 2, except that a light-shielding pattern 500 and a functional region 400 are additionally located on the encapsulation portion 300. The functional region 400 may be i) a color filter area, ii) a color conversion area, or iii) a combination of the color filter area and the color conversion area. In an embodiment, the light-emitting device included in the light-emitting apparatus of FIG. 3 may be a tandem light-emitting device.

### Manufacturing method

The layers included in the hole transport region, the emission layer, and the layers included in the electron transport region may be formed in a certain region by utilizing one or more suitable methods such as vacuum deposition, spin coating, casting, Langmuir-Blodgett (LB) deposition, ink-jet printing, laser-printing, laser-induced thermal imaging, and/or the like.

When layers constituting the hole transport region, an emission layer, and layers constituting the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### Definition of Terms

The term "C₃-C₆₀ carbocyclic group" as utilized herein refers to a cyclic group including (e.g., consisting of) carbon only as a ring-forming atom and having three to sixty carbon atoms, and the term "C₁-C₆₀ heterocyclic group" as utilized herein refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group including (e.g., consisting of) one ring or a polycyclic group in which two or more rings are condensed with each other. For example, the C₁-C₆₀ heterocyclic group has 3 to 61 ring-forming atoms.

The "cyclic group" as utilized herein may include the C₃-C₆₀ carbocyclic group, and the C₁-C₆₀ heterocyclic group.

The term "π electron-rich C₃-C₆₀ cyclic group" as utilized herein refers to a cyclic group that has three to sixty carbon atoms and does not include *-N=*' as a ring-forming moiety, and the term "π electron-deficient nitrogen-containing C₁-C₆₀ cyclic group" as utilized herein refers to a heterocyclic group that has one to sixty carbon atoms and includes *-N=*' as a ring-forming moiety.

For example,
the C₃-C₆₀ carbocyclic group may be i) group T1 or ii) a condensed cyclic group in which two or more groups T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) group T2, ii) a condensed cyclic group in which two or more groups T2 are condensed with each other, or iii) a condensed cyclic group in which at least one group T2 and at least one group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) group T1, ii) a condensed cyclic group in which two or more groups T1 are condensed with each other, iii) group T3, iv) a condensed cyclic group in which two or more groups T3 are condensed with each other, or v) a condensed cyclic group in which at least one group T3 and at least one group T1 are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ cyclic group may be i) group T4, ii) a condensed cyclic group in which two or more groups T4 are condensed with each other, iii) a condensed cyclic group in which at least one group T4 and at least one group T1 are condensed with each other, iv) a condensed cyclic group in which at least one group T4 and at least one group T3 are condensed with each other, or v) a condensed cyclic group in which at least one group T4, at least one group T1, and at least one group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
the group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a petrahydropyrazine group, a dihydropyrazine group, a tetrahydropyridazine group, or a dihydropyridazine group,
group T3 may be a furan group, a thiophene group, a 1H-pyrrole group, a silole group, or a borole group, and
group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₃-C₆₀ carbocyclic group, the C₁-C₆₀ heterocyclic group, the π electron-rich C₃-C₆₀ cyclic group, or the π electron-deficient nitrogen-containing C₁-C₆₀ cyclic group" as utilized herein refer to a group condensed to any cyclic group, a monovalent group, or a polyvalent group (for example, a divalent group, a trivalent group, a tetravalent group, etc.) according to the structure of a formula for which the corresponding term is utilized. For example, the "benzene group" may be a benzo group, a phenyl group, a phenylene group, and/or the like, which may be understood by one of ordinary skill in the art according to the structure of a formula including the "benzene group."

Examples of the monovalent C₃-C₆₀ carbocyclic group and the monovalent C₁-C₆₀ heterocyclic group are a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the monovalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as utilized herein refers to a linear or branched aliphatic hydrocarbon monovalent group that has one to sixty carbon atoms, and specific examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as utilized herein refers to a divalent group having the same structure as the C₁-C₆₀ alkyl group.

The term "C₂-C₆₀ alkenyl group" as utilized herein refers to a monovalent hydrocarbon group having at least one carbon-carbon double bond in the middle or at the terminus of the C₂-C₆₀ alkyl group, and examples thereof are an ethenyl group, a propenyl group, and a butenyl group. The term "C₂-C₆₀ alkenylene group" as utilized herein refers to a divalent group having the same structure as the C₂-C₆₀ alkenyl group.

The term "C₂-C₆₀ alkynyl group" as utilized herein refers to a monovalent hydrocarbon group having at least one carbon-carbon triple bond in the middle or at the terminus of the C₂-C₆₀ alkyl group, and examples thereof include an ethynyl group and a propynyl group. The term "C₂-C₆₀ alkynylene group" as utilized herein refers to a divalent group having the same structure as the C₂-C₆₀ alkynyl group.

The term "C₁-C₆₀ alkoxy group" as utilized herein refers to a monovalent group represented by -OA₁₀₁ (wherein A₁₀₁ is the C₁-C₆₀ alkyl group), and examples thereof include a methoxy group, an ethoxy group, and an isopropyloxy group.

The term "C₃-C₁₀ cycloalkyl group" as utilized herein refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group" as utilized herein refers to a divalent group having the same structure as the C₃-C₁₀ cycloalkyl group.

The term "C₁-C₁₀ heterocycloalkyl group" as utilized herein refers to a monovalent cyclic group of 1 to 10 carbon atoms, further including, in addition to carbon atoms, at least one heteroatom, as ring-forming atoms, and specific examples are a 1,2,3,4-oxatriazolidinyl group, a tetrahydrofuranyl group, and a tetrahydrothiophenyl group. The term "C₁-C₁₀ heterocycloalkylene group" as utilized herein refers to a divalent group having the same structure as the C₁-C₁₀ heterocycloalkyl group.

The term C₃-C₁₀ cycloalkenyl group utilized herein refers to a monovalent cyclic group that has three to ten carbon atoms and at least one carbon-carbon double bond in the ring thereof and no aromaticity, and specific examples thereof are a cyclopentenyl group, a cyclohexenyl group, and a cycloheptenyl group. The term "C₃-C₁₀ cycloalkenylene group" as utilized herein refers to a divalent group having the same structure as the C₃-C₁₀ cycloalkenyl group.

The term "C₁-C₁₀ heterocycloalkenyl group" as utilized herein refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as utilized herein refers to a divalent group having the same structure as the C₁-C₁₀ heterocycloalkenyl group.

The term "C₆-C₆₀ aryl group" as utilized herein refers to a monovalent group having a carbocyclic aromatic system of 6 to 60 carbon atoms, and the term "C₆-C₆₀ arylene group" as utilized herein refers to a divalent group having a carbocyclic aromatic system of 6 to 60 carbon atoms. Examples of the C₆-C₆₀ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the rings may be condensed with each other.

The term "C₁-C₆₀ heteroaryl group" as utilized herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as utilized herein refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed with each other.

The term "monovalent non-aromatic condensed polycyclic group" as utilized herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group are an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as utilized herein refers to a divalent group having the same structure as the monovalent non-aromatic condensed polycyclic group described above.

The term "monovalent non-aromatic condensed heteropolycyclic group" as utilized herein refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure. Examples of the monovalent non-aromatic condensed heteropolycyclic group are a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphtho silolyl group, a benzofurodibenzofuranyl group, a benzofurodibenzothiophenyl group, and a benzothienodibenzothiophenyl group. The term "divalent non-aromatic condensed heteropolycyclic group" as utilized herein refers to a divalent group having the same structure as the monovalent non-aromatic condensed heteropolycyclic group described above.

The term "C₆-C₆₀ aryloxy group" as utilized herein indicates -OA₁₀₂ (wherein A₁₀₂ is the C₆-C₆₀ aryl group), and the term "C₆-C₆₀ arylthio group" as utilized herein indicates -SA₁₀₃ (wherein A₁₀₃ is the C₆-C₆₀ aryl group).

The term "C₇-C₆₀ aryl alkyl group" utilized herein refers to -A₁₀₄A₁₀₅ (where A₁₀₄ may be a C₁-C₅₄ alkylene group, and A₁₀₅ may be a C₆-C₅₉ aryl group), and the term C₂-C₆₀ heteroaryl alkyl group" utilized herein refers to -A₁₀₆A₁₀₇ (where A₁₀₆ may be a C₁-C₅₉ alkylene group, and A₁₀₇ may be a C₁-C₅₉ heteroaryl group).

The term "R₁₀ₐ" as utilized herein refers to:
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or one or more combinations thereof,
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), or one or more combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q3₂).

Q₁ to Q₃, Q₁₁ to Q₁₃, Q₂₁ to Q₂₃, and Q₃₁ to Q₃₃ in the present disclosure may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or one or more combinations thereof.

The term "heteroatom" as utilized herein refers to any atom other than a carbon atom. Examples of the heteroatom are O, S, N, P, Si, B, Ge, Se, and one or more combinations thereof.

The term "third-row transition metal" utilized herein includes hafnium (Hf), tantalum (Ta), tungsten (W), rhenium (Re), osmium (Os), iridium (Ir), platinum (Pt), gold (Au), and/or the like.

"Ph" as utilized herein refers to a phenyl group, "Me" as utilized herein refers to a methyl group, "Et" as utilized herein refers to an ethyl group, "ter-Bu" or "Bu^{t}" as utilized herein refers to a tert-butyl group, and "OMe" as utilized herein refers to a methoxy group.

The term "biphenyl group" as utilized herein refers to "a phenyl group substituted with a phenyl group." For example, the "biphenyl group" is a substituted phenyl group having a C₆-C₆₀ aryl group as a substituent.

The term "terphenyl group" as utilized herein refers to "a phenyl group substituted with a biphenyl group". For example, the "terphenyl group" is a substituted phenyl group having, as a substituent, a C₆-C₆₀ aryl group substituted with a C₆-C₆₀ aryl group.

* and *' as utilized herein, unless defined otherwise, each refer to a binding site to a neighboring atom in a corresponding formula or moiety.

Hereinafter, a light-emitting device according to examples will be described in more detail with reference to Examples.

### Examples

### Evaluation Example 1

According to the method in Table 1, the HOMO energy level, LUMO energy level, band gap and triplet (T₁) energy of each of Compounds GD-1, GD-2, GD-3, GD-4, GD-5, GD-6, A01, and A04 were evaluated. The results are shown in Table 2.

**Table 1**

| | |
|---|---|
| HOMO energy level evaluation method | By utilizing cyclic voltammetry (CV) (electrolyte: 0.1 M Bu₄NPF₆ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and then, from the oxidation onset of the graph, the HOMO energy level of each compound was calculated. |
| LUMO energy level evaluation method | By utilizing cyclic voltammetry (CV) (electrolyte: 0.1 M Bu₄NPF₆ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and then, from the reduction onset of the graph, the LUMO energy level of each compound was calculated. |
| Band gap evaluation method | The absolute value of the difference between HOMO energy level and LUMO energy level was calculated |
| Triplet (T₁) energy | A mixture of 2-methyl-THF(2-MeTHF) and each compound (each compound was dissolved to a concentration of 10 mM in 3 mL of 2-MeTHF) was put into a quartz cell, which was then placed in a cryostat containing liquid nitrogen (77 K)(Oxford, DN). Then, the phosphorescent spectrum thereof was measured utilizing a luminescence measuring instrument (PTI, Quanta Master 400), and then the triplet energy level was measured from the peak wavelength of the phosphorescent spectrum. |

**Table 2**

| | HOMO (eV) | LUMO (eV) | Band gap (eV) | T₁ (eV) |
|---|---|---|---|---|
| GD-1 | -4.81 | -1.84 | 2.97 | 2.37 |
| GD-2 | -5.06 | -2.1 | 2.96 | 2.38 |
| GD-3 | -4.94 | -1.97 | 2.97 | 2.38 |
| GD-4 | -4.83 | -1.94 | 2.89 | 2.35 |
| GD-5 | -4.91 | -1.92 | 2.99 | 2.38 |
| GD-6 | -4.91 | -1.91 | 3.00 | 2.38 |
| A01 | -4.93 | -1.97 | 2.96 | 2.34 |
| A04 | -4.88 | -1.97 | 2.91 | 2.32 |

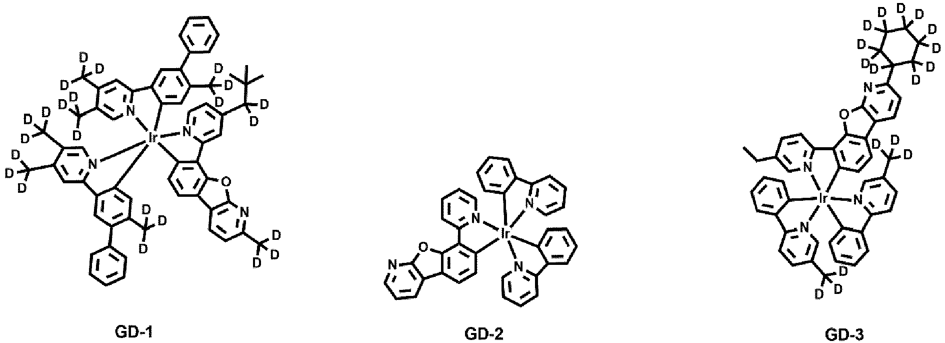

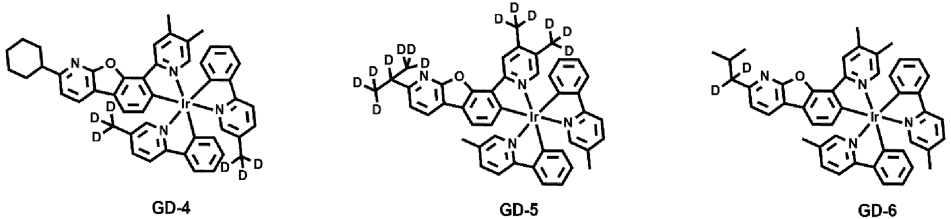

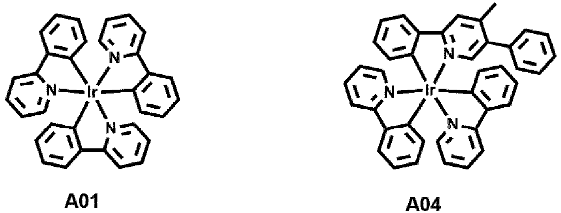

### Evaluation Example 2

PMMA in CH₂Cl₂ solution and Compound GD-1(4 wt% to PMMA) were mixed, and then, the resultant obtained therefrom was coated on a quartz substrate utilizing a spin coater, and then heat treated in an oven at 80 °C, followed by cooling to room temperature to manufacture a film GD-1 having a thickness of 40 nm. Next, films GD-2, GD-3, GD-4, GD-5, GD-6, A01, and A04 were prepared utilizing substantially the same method as utilized to prepare film GD-1, except that GD-2, GD-3, GD-4, GD-5, GD-6, A01, and A04 were utilized instead of GD-1.

The emission spectrum of each of films GD-1, GD-2, GD-3, GD-4, GD-5, GD-6, A01, and A04 was measured by utilizing a Quantaurus-QY Absolute PL quantum yield spectrometer of Hamamatsu Inc. (equipped with a xenon light source, a monochromator, a photonic multichannel analyzer, and an integrating sphere, and utilizing PLQY measurement software (Hamamatsu Photonics, Ltd., Shizuoka, Japan)). During measurements, the excitation wavelength was scanned from 320 nm to 380 nm at 10 nm intervals, and the spectrum measured at the excitation wavelength of 340 nm was utilized to obtain the maximum emission wavelength (emission peak wavelength) and FWHM of the compound included in each film. Results thereof are shown in Table 3.

**Table 3**

| Film no. | Compound included in film (4 wt% in PMMA) | Maximum emission wavelength (nm) | FWHM (nm) |
|---|---|---|---|
| GD-1 | GD-1 | 534 | 55 |
| GD-2 | GD-2 | 531 | 54 |
| GD-3 | GD-3 | 532 | 56 |
| GD-4 | GD-4 | 525 | 55 |
| GD-5 | GD-5 | 534 | 56 |
| GD-6 | GD-6 | 525 | 54 |
| A01 | A01 | 516 | 62 |
| A04 | A04 | 559 | 81 |

From Table 3, it can be confirmed that Compounds GD-1, GD-2, GD-3, GD-4, GD-5 and GD-6 emit green light which satisfies the maximum emission wavelength range of about 520 nm to about 550 nm, and has a relatively small FWHM compared to Compounds A01 and A04.

### Evaluation Example 3

Compound CP01 was deposited on a glass substrate to prepare film CPL-1 having a thickness of 60 nm. Then, for the film CP01, the refractive index of Compound CP01 with respect to light having a wavelength of 530 nm was measured according to the Cauchy Film Model by utilizing an Ellipsometer M-2000 (JA Woollam) at a temperature of 25 °C and in 50% relative humidity. Results thereof are shown Table 4. This experiment was repeatedly performed for each of Compounds CP12, CP06, B01, B02, and B03, and the results are summarized in Table 4.

**Table 4**

| Film no. | Compound included in film | Refractive index for light having a wavelength of 530 nm |
|---|---|---|
| CP01 | CP01 | 1.997 |
| CP12 | CP12 | 1.951 |
| CP06 | CP06 | 2.009 |
| B01 | B01 | 1.757 |
| B02 | B02 | 1.844 |
| B03 | B03 | 1.728 |

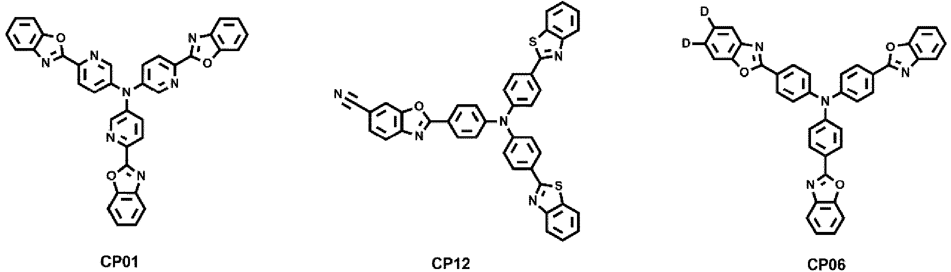

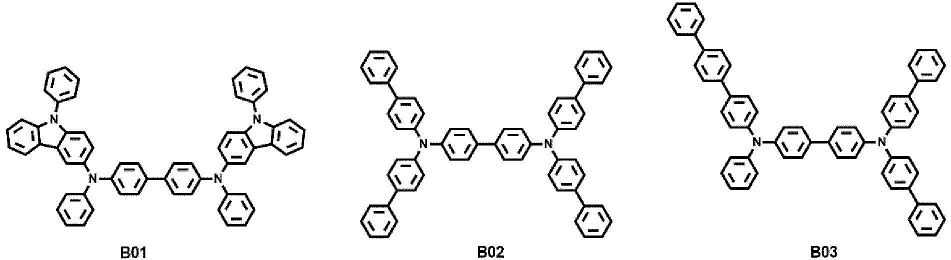

### Example 1

A glass substrate (available from Corning Co., Ltd) on which an ITO anode (15 Ohms per square centimeter (Ω/cm²)) having a thickness of 1,200 Å was formed, was cut to a size of 50 millimeters (mm)×50 mm×0.7 mm, sonicated for 5 minutes in isopropyl alcohol and then 5 minutes in pure water, cleaned with ultraviolet rays for 30 minutes, and then ozone, and was mounted on a vacuum deposition apparatus.

HT3 was vacuum-deposited on the ITO anode to form a hole transport layer having a thickness of 600 Å, and HT40 was vacuum-deposited on the hole transport layer to form an emission auxiliary layer having a thickness of 250 Å.

Compound H125, Compound H126, and Compound GD-1 (first emitter) were vacuum-deposited on the emission auxiliary layer at the weight ratio of 45:45 :10 to form an emission layer having a thickness of 300 Å.

Compound ET37 was vacuum-deposited on the emission layer to form a buffer layer having a thickness of 50 Å, and ET46 and LiQ were vacuum-deposited on the buffer layer at the weight ratio of 5:5 to form an electron transport layer having a thickness of 310 Å. Subsequently, Yb was vacuum-deposited on the electron transport layer to form an electron injection layer having a thickness of 15 Å , and then, Ag and Mg were vacuum-deposited thereon to form a cathode having a thickness of 100 Å.

Subsequently, Compound CP01 was vacuum-deposited on the cathode to form a capping layer having a thickness of 700 Å to complete the manufacturing of an organic light-emitting device.

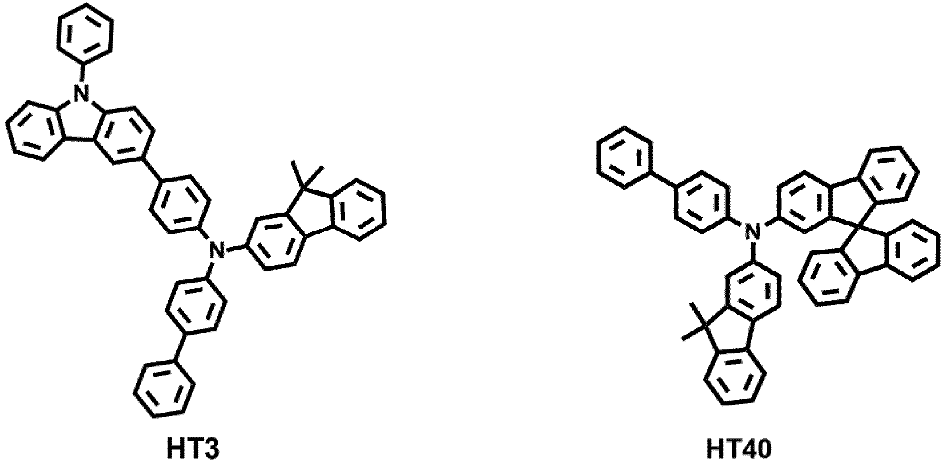

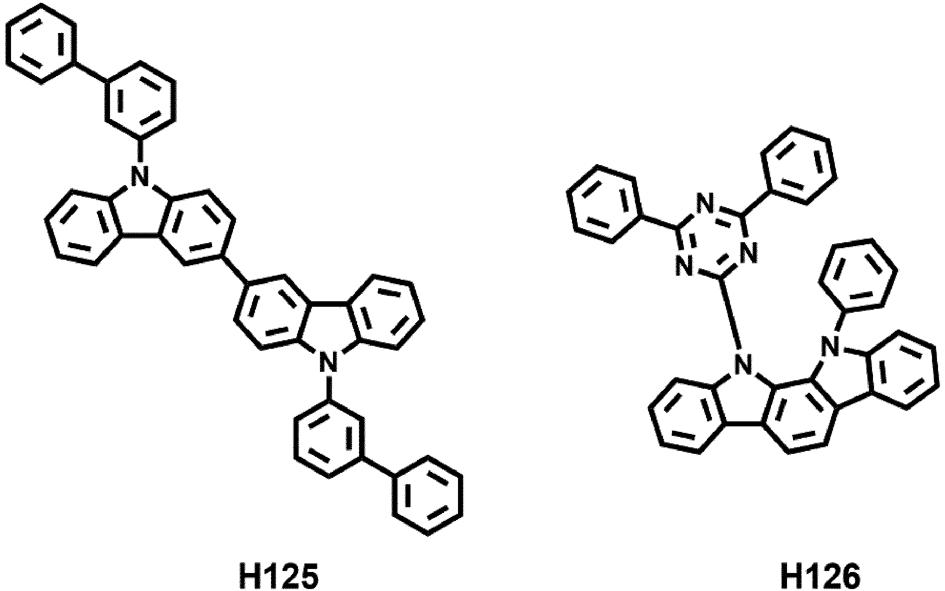

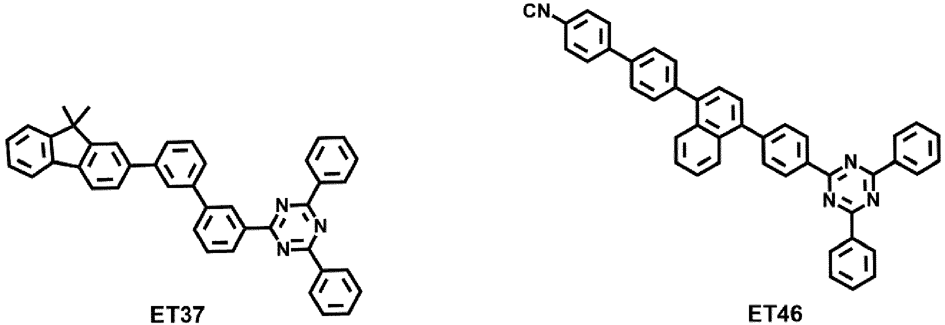

### Examples 2 to 18 and Comparative Examples 1 to 30

Organic light-emitting devices were manufactured in substantially the same manner as in Example 1, except that each of the compounds shown in Table 5 were utilized as materials for forming the first emitter in the emission layer and the capping layer.

### Evaluation Example 4

The color purity (CIEx and CIEy coordinates) at 400 cd/m², frontal (0°) luminescence efficiency (cd/A), and lateral (45°) luminescence efficiency (cd/A) of the organic light-emitting devices manufactured according to Examples 1 to 18 and Comparative Examples 1 to 30 were evaluated by utilizing a luminance meter (Minolta Cs-1000A). Results thereof are shown in Tables 6 to 11. The RCR values calculated with reference to Table 4 are also summarized in Table 5.

**Table 5**

| | First emitter | Material for capping layer | Refractive index of material for capping layer with respect to light having a wavelength of 530 nm | CIEx | CIEy | RCR value |
|---|---|---|---|---|---|---|
| Example 1 | GD-1 | CP01 | 1.997 | 0.249 | 0.726 | 36.35 |
| Example 2 | GD-1 | CP12 | 1.951 | 0.25 | 0.725 | 37.16 |
| Example 3 | GD-1 | CP06 | 2.009 | 0.249 | 0.726 | 36.14 |
| Example 4 | GD-2 | CP01 | 1.997 | 0.249 | 0.725 | 36.3 |
| Example 5 | GD-2 | CP12 | 1.951 | 0.25 | 0.724 | 37.1 |
| Example 6 | GD-2 | CP06 | 2.009 | 0.249 | 0.724 | 36.04 |
| Example 7 | GD-3 | CP01 | 1.997 | 0.249 | 0.725 | 36.3 |
| Example 8 | GD-3 | CP12 | 1.951 | 0.25 | 0.724 | 37.1 |
| Example 9 | GD-3 | CP06 | 2.009 | 0.249 | 0.725 | 36.09 |
| Example 10 | GD-4 | CP01 | 1.997 | 0.248 | 0.721 | 36.1 |
| Example 11 | GD-4 | CP12 | 1.951 | 0.248 | 0.72 | 36.9 |
| Example 12 | GD-4 | CP06 | 2.009 | 0.248 | 0.721 | 35.89 |
| Example 13 | GD-5 | CP01 | 1.997 | 0.247 | 0.721 | 36.1 |
| Example 14 | GD-5 | CP12 | 1.951 | 0.249 | 0.72 | 36.9 |
| Example 15 | GD-5 | CP06 | 2.009 | 0.247 | 0.721 | 35.89 |
| Example 16 | GD-6 | CP01 | 1.997 | 0.248 | 0.722 | 36.15 |
| Example 17 | GD-6 | CP12 | 1.951 | 0.25 | 0.72 | 36.9 |
| Example 18 | GD-6 | CP06 | 2.009 | 0.248 | 0.722 | 35.94 |
| Comparative Example 1 | A01 | B01 | 1.757 | 0.249 | 0.711 | 40.47 |
| Comparative Example 2 | A01 | B02 | 1.844 | 0.249 | 0.713 | 38.67 |
| Comparative Example 3 | A01 | B03 | 1.728 | 0.244 | 0.709 | 41.03 |
| Comparative Example 4 | A04 | B01 | 1.757 | 0.246 | 0.708 | 40.29 |
| Comparative Example 5 | A04 | B02 | 1.844 | 0.245 | 0.709 | 38.44 |
| Comparative Example 6 | A04 | B03 | 1.728 | 0.244 | 0.708 | 40.97 |
| Comparative Example 7 | A01 | CP01 | 1.997 | 0.246 | 0.712 | 35.65 |
| Comparative Example 8 | A01 | CP12 | 1.951 | 0.246 | 0.713 | 36.54 |
| Comparative Example 9 | A01 | CP06 | 2.009 | 0.247 | 0.712 | 35.44 |
| Comparative Example 10 | A04 | CP01 | 1.997 | 0.246 | 0.71 | 35.55 |
| Comparative Example 11 | A04 | CP12 | 1.951 | 0.247 | 0.708 | 36.28 |
| Comparative Example 12 | A04 | CP06 | 2.009 | 0.245 | 0.709 | 35.29 |
| Comparative Example 13 | GD-1 | B01 | 1.757 | 0.244 | 0.722 | 41.09 |
| Comparative Example 14 | GD-1 | B02 | 1.844 | 0.245 | 0.723 | 39.21 |
| Comparative Example 15 | GD-1 | B03 | 1.728 | 0.244 | 0.722 | 41.78 |
| Comparative Example 16 | GD-2 | B01 | 1.757 | 0.244 | 0.721 | 41.04 |
| Comparative Example 17 | GD-2 | B02 | 1.844 | 0.246 | 0.723 | 39.21 |
| Comparative Example 18 | GD-2 | B03 | 1.728 | 0.245 | 0.722 | 41.78 |
| Comparative Example 19 | GD-3 | B01 | 1.757 | 0.246 | 0.723 | 41.15 |
| Comparative Example 20 | GD-3 | B02 | 1.844 | 0.244 | 0.721 | 39.10 |
| Comparative Example 21 | GD-3 | B03 | 1.728 | 0.245 | 0.723 | 41.84 |
| Comparative Example 21 | GD-4 | B01 | 1.757 | 0.246 | 0.722 | 41.09 |
| Comparative Example 23 | GD-4 | B02 | 1.844 | 0.244 | 0.722 | 39.15 |
| Comparative Example 24 | GD-4 | B03 | 1.728 | 0.244 | 0.723 | 41.84 |
| Comparative Example 25 | GD-5 | B01 | 1.757 | 0.246 | 0.721 | 41.04 |
| Comparative Example 26 | GD-5 | B02 | 1.844 | 0.244 | 0.721 | 39.10 |
| Comparative Example 27 | GD-5 | B03 | 1.728 | 0.245 | 0.722 | 41.78 |
| Comparative Example 28 | GD-6 | B01 | 1.757 | 0.245 | 0.724 | 41.21 |
| Comparative Example 29 | GD-6 | B02 | 1.844 | 0.244 | 0.723 | 39.21 |
| Comparative Example 30 | GD-6 | B03 | 1.728 | 0.244 | 0.721 | 41.72 |

**Table 6**

| | First emitter | Material for capping layer | Frontal (0°) luminescence efficiency (cd/A) | Lateral (45°) luminescence efficiency (cd/A) |
|---|---|---|---|---|
| Example 1 | GD-1 | CP01 | 181.1 | 88.7 |
| Example 2 | GD-1 | CP12 | 178.3 | 83.8 |
| Example 3 | GD-1 | CP06 | 184.7 | 92.4 |
| Comparative Example 1 | A01 | B01 | 150.3 | 87.2 |
| Comparative Example 2 | A01 | B02 | 153.1 | 88.8 |
| Comparative Example 3 | A01 | B03 | 149.5 | 79.2 |
| Comparative Example 4 | A04 | B01 | 152.8 | 85.6 |
| Comparative Example 5 | A04 | B02 | 155.3 | 88.5 |
| Comparative Example 6 | A04 | B03 | 151.9 | 79.0 |
| Comparative Example 7 | A01 | CP01 | 166.9 | 91.8 |
| Comparative Example 8 | A01 | CP12 | 164.6 | 90.5 |
| Comparative Example 9 | A01 | CP06 | 168.5 | 87.6 |
| Comparative Example 10 | A04 | CP01 | 167 | 88.5 |
| Comparative Example 11 | A04 | CP12 | 165.2 | 87.6 |
| Comparative Example 12 | A04 | CP06 | 169.4 | 86.4 |
| Comparative Example 13 | GD-1 | B01 | 160.8 | 86.8 |
| Comparative Example 14 | GD-1 | B02 | 163.5 | 86.7 |
| Comparative Example 15 | GD-1 | B03 | 158.6 | 80.9 |

**Table 7**

| | First emitter | Material for capping layer | Frontal (0°) luminescence efficiency (cd/A) | Lateral (45°) luminescence efficiency (cd/A) |
|---|---|---|---|---|
| Example 4 | GD-2 | CP01 | 185.2 | 92.6 |
| Example 5 | GD-2 | CP12 | 181.6 | 87.2 |
| Example 6 | GD-2 | CP06 | 189 | 92.6 |
| Comparative Example 1 | A01 | B01 | 150.3 | 87.2 |
| Comparative Example 2 | A01 | B02 | 153.1 | 88.8 |
| Comparative Example 3 | A01 | B03 | 149.5 | 79.2 |
| Comparative Example 4 | A04 | B01 | 152.8 | 85.6 |
| Comparative Example 5 | A04 | B02 | 155.3 | 88.5 |
| Comparative Example 6 | A04 | B03 | 151.9 | 79.0 |
| Comparative Example 7 | A01 | CP01 | 166.9 | 91.8 |
| Comparative Example 8 | A01 | CP12 | 164.6 | 90.5 |
| Comparative Example 9 | A01 | CP06 | 168.5 | 87.6 |
| Comparative Example 10 | A04 | CP01 | 167 | 88.5 |
| Comparative Example 11 | A04 | CP12 | 165.2 | 87.6 |
| Comparative Example 12 | A04 | CP06 | 169.4 | 86.4 |
| Comparative Example 16 | GD-2 | B01 | 164 | 90.2 |
| Comparative Example 17 | GD-2 | B02 | 167.4 | 88.7 |
| Comparative Example 18 | GD-2 | B03 | 163.4 | 83.3 |

**Table 8**

| | First emitter | Material for capping layer | Frontal (0°) luminescence efficiency (cd/A) | Lateral (45°) luminescence efficiency (cd/A) |
|---|---|---|---|---|
| Example 7 | GD-3 | CP01 | 182.3 | 87.5 |
| Example 8 | GD-3 | CP12 | 180.1 | 82.8 |
| Example 9 | GD-3 | CP06 | 185.6 | 89.1 |
| Comparative Example 1 | A01 | B01 | 150.3 | 87.2 |
| Comparative Example 2 | A01 | B02 | 153.1 | 88.8 |
| Comparative Example 3 | A01 | B03 | 149.5 | 79.2 |
| Comparative Example 4 | A04 | B01 | 152.8 | 85.6 |
| Comparative Example 5 | A04 | B02 | 155.3 | 88.5 |
| Comparative Example 6 | A04 | B03 | 151.9 | 79.0 |
| Comparative Example 7 | A01 | CP01 | 166.9 | 91.8 |
| Comparative Example 8 | A01 | CP12 | 164.6 | 90.5 |
| Comparative Example 9 | A01 | CP06 | 168.5 | 87.6 |
| Comparative Example 10 | A04 | CP01 | 167 | 88.5 |
| Comparative Example 11 | A04 | CP12 | 165.2 | 87.6 |
| Comparative Example 12 | A04 | CP06 | 169.4 | 86.4 |
| Comparative Example 19 | GD-3 | B01 | 161 | 88.6 |
| Comparative Example 20 | GD-3 | B02 | 163.7 | 88.4 |
| Comparative Example 21 | GD-3 | B03 | 158.9 | 82.6 |

**Table 9**

| | First emitter | Material for capping layer | Frontal (0°) luminescence efficiency (cd/A) | Lateral (45°) luminescence efficiency (cd/A) |
|---|---|---|---|---|
| Example 10 | GD-4 | CP01 | 186 | 93.0 |
| Example 11 | GD-4 | CP12 | 182.5 | 89.4 |
| Example 12 | GD-4 | CP06 | 190.1 | 97.0 |
| Comparative Example 1 | A01 | B01 | 150.3 | 87.2 |
| Comparative Example 2 | A01 | B02 | 153.1 | 88.8 |
| Comparative Example 3 | A01 | B03 | 149.5 | 79.2 |
| Comparative Example 4 | A04 | B01 | 152.8 | 85.6 |
| Comparative Example 5 | A04 | B02 | 155.3 | 88.5 |
| Comparative Example 6 | A04 | B03 | 151.9 | 79.0 |
| Comparative Example 7 | A01 | CP01 | 166.9 | 91.8 |
| Comparative Example 8 | A01 | CP12 | 164.6 | 90.5 |
| Comparative Example 9 | A01 | CP06 | 168.5 | 87.6 |
| Comparative Example 10 | A04 | CP01 | 167 | 88.5 |
| Comparative Example 11 | A04 | CP12 | 165.2 | 87.6 |
| Comparative Example 12 | A04 | CP06 | 169.4 | 86.4 |
| Comparative Example 22 | GD-4 | B01 | 165.1 | 89.2 |
| Comparative Example 23 | GD-4 | B02 | 168.5 | 89.3 |
| Comparative Example 24 | GD-4 | B03 | 164.2 | 83.7 |

**Table 10**

| | First emitter | Material for capping layer | Frontal (0°) luminescence efficiency (cd/A) | Lateral (45°) luminescence efficiency (cd/A) |
|---|---|---|---|---|
| Example 13 | GD-5 | CP01 | 180.8 | 86.8 |
| Example 14 | GD-5 | CP12 | 178.6 | 82.2 |
| Example 15 | GD-5 | CP06 | 183.7 | 90.0 |
| Comparative Example 1 | A01 | B01 | 150.3 | 87.2 |
| Comparative Example 2 | A01 | B02 | 153.1 | 88.8 |
| Comparative Example 3 | A01 | B03 | 149.5 | 79.2 |
| Comparative Example 4 | A04 | B01 | 152.8 | 85.6 |
| Comparative Example 5 | A04 | B02 | 155.3 | 88.5 |
| Comparative Example 6 | A04 | B03 | 151.9 | 79.0 |
| Comparative Example 7 | A01 | CP01 | 166.9 | 91.8 |
| Comparative Example 8 | A01 | CP12 | 164.6 | 90.5 |
| Comparative Example 9 | A01 | CP06 | 168.5 | 87.6 |
| Comparative Example 10 | A04 | CP01 | 167 | 88.5 |
| Comparative Example 11 | A04 | CP12 | 165.2 | 87.6 |
| Comparative Example 12 | A04 | CP06 | 169.4 | 86.4 |
| Comparative Example 25 | GD-5 | B01 | 160.1 | 86.5 |
| Comparative Example 26 | GD-5 | B02 | 163.2 | 84.9 |
| Comparative Example 27 | GD-5 | B03 | 158.1 | 80.6 |

**Table 11**

| | First emitter | Material for capping layer | Frontal (0°) luminescence efficiency (cd/A) | Lateral (45°) luminescence efficiency (cd/A) |
|---|---|---|---|---|
| Example 16 | GD-6 | CP01 | 181 | 83.3 |
| Example 17 | GD-6 | CP12 | 179.3 | 80.7 |
| Example 18 | GD-6 | CP06 | 183.6 | 86.3 |
| Comparative Example 1 | A01 | B01 | 150.3 | 87.2 |
| Comparative Example 2 | A01 | B02 | 153.1 | 88.8 |
| Comparative Example 3 | A01 | B03 | 149.5 | 79.2 |
| Comparative Example 4 | A04 | B01 | 152.8 | 85.6 |
| Comparative Example 5 | A04 | B02 | 155.3 | 88.5 |
| Comparative Example 6 | A04 | B03 | 151.9 | 79.0 |
| Comparative Example 7 | A01 | CP01 | 166.9 | 91.8 |
| Comparative Example 8 | A01 | CP12 | 164.6 | 90.5 |
| Comparative Example 9 | A01 | CP06 | 168.5 | 87.6 |
| Comparative Example 10 | A04 | CP01 | 167 | 88.5 |
| Comparative Example 11 | A04 | CP12 | 165.2 | 87.6 |
| Comparative Example 12 | A04 | CP06 | 169.4 | 86.4 |
| Comparative Example 28 | GD-6 | B01 | 162 | 87.5 |
| Comparative Example 29 | GD-6 | B02 | 164.9 | 85.7 |
| Comparative Example 30 | GD-6 | B03 | 161.3 | 83.9 |

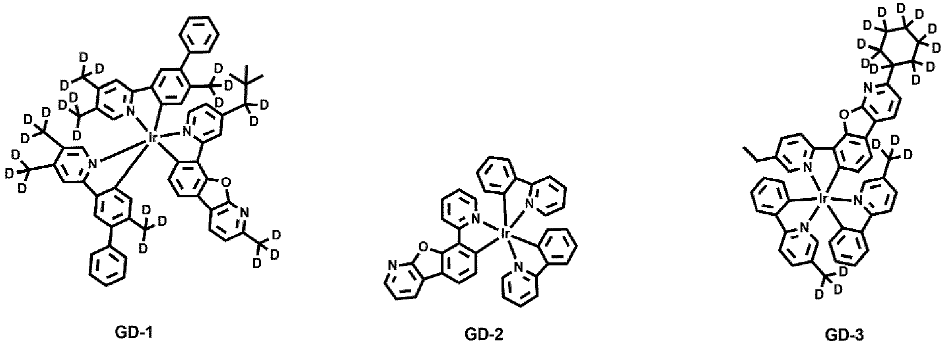

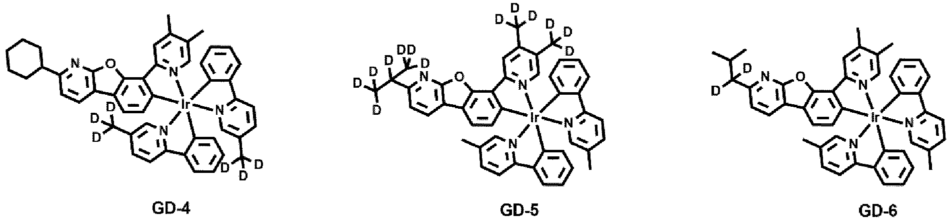

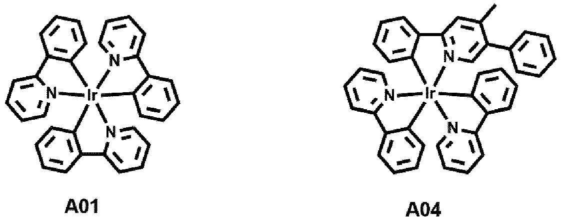

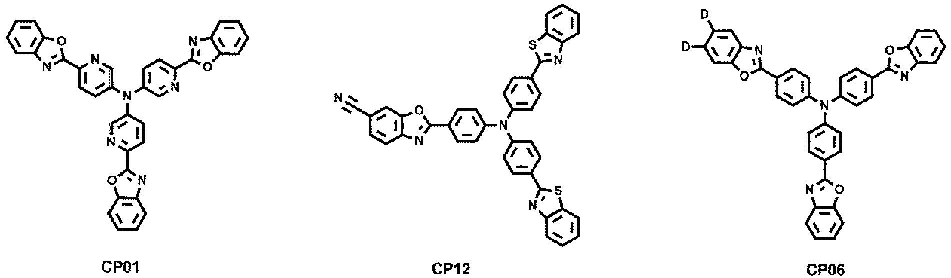

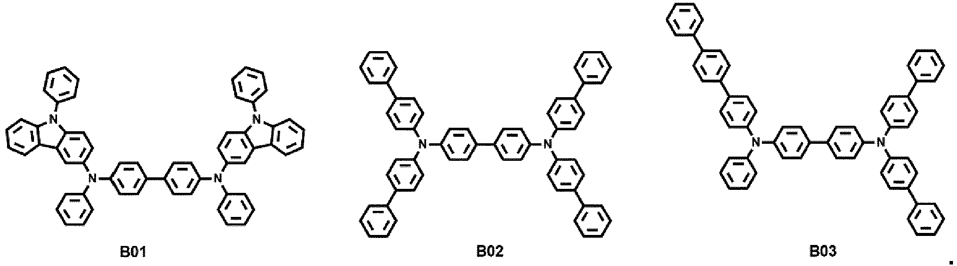

1) From Tables 5 and 6, it can be seen that the organic light-emitting devices of Examples 1 to 3 each including the first emitter including iridium (emitting green light with the maximum emission wavelength in the range of 520 nm to 550 nm) and having the RCR value of 38 or less, have an equivalent level of lateral luminescence efficiency and improved frontal luminescence efficiency, compared to the organic light-emitting devices of Comparative Examples 1 to 15,
2) From Tables 5 and 7, it can be seen that the organic light-emitting devices of Examples 4 to 6 each including the first emitter including iridium (emitting green light with the maximum emission wavelength in the range of 520 nm to 550 nm) and having the RCR value of 38 or less, have an equivalent level of lateral luminescence efficiency and improved frontal luminescence efficiency, compared to the organic light-emitting devices of Comparative Examples 1 to 12 and 16 to 18,
3) From Tables 5 and 8, it can be seen that the organic light-emitting devices of Examples 7 to 9 each including the first emitter including iridium (emitting green light with the maximum emission wavelength in the range of 520 nm to 550 nm) and having the RCR value of 38 or less, have an equivalent level of lateral luminescence efficiency and improved frontal luminescence efficiency, compared to the organic light-emitting devices of Comparative Examples 1 to 12 and 19 to 21,
4) From Tables 5 and 9, it can be seen that the organic light-emitting devices of Examples 10 to 12 each including the first emitter including iridium (emitting green light with the maximum emission wavelength in the range of 520 nm to 550 nm) and having the RCR value of 38 or less, have an equivalent level of lateral luminescence efficiency and improved frontal luminescence efficiency, compared to the organic light-emitting devices of Comparative Examples 1 to 12 and 22 to 24,
5) From Tables 5 and 10, it can be seen that the organic light-emitting devices of Examples 13 to 15 each including the first emitter including iridium (emitting green light with the maximum emission wavelength in the range of 520 nm to 550 nm) and having the RCR value of 38 or less, have an equivalent level of lateral luminescence efficiency and improved (increased) frontal luminescence efficiency, compared to the organic light-emitting devices of Comparative Examples 1 to 12 and 25 to 27, and
6) From Tables 5 and 11, it can be seen that the organic light-emitting devices of Examples 16 to 18 each including the first emitter including iridium (emitting green light with the maximum emission wavelength in the range of 520 nm to 550 nm) and having the RCR value of 38 or less, have an equivalent level of lateral luminescence efficiency and improved frontal luminescence efficiency, compared to the organic light-emitting devices of Comparative Examples 1 to 12 and 28 to 30.

Because the light-emitting device has excellent or suitable frontal luminescence efficiency and lateral luminescence efficiency at the same time (concurrently), a high-quality electronic apparatus can be manufactured utilizing the same.

The use of "may" when describing embodiments of the present disclosure refers to "one or more embodiments of the present disclosure."

As used herein, the term "substantially," "about," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this disclosure is intended to include all higher numerical limitations subsumed therein. Accordingly, Applicant reserves the right to amend this disclosure, including the claims, to expressly recite any sub-range subsumed within the ranges expressly recited herein.

The light emitting device, electronic apparatus, the consumer product or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC
chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made.

## Claims

1. A light-emitting device (10) comprising:
a first electrode (110);
a second electrode (150) facing the first electrode (110);
an interlayer (130) between the first electrode (110) and the second electrode (150) and comprising an emission layer; and
a capping layer (170),
wherein the emission layer comprises a first emitter,
the first emitter is configured to emit a first light having a first emission spectrum,
the capping layer (170) is in a path on which the first light travels,
the first emitter comprises iridium,
the capping layer (170) comprises an amine-containing compound, and
the value of ratio of CIEy to reflective index (RCR value) of the first light extracted to the outside through the capping layer is 38 or less, and
the RCR value is calculated according to Equation 1: $CIEy / R \left(cap\right) \times 100$
wherein, in Equation 1,
CIEy is the y coordinate value of the CIE color coordinates of the first light extracted to the outside through the capping layer, and
R(cap) is the refractive index of the amine-containing compound with respect to a second light having a wavelength of 530 nm,
**characterised in that** a maximum emission peak wavelength of the first emission spectrum is from 520 nm to 550 nm**.**

2. The light-emitting device of claim 1, wherein
a maximum emission peak wavelength of the first emission spectrum is in the range of 525 nm to 545 nm, and/or,
wherein
a full width at half maximum of the first light is from 15 nm to 60 nm, and/or, wherein
the first light is a green light.

3. The light-emitting device of claim 1 or 2, wherein
the first emitter comprises a first ligand, a second ligand, and a third ligand, wherein each of the first ligand, second ligand and third ligand is bonded to the iridium,
the first ligand is a bidentate ligand comprising Y₁-containing ring B₁ and Y₂-containing ring B₂,
the second ligand is a bidentate ligand comprising Y₃-containing ring B₃ and Y₄-containing ring B₄,
the third ligand is a bidentate ligand comprising Y₅-containing ring B₅ and Y₆-containing ring B₆,
each of Y₁, Y_{3,} and Y₅ is nitrogen (N),
each of Y₂, Y_{4,} and Y₆ is carbon (C), and
Y₂-containing ring B₂ and Y₄-containing ring B₄ are different from each other.

4. The light-emitting device of any one of the preceding claims, wherein
the amine-containing compound comprised in the capping layer comprises a benzoxazole group, a benzthiazole group, a naphthooxazole group, a naphthothiazole group, or any combination thereof.

5. The light-emitting device of any one of the preceding claims, wherein
the RCR value of the first light extracted to the outside through the capping layer is from 32.0 to 38.0 and/or
wherein
CIEy is from 0.705 to 0.740.

6. The light-emitting device of any one of the preceding claims, wherein
R(cap) is from 1.85 to 2.5.

7. An electronic apparatus comprising the light-emitting device of claim 1.

8. The electronic apparatus of claim 7, further comprising
a color filter, a color conversion layer, a touch screen layer, a polarizing layer, or any combination thereof.

9. A consumer product, comprising the light-emitting device of claim 1.

10. The consumer product of claim 9, the consumer product being one selected from among a flat panel display, a curved display, a computer monitor, a medical monitor, a TV, a billboard, indoor or outdoor illuminations and/or signal light, a head-up display, a fully or partially transparent display, a flexible display, a rollable display, a foldable display, a stretchable display, a laser printer, a phone, a cell phone, a tablet, a phablet, a personal digital assistant (PDA), a wearable device, laptop computers, digital cameras, camcorders, viewfinders, micro displays, 3D displays, virtual or augmented reality displays, vehicles, a video wall comprising multiple displays tiled together, a theater or stadium screen, a phototherapy device, and a signage.

## Patentansprüche

1. Lichtemittierende Vorrichtung (10), umfassend:
eine erste Elektrode (110);
eine der ersten Elektrode (110) gegenüberliegende zweite Elektrode (150);
eine Zwischenschicht (130) zwischen der ersten Elektrode (110) und der zweiten Elektrode (150), die eine Emissionsschicht umfasst; und
eine Abdeckschicht (170),
wobei die Emissionsschicht einen ersten Emitter umfasst,
der erste Emitter dazu ausgestaltet ist, ein erstes Licht mit einem ersten Emissionsspektrum zu emittieren,
die Abdeckschicht (170) sich in einem Pfad befindet, auf dem sich das erste Licht bewegt,
der erste Emitter Iridium umfasst,
die Abdeckschicht (170) eine aminhaltige Verbindung umfasst und
der Wert des Verhältnisses von CIEy zum Reflexionsindex (RCR-Wert) des durch die Abdeckschicht nach außen extrahierten ersten Lichts 38 oder weniger beträgt und
der RCR-Wert anhand von Gleichung 1 berechnet wird: $CIEy / R \left(cap\right) \times 100$
wobei in Gleichung 1,
CIEy der y-Koordinatenwert der CIE-Farbkoordinaten des durch die Abdeckschicht nach außen extrahierten ersten Lichts ist und
R(cap) der Brechungsindex der aminhaltigen Verbindung in Bezug auf ein zweites Licht mit einer Wellenlänge von 530 nm ist,
**dadurch gekennzeichnet, dass** eine maximale Emissionsspitzenwellenlänge des ersten Emissionsspektrums 520 nm bis 550 nm beträgt.

2. Lichtemittierende Vorrichtung nach Anspruch 1, wobei
eine maximale Emissionsspitzenwellenlänge des ersten Emissionsspektrums im Bereich von 525 nm bis 545 nm liegt und/oder
wobei
eine Halbwertsbreite des ersten Lichts 15 nm bis 60 nm beträgt und/oder
wobei
das erste Licht ein grünes Licht ist.

3. Lichtemittierende Vorrichtung nach Anspruch 1 oder 2, wobei
der erste Emitter einen ersten Liganden, einen zweiten Liganden und einen dritten Liganden umfasst,
wobei jeder des ersten Liganden, zweiten Liganden und dritten Liganden an das Iridium gebunden ist,
der erste Ligand ein zweizähniger Ligand ist, der einen Y₁-haltigen Ring B₁ und einen Y₂-haltigen Ring B₂ umfasst,
der zweite Ligand ein zweizähniger Ligand ist, der einen Y₃-haltigen Ring B₃ und einen Y₄-haltigen Ring B₄ umfasst,
der dritte Ligand ein zweizähniger Ligand ist, der einen Y₅-haltigen Ring B₅ und einen Y₆-haltigen Ring B₆ umfasst,
jeder aus Y₁, Y₃, und Y₅ Stickstoff (N) ist,
jeder aus Y₂, Y₄, und Y₆ Kohlenstoff (C) ist und
der Y₂-haltige Ring B₂ und der Y₄-haltige Ring B₄ voneinander verschieden sind.

4. Lichtemittierende Vorrichtung nach einem der vorangehenden Ansprüche, wobei
die in der Abdeckschicht enthaltene aminhaltige Verbindung eine Benzoxazolgruppe, eine Benzthiazolgruppe, eine Naphthooxazolgruppe, eine Naphthothiazolgruppe oder eine beliebige Kombination davon umfasst.

5. Lichtemittierende Vorrichtung nach einem der vorangehenden Ansprüche, wobei
der RCR-Wert des durch die Abdeckschicht nach außen extrahierten ersten Lichts 32,0 bis 38,0 beträgt und/oder
wobei
CIEy 0,705 bis 0,740 beträgt.

6. Lichtemittierende Vorrichtung nach einem der vorangehenden Ansprüche, wobei R(cap) 1,85 bis 2,5 beträgt.

7. Elektronisches Gerät, umfassend die lichtemittierende Vorrichtung nach Anspruch 1.

8. Elektronisches Gerät nach Anspruch 7, ferner umfassend
einen Farbfilter, eine Farbumwandlungsschicht, eine Touchscreenschicht, eine polarisierende Schicht oder eine beliebige Kombination davon.

9. Verbraucherprodukt, umfassend die lichtemittierende Vorrichtung nach Anspruch 1.

10. Verbraucherprodukt nach Anspruch 9, wobei das Verbraucherprodukt eines ist, das aus einem Flachbildschirm, einem gebogenen Bildschirm, einem Computermonitor, einem medizinischen Monitor, einem Fernseher, einer Werbetafel, Innen- oder Außenbeleuchtungen und/oder einem -signallicht, einer Head-up-Anzeige, einer ganz oder teilweise transparenten Anzeige, einer flexiblen Anzeige, einer rollbaren Anzeige, einer faltbaren Anzeige, einer dehnbaren Anzeige, einem Laserdrucker, einem Telefon, einem Mobiltelefon, einem Tablet, einem Phablet, einem persönlichen digitalen Assistenten (*Personal Digital Assistant,* PDA), einer tragbaren Vorrichtung, Laptops, Digitalkameras, Camcordern, Bildsuchern, Mikroanzeigen, 3D-Anzeigen, Anzeigen für virtuelle oder erweiterte Realität, Fahrzeugen, einer Videowand mit mehreren zusammengefügten Anzeigen, einer Theater- oder Stadionanzeige, einer Phototherapievorrichtung und einer Beschilderung ausgewählt ist.

## Revendications

1. Dispositif électroluminescent (10) comprenant :
une première électrode (110) ;
une seconde électrode (150) faisant face à la première électrode (110) ;
une couche intermédiaire (130) entre la première électrode (110) et la seconde électrode (150), et comprenant une couche émettrice ; et
une couche de recouvrement (170),
dans lequel la couche émettrice comprend un premier émetteur,
le premier émetteur est configuré pour émettre une première lumière ayant un premier spectre d'émission,
la couche de recouvrement (170) se trouve sur le trajet de la première lumière,
le premier émetteur comprend de l'iridium,
la couche de recouvrement (170) comprend un composé contenant une amine, et
la valeur du rapport entre CIEy et l'indice de réflectivité (valeur RCR) de la première lumière extraite vers l'extérieur à travers la couche de recouvrement est inférieure ou égale à 38, et
la valeur RCR est calculée selon l'équation 1 : $CIEy / R \left(cap\right) \times 100$
dans lequel, dans l'Équation 1,
CIEy est la valeur de la coordonnée y des coordonnées chromatiques CIE de la première lumière extraite vers l'extérieur à travers la couche de recouvrement, et
R(cap) est l'indice de réfraction du composé contenant une amine par rapport à une seconde lumière ayant une longueur d'onde de 530 nm,
**caractérisé en ce que** la longueur d'onde maximale du pic d'émission du premier spectre d'émission est comprise entre 520 nm et 550 nm.

2. Dispositif électroluminescent selon la revendication 1, dans lequel
une longueur d'onde maximale du pic d'émission du premier spectre d'émission est comprise entre 525 nm et 545 nm, et/ou,
dans lequel
une largeur à mi-hauteur de la première lumière est comprise entre 15 nm et 60 nm, et/ou,
dans lequel
la première lumière est une lumière verte.

3. Dispositif électroluminescent selon la revendication 1 ou 2, dans lequel
le premier émetteur comprend un premier ligand, un second ligand et un troisième ligand,
dans lequel chaque premier ligand, second ligand et troisième ligand est lié à l'iridium, le premier ligand est un ligand bidenté comprenant un cycle B₁ contenant Y₁ et un cycle B₂ contenant Y₂,
le second ligand est un ligand bidenté comprenant un cycle B₃ contenant Y₃ et un cycle B₄ contenant Y₄,
le troisième ligand est un ligand bidenté comprenant un cycle B₅ contenant Y₅ et un cycle B₆ contenant Y₆,
chaque Y₁, Y₃ et Y₅ est un atome d'azote (N),
chaque Y₂, Y₄ et Y₆ est un atome de carbone (C), et
le cycle B₂ contenant Y₂ et le cycle B₄ contenant Y₄ sont différents l'un de l'autre.

4. Dispositif électroluminescent selon l'une quelconque des revendications précédentes, dans lequel
le composé contenant une amine compris dans la couche de recouvrement comprend un groupe benzoxazole, un groupe benzothiazole, un groupe naphtoxazole, un groupe naphtothiazole ou toute combinaison de ceux-ci.

5. Dispositif électroluminescent selon l'une quelconque des revendications précédentes, dans lequel
la valeur RCR de la première lumière extraite vers l'extérieur à travers la couche de recouvrement est comprise entre 32,0 et 38,0 et/ou
dans lequel
CIEy est comprise entre 0,705 et 0,740.

6. Dispositif électroluminescent selon l'une quelconque des revendications précédentes, dans lequel R(cap) est comprise entre 1,85 et 2,5.

7. Appareil électronique comprenant le dispositif électroluminescent selon la revendication 1.

8. Appareil électronique selon la revendication 7, comprenant en outre
un filtre couleur, une couche de conversion de couleur, une couche d'écran tactile, une couche polarisante ou toute combinaison de ceux-ci.

9. Produit de consommation, comprenant le dispositif électroluminescent selon la revendication 1.

10. Produit de consommation selon la revendication 9, le produit de consommation étant l'un des produits suivants : un écran plat, un écran incurvé, un écran d'ordinateur, un écran médical, un téléviseur, un panneau d'affichage, un éclairage intérieur ou extérieur et/ou un feu de signalisation, un affichage tête haute, un écran entièrement ou partiellement transparent, un écran flexible, un écran enroulable, un écran pliable, un écran extensible, une imprimante laser, un téléphone, un téléphone portable, une tablette, une phablette, un assistant numérique personnel (PDA), un appareil portable, un ordinateur portable, un appareil photo numérique, un caméscope, un viseur, un micro-écran, un écran 3D, un écran de réalité virtuelle ou augmentée, un véhicule, un mur vidéo composé de plusieurs écrans assemblés, un écran de cinéma ou de stade, un appareil de photothérapie et un panneau de signalisation.
